# EUROPEAN PATENT APPLICATION

(11) **EP 4 791 146 A1**
(43) Date of publication of application: **12.08.2026**
(21) Application number: 24874377.5
(22) Date of filing: 22.08.2024
(51) Int. Cl.: H10D 30/66, H01L 21/265, H10D 8/50, H10D 8/60, H10D 12/00, H10D 30/01, H10D 62/10, H10D 64/60, H10D 64/64

(54) **SEMICONDUCTOR DEVICE**

(30) Priority: 05.10.2023 JP 2023173681
(71) Applicant: Rohm Co., Ltd., Kyoto-shi, Kyoto 615-8585 (JP)
(72) Inventor: MORI, Seigo, Kyoto-shi, Kyoto 615-8585 (JP); NAKANO, Yuki, Kyoto-shi, Kyoto 615-8585 (JP); WAGURI, Rogosu, Kyoto-shi, Kyoto 615-8585 (JP)
(74) Representative: Witte, Weller & Partner Patentanwälte mbB
(86) International application number: PCT/JP2024/029791
(87) International publication number: WO 2025/074763

(57) **Abstract**

A semiconductor device includes a first impurity region, a second impurity region, and a third impurity region that are formed in a chip, a trench that is formed in the chip, a trench insulating film that is formed on an inner surface of the trench, an embedded body with conductivity that is embedded in the trench, and an electric field relaxation layer that is formed at a bottom portion of the trench and the electric field relaxation layer includes a first layer that is formed separated to the second principal surface side from the bottom portion of the trench and has a first impurity concentration and a second layer that is formed between the first layer and the bottom portion of the trench and has a second impurity concentration higher than the first impurity concentration.

## Description

### Related Application

The present application corresponds to Japanese Patent Application No. 2023-173681 filed on Oct. 5, 2023 in the Japan Patent Office, the entire disclosure of which is incorporated herein by reference.

### Technical Field

The present invention relates to a semiconductor device.

### Background Art

Patent Literature 1 discloses an electronic device having an impurity region introduced into a silicon carbide layer by a channeling implantation method.

### Citation List

### Patent Literature

Patent Literature 1: United States Patent Application Publication No. 2015/0028351

### [Summary of the Invention]

A preferred embodiment of the present disclosure provides a semiconductor device including a chip that has a first principal surface and a second principal surface at an opposite side thereto, a first impurity region of a first conductivity type that is formed in a surface layer portion of the first principal surface, a second impurity region of a second conductivity type that is formed in a surface layer portion of the first impurity region, a third impurity region of the first conductivity type that is formed in a surface layer portion of the second impurity region, a trench passing through the third impurity region and the second impurity region from the first principal surface and reaching the first impurity region, a trench insulating film that is formed on an inner surface of the trench, an embedded body with conductivity that is embedded in the trench with the trench insulating film interposed therebetween, and an electric field relaxation layer of the second conductivity type that is formed at a bottom portion of the trench, and where the electric field relaxation layer includes a first layer that is formed separated to the second principal surface side from the bottom portion of the trench and has a first impurity concentration and a second layer that is formed between the first layer and the bottom portion of the trench and has a second impurity concentration higher than the first impurity concentration.

### BRIEF DESCRIPTION OF THE DRAWINGS

[FIG. 1] FIG. 1 is a plan view showing a semiconductor device according to a preferred embodiment of the present disclosure.
[FIG. 2] FIG. 2 is a sectional view taken along line II-II shown in FIG. 1.
[FIG. 3] FIG. 3 is a plan view showing a layout example of a chip.
[FIG. 4] FIG. 4 is a perspective view showing the layout example of the chip.
[FIG. 5] FIG. 5 is a perspective view showing an active region and trench structures.
[FIG. 6] FIG. 6 is a sectional view taken along line VI-VI shown in FIG. 5.
[FIG. 7] FIG. 7 is a sectional view taken along line VII-VII shown in FIG. 5.
[FIG. 8] FIG. 8 is the same sectional view as FIG. 6 and is a diagram mainly showing dimensions of respective portions.
[FIG. 9] FIG. 9 is the same sectional view as FIG. 7 and is a diagram mainly showing dimensions of respective portions.
[FIG. 10] FIG. 10 is a schematic view showing a wafer used in manufacture of the semiconductor device.
[FIG. 11] FIG. 11 is a flowchart showing a manufacturing method example of the semiconductor device.
[FIG. 12A] FIG. 12A is a diagram for describing a portion of a manufacturing process of the semiconductor device and shows a cross section corresponding to FIG. 6.
[FIG. 12B] FIG. 12B is a diagram for describing a portion of the manufacturing process of the semiconductor device and shows a cross section corresponding to FIG. 7.
[FIG. 13A] FIG. 13A is a diagram showing a step subsequent to that of FIG. 12A.
[FIG. 13B] FIG. 13B is a diagram showing a step subsequent to that of FIG. 12B.
[FIG. 14A] FIG. 14A is a diagram showing a step subsequent to that of FIG. 13A.
[FIG. 14B] FIG. 14B is a diagram showing a step subsequent to that of FIG. 13B.
[FIG. 15A] FIG. 15A is a diagram showing a step subsequent to that of FIG. 14A.
[FIG. 15B] FIG. 15B is a diagram showing a step subsequent to that of FIG. 14B.
[FIG. 16A] FIG. 16A is a diagram showing a step subsequent to that of FIG. 15A.
[FIG. 16B] FIG. 16B is a diagram showing a step subsequent to that of FIG. 15B.
[FIG. 17A] FIG. 17A is a diagram showing a step subsequent to that of FIG. 16A.
[FIG. 17B] FIG. 17B is a diagram showing a step subsequent to that of FIG. 16B.
[FIG. 18A] FIG. 18A is a diagram showing a step subsequent to that of FIG. 17A.
[FIG. 18B] FIG. 18B is a diagram showing a step subsequent to that of FIG. 17B.
[FIG. 19A] FIG. 19A is a diagram showing a step subsequent to that of FIG. 18A.
[FIG. 19B] FIG. 19B is a diagram showing a step subsequent to that of FIG. 18B.
[FIG. 20A] FIG. 20A is a diagram showing a step subsequent to that of FIG. 19A.
[FIG. 20B] FIG. 20B is a diagram showing a step subsequent to that of FIG. 19B.
[FIG. 21A] FIG. 21A is a diagram showing a step subsequent to that of FIG. 20A.
[FIG. 21B] FIG. 21B is a diagram showing a step subsequent to that of FIG. 20B.
[FIG. 22A] FIG. 22A is a diagram showing a step subsequent to that of FIG. 21A.
[FIG. 22B] FIG. 22B is a diagram showing a step subsequent to that of FIG. 21B.
[FIG. 23A] FIG. 23A is a diagram showing a step subsequent to that of FIG. 22A.
[FIG. 23B] FIG. 23B is a diagram showing a step subsequent to that of FIG. 22B.
[FIG. 24A] FIG. 24A is a diagram showing a step subsequent to that of FIG. 23A.
[FIG. 24B] FIG. 24B is a diagram showing a step subsequent to that of FIG. 23B.
[FIG. 25A] FIG. 25A is a diagram showing a step subsequent to that of FIG. 24A.
[FIG. 25B] FIG. 25B is a diagram showing a step subsequent to that of FIG. 24B.
[FIG. 26A] FIG. 26A is a diagram showing a step subsequent to that of FIG. 25A.
[FIG. 26B] FIG. 26B is a diagram showing a step subsequent to that of FIG. 25B.
[FIG. 27A] FIG. 27A is a diagram showing a step subsequent to that of FIG. 26A.
[FIG. 27B] FIG. 27B is a diagram showing a step subsequent to that of FIG. 26B.
[FIG. 28A] FIG. 28A is a diagram showing a step subsequent to that of FIG. 27A.
[FIG. 28B] FIG. 28B is a diagram showing a step subsequent to that of FIG. 27B.
[FIG. 29A] FIG. 29A is a diagram showing a step subsequent to that of FIG. 28A.
[FIG. 29B] FIG. 29B is a diagram showing a step subsequent to that of FIG. 28B.
[FIG. 30A] FIG. 30A is a diagram showing a step subsequent to that of FIG. 29A.
[FIG. 30B] FIG. 30B is a diagram showing a step subsequent to that of FIG. 29B.
[FIG. 31] FIG. 31 shows another preferred embodiment of the semiconductor device and is a perspective view corresponding to FIG. 5.
[FIG. 32] FIG. 32 shows another preferred embodiment of the semiconductor device and is a sectional view corresponding to FIG. 7.
[FIG. 33] FIG. 33 shows another preferred embodiment of the semiconductor device and is a perspective view corresponding to FIG. 5.
[FIG. 34] FIG. 34 shows another preferred embodiment of the semiconductor device and is a perspective view corresponding to FIG. 5.
[FIG. 35] FIG. 35 is a sectional view taken along line A-A shown in FIG. 34.
[FIG. 36] FIG. 36 is a sectional view taken along line B-B shown in FIG. 34.
[FIG. 37] FIG. 37 shows another preferred embodiment of the semiconductor device and is a sectional view corresponding to FIG. 7.
[FIG. 38] FIG. 38 shows another preferred embodiment of the semiconductor device and is a sectional view corresponding to FIG. 6.
[FIG. 39] FIG. 39 shows the other preferred embodiment of the semiconductor device and is a sectional view corresponding to FIG. 7.
[FIG. 40] FIG. 40 shows another preferred embodiment of the semiconductor device and is a sectional view corresponding to FIG. 6.
[FIG. 41] FIG. 41 shows the other preferred embodiment of the semiconductor device and is a sectional view corresponding to FIG. 7.
[FIG. 42] FIG. 42 shows another preferred embodiment of the semiconductor device and is a sectional view corresponding to FIG. 6.
[FIG. 43] FIG. 43 shows the other preferred embodiment of the semiconductor device and is a sectional view corresponding to FIG. 7.
[FIG. 44] FIG. 44 shows another preferred embodiment of the semiconductor device and is a sectional view corresponding to FIG. 6.
[FIG. 45] FIG. 45 shows the other preferred embodiment of the semiconductor device and is a sectional view corresponding to FIG. 7.
[FIG. 46] FIG. 46 shows another preferred embodiment of the semiconductor device and is a sectional view corresponding to FIG. 6.
[FIG. 47] FIG. 47 shows the other preferred embodiment of the semiconductor device and is a sectional view corresponding to FIG. 7.
[FIG. 48] FIG. 48 shows another preferred embodiment of the semiconductor device and is a sectional view corresponding to FIG. 6.
[FIG. 49] FIG. 49 shows the other preferred embodiment of the semiconductor device and is a sectional view corresponding to FIG. 7.
[FIG. 50] FIG. 50 shows another preferred embodiment of the semiconductor device and is a sectional view corresponding to FIG. 6.
[FIG. 51] FIG. 51 shows the other preferred embodiment of the semiconductor device and is a sectional view corresponding to FIG. 7.
[FIG. 52] FIG. 52 shows another preferred embodiment of the semiconductor device and is a sectional view corresponding to FIG. 6.
[FIG. 53] FIG. 53 shows the other preferred embodiment of the semiconductor device and is a sectional view corresponding to FIG. 7.
[FIG. 54] FIG. 54 shows another preferred embodiment of the semiconductor device and is a perspective view corresponding to FIG. 5.
[FIG. 55] FIG. 55 shows another preferred embodiment of the semiconductor device and is a perspective view corresponding to FIG. 5.
[FIG. 56] FIG. 56 shows the other preferred embodiment of the semiconductor device and is a sectional view corresponding to FIG. 6.
[FIG. 57] FIG. 57 shows another preferred embodiment of the semiconductor device and is a perspective view corresponding to FIG. 5.
[FIG. 58] FIG. 58 shows the other preferred embodiment of the semiconductor device and is a sectional view corresponding to FIG. 6.
[FIG. 59] FIG. 59 shows another preferred embodiment of the semiconductor device and is a sectional view corresponding to FIG. 6.
[FIG. 60] FIG. 60 shows the other preferred embodiment of the semiconductor device and is a sectional view corresponding to FIG. 7.
[FIG. 61] FIG. 61 shows another preferred embodiment of the semiconductor device and is a perspective view corresponding to FIG. 5.
[FIG. 62] FIG. 62 shows the other preferred embodiment of the semiconductor device and is a sectional view corresponding to FIG. 6.
[FIG. 63] FIG. 63 shows the other preferred embodiment of the semiconductor device and is a sectional view corresponding to FIG. 7.
[FIG. 64] FIG. 64 shows another preferred embodiment of the semiconductor device and is a perspective view corresponding to FIG. 5.
[FIG. 65] FIG. 65 shows the other preferred embodiment of the semiconductor device and is a sectional view corresponding to FIG. 6.
[FIG. 66] FIG. 66 shows another preferred embodiment of the semiconductor device and is a perspective view corresponding to FIG. 5.
[FIG. 67] FIG. 67 shows the other preferred embodiment of the semiconductor device and is a sectional view corresponding to FIG. 6.
[FIG. 68] FIG. 68 shows another preferred embodiment of the semiconductor device and is a perspective view corresponding to FIG. 5.
[FIG. 69] FIG. 69 shows the other preferred embodiment of the semiconductor device and is a sectional view corresponding to FIG. 6.

### [Detailed Description of Preferred Embodiments]

Preferred embodiments of the present disclosure shall be described in detail below with reference to the attached drawings.

The attached drawings are all schematic views and are not strictly illustrated, and scales, proportions, angles and the like thereof do not always match. Identical reference signs are given to corresponding structures among the attached drawings, and duplicate descriptions thereof shall be omitted or simplified. For the structures whose description has been omitted or simplified, the description given before the omission or simplification shall apply.

When the wording "substantially" is used in this description, the wording includes a numerical value (shape) equal to a numerical value (shape) of a comparison target and also includes numerical errors (shape errors) in a range of ±10% on a basis of the numerical value (shape) of the comparison target. Although the wordings "first," "second," "third," etc., are used in the following description, these are symbols attached to names of respective structures in order to clarify the order of description and are not attached with an intention of restricting the names of the respective structures.

In the following description, a conductivity type of a semiconductor (an impurity) is indicated using "p-type" or "n-type," and the "n-type" may be referred to as a "first conductivity type" and the "p-type" may be referred to as a "second conductivity type." As a matter of course, the "p-type" may be referred to as the "first conductivity type" and the "n-type" may be referred to as the "second conductivity type" instead. The "n-type" is a conductivity type due to a pentavalent element, and the "p-type" is a conductivity type due to a trivalent element. Unless mentioned otherwise, the trivalent element is at least one type among boron, aluminum, gallium, and indium. Unless mentioned otherwise, the pentavalent element is at least one type among nitrogen, phosphorus, arsenic, antimony, and bismuth.

### [Overall Arrangement of Semiconductor Device 1]

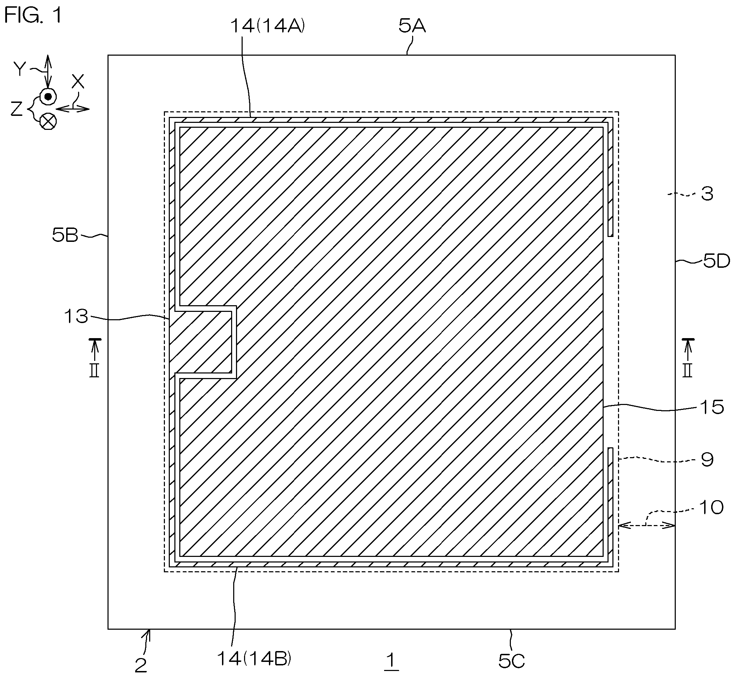

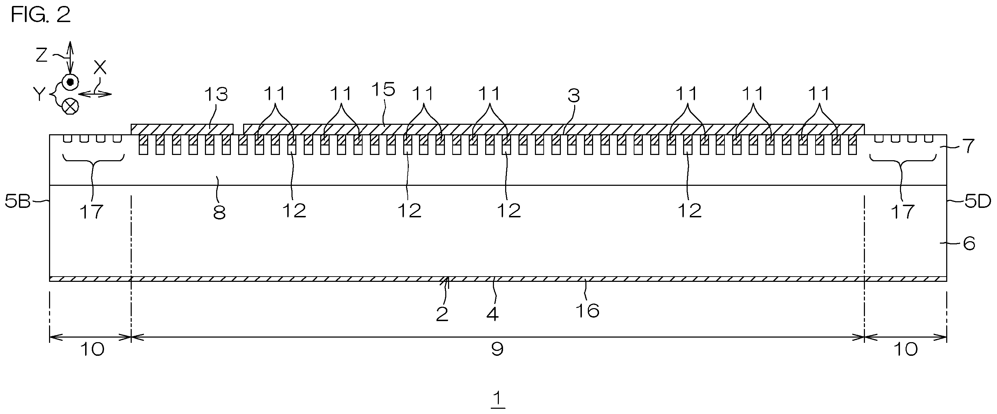

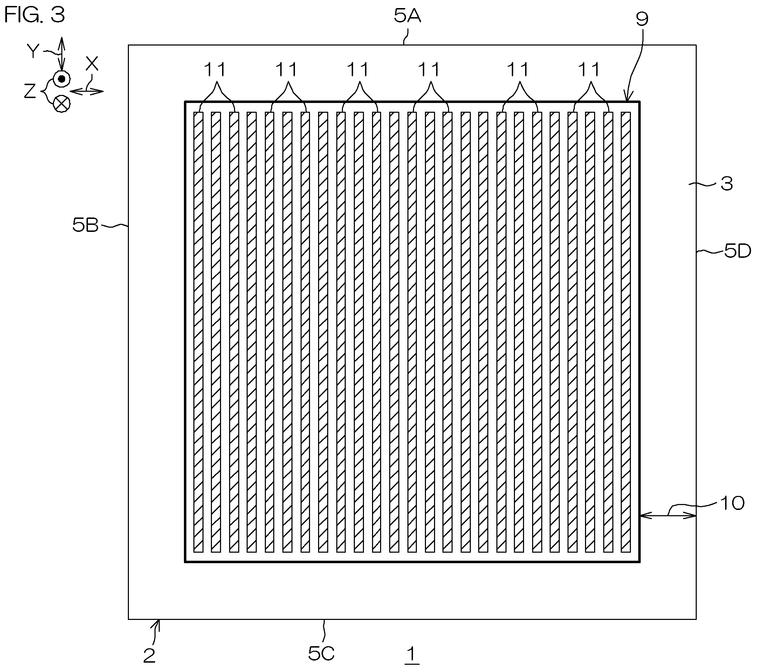

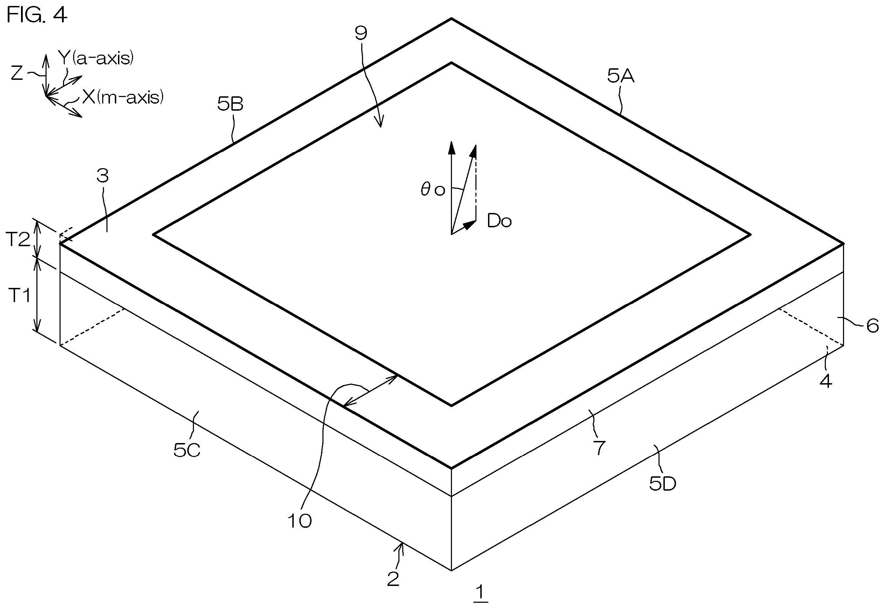

FIG. 1 is a plan view showing a semiconductor device 1 according to a preferred embodiment of the present disclosure. FIG. 2 is a sectional view taken along line II-II shown in FIG. 1. FIG. 3 is a plan view showing a layout example of a chip 2. FIG. 4 is a perspective view showing the layout example of the chip 2.

Referring to FIG. 1 to FIG. 4, the semiconductor device 1 includes the chip 2 that includes an SiC monocrystal. The chip 2 may be referred to as an "SiC chip" or a "semiconductor chip." In this embodiment, the chip 2 is constituted of the SiC monocrystal, which is a hexagonal crystal, and is formed in a rectangular parallelepiped shape. The SiC monocrystal that is a hexagonal crystal has multiple polytypes including a 2H (hexagonal)-SiC monocrystal, a 4H-SiC monocrystal, a 6H-SiC monocrystal, etc. In this embodiment, an example in which the chip 2 is constituted of the 4H-SiC monocrystal is to be given, but the chip 2 may be constituted of another polytype instead.

The chip 2 has a first principal surface 3 on one side, a second principal surface 4 on the other side, and first to fourth side surfaces 5A to 5D connecting the first principal surface 3 and the second principal surface 4. In a plan view as viewed from a vertical direction Z (hereinafter referred to simply as "plan view"), the first principal surface 3 and the second principal surface 4 are formed in quadrangle shapes. The vertical direction Z is also a thickness direction of the chip 2 and a normal direction to the first principal surface 3 (second principal surface 4). The first principal surface 3 and the second principal surface 4 may be formed in a square shape or a rectangular shape in plan view.

The first principal surface 3 and the second principal surface 4 are preferably formed by c-planes of the SiC monocrystal. In this case, preferably, the first principal surface 3 is formed by a silicon plane (a (0001) plane) of the SiC monocrystal and the second principal surface 4 is formed by a carbon plane (a (000-1) plane) of the SiC monocrystal.

In regard to a circumferential direction of the chip 2 with the first side surface 5A as a starting point (counterclockwise in FIG. 1), the second side surface 5B is connected to the first side surface 5A, the third side surface 5C is connected to the second side surface 5B, and the fourth side surface 5D is connected to the first side surface 5A and the third side surface 5C. The first side surface 5A and the third side surface 5C extend in a first direction X oriented along the first principal surface 3 and are opposed in a second direction Y intersecting (specifically, orthogonal to) the first direction X. The second side surface 5B and the fourth side surface 5D extend in the second direction Y and are opposed in the first direction X.

In this embodiment, the first direction X is an m-axis direction (a [1-100] direction) of the SiC monocrystal and the second direction Y is an a-axis direction (a [11-20] direction) of the SiC monocrystal. As a matter of course, the first direction X may be the a-axis direction of the SiC monocrystal and the second direction Y may be the m-axis direction of the SiC monocrystal instead.

An XY plane that includes the first direction X and the second direction Y forms a horizontal plane that is orthogonal to the vertical direction Z. In the following, an axis extending along the vertical direction Z is expressed at times as a "vertical axis." Also, in the following, the first direction X and the second direction Y are expressed at times as "horizontal directions." The horizontal directions are also directions that extend along the first principal surface 3.

Referring to FIG. 4, the chip 2 (the first principal surface 3 and the second principal surface 4) has an off angle θo inclined at a predetermined angle in a predetermined off direction Do with respect to the c-plane of the SiC monocrystal. That is, a c-axis (a (0001) axis) of the SiC monocrystal is inclined by just the off angle θo toward the off direction Do from the vertical axis. Also, the c-plane of the SiC monocrystal is inclined by just the off angle θo with respect to the horizontal plane.

The off direction Do is preferably the a-axis direction (that is, the second direction Y) of the SiC monocrystal. The off angle θo may exceed 0° and be not more than 10°. The off angle θo may have a value belonging to any one range among exceeding 0° and being not more than 1°, being not less than 1° and not more than 2.5°, being not less than 2.5° and not more than 5°, being not less than 5° and not more than 7.5°, and being not less than 7.5° and not more than 10°.

The off angle θo is preferably not more than 5°. The off angle θo is particularly preferably not less than 2° and not more than 4.5°. The off angle θo is typically set in a range of 4°±0.1°. As a matter of course, this Description does not exclude an embodiment in which the off angle θo is 0° (that is, an embodiment in which the first principal surface 3 is a just surface with respect to the c-plane).

The chip 2 includes a base layer 6 of the n-type that is constituted of the SiC monocrystal. The base layer 6 may be referred to as a "drain region," a "base SiC layer," a "base region," etc. The base layer 6 extends in a layered shape in the horizontal directions and forms the second principal surface 4 and portions of the first to fourth side surfaces 5A to 5D. In this embodiment, the base layer 6 is constituted of a substrate made of the SiC monocrystal (in other words, an SiC substrate). The base layer 6 has the off direction Do and the off angle θo described above.

The base layer 6 may have an n-type impurity concentration of not less than 1×10¹⁸ cm⁻³ and not more than 1×10²¹ cm⁻³ as a peak value. The base layer 6 preferably has an n-type impurity concentration that is substantially fixed in a thickness direction. The n-type impurity concentration of the base layer 6 is preferably adjusted by a single type of pentavalent element. The n-type impurity concentration of the base layer 6 is particularly preferably adjusted by a pentavalent element other than phosphorus. In this embodiment, the n-type impurity concentration of the base layer 6 is adjusted by nitrogen.

The base layer 6 has a first thickness T1. The first thickness T1 may be not less than 5 µm and not more than 300 µm. The first thickness T1 is preferably not less than 50 µm and not more than 250 µm.

The chip 2 includes a semiconductor layer 7 made of the SiC monocrystal that is laminated on the base layer 6. As an example of a first impurity region, the semiconductor layer 7 may be referred to as a "drift region," an "SiC layer," a "semiconductor region," etc. The semiconductor layer 7 extends in a layered shape in the horizontal directions and forms the first principal surface 3 and portions of the first to fourth side surfaces 5A to 5D. The semiconductor layer 7 is constituted of an epitaxial layer (that is, an SiC epitaxial layer) formed by crystal growth with the base layer 6 as a starting point.

The semiconductor layer 7 has a lower end and an upper end. The lower end of the semiconductor layer 7 is a crystal growth starting point and the upper end of the semiconductor layer 7 is a crystal growth end point. The lower end of the semiconductor layer 7 is also a bottom portion of the semiconductor layer 7. The semiconductor layer 7 is formed by continuous crystal growth from the base layer 6 and therefore, the lower end of the semiconductor layer 7 coincides with an upper end of the base layer 6.

The semiconductor layer 7 includes a drift region 8 of the n-type. In this embodiment, the drift region 8 is formed by a portion (an n-type portion) of the semiconductor layer 7.

A boundary portion between the base layer 6 and the semiconductor layer 7 is not necessarily visually recognizable and can be evaluated and/or determined indirectly from other arrangements and elements. The semiconductor layer 7 has an off direction Do and an off angle θo that substantially coincide with the off direction Do and the off angle θo of the base layer 6.

The semiconductor layer 7 has a second thickness T2 less than the first thickness T1. The second thickness T2 may be not less than 1 µm and not more than 10 µm. The second thickness T2 is preferably not less than 2 µm and not more than 8 µm.

The semiconductor device 1 includes an active region 9 that is set in the chip 2. The active region 9 is set in an inner portion of the chip 2 at intervals from peripheral edges (the first to fourth side surfaces 5A to 5D) of the chip 2 in plan view. The active region 9 is set in a polygonal shape (in this embodiment, a quadrangle shape) having four sides parallel to the peripheral edges of the chip 2 in plan view. A planar area of the active region 9 is preferably not less than 50% and not more than 90% of a planar area of the first principal surface 3.

The semiconductor device 1 includes an outer peripheral region 10 that, in the chip 2, is set outside the active region 9. The outer peripheral region 10 is provided in a region between the peripheral edges of the chip 2 and the active region 9 in plan view. The outer peripheral region 10 extends as a band along the active region 9 and is set to a polygonal annular shape (in this embodiment, a quadrangle annular shape) that surrounds the active region 9 in plan view.

The semiconductor device 1 includes a plurality of trench structures 11 of a trench electrode type that are formed in the first principal surface 3 in the active region 9. The trench structures 11 may be referred to as "gate structures," "trench gate structures," etc. A gate potential is applied as a control potential to the plurality of trench structures 11.

The plurality of trench structures 11 are arranged at intervals inward from peripheral edges of the active region 9. In this embodiment, the plurality of trench structures 11 are aligned at intervals in the first direction X and are each formed in a band shape extending in the second direction Y. That is, the plurality of trench structures 11 are aligned at intervals in the m-axis direction and each extend in the a-axis direction.

Also, in this embodiment, the plurality of trench structures 11 are aligned as stripes extending in the a-axis direction (the second direction Y). An extension direction of the plurality of trench structures 11 coincides with the off direction Do of the semiconductor layer 7. The plurality of trench structures 11 are formed at intervals to the first principal surface 3 side from the lower end of the semiconductor layer 7 (from the base layer 6) and faces the base layer 6 with a portion of the semiconductor layer 7 interposed therebetween.

The semiconductor device 1 includes a plurality of electric field relaxation layers 12 of the p-type that are formed at intervals in a horizontal direction inside the semiconductor layer 7. Specifically, the plurality of electric field relaxation layers 12 are respectively formed at bottom portions of the trench structures 11.

The semiconductor device 1 includes a gate pad 13 that is arranged on the first principal surface 3. The gate pad 13 is an electrode to which the gate potential is applied from the exterior. The gate pad 13 may be referred to as a "gate pad electrode," a "first pad electrode," etc. The gate pad 13 may have a laminated structure that includes a Ti-based metal film and an Al-based metal film that are laminated in that order from the first principal surface 3 side.

In this embodiment, the gate pad 13 is arranged on the active region 9. Specifically, the gate pad 13 is arranged in a region near a central portion of one side (in this embodiment, the second side surface 5B side) of the first principal surface 3 in plan view. As a matter of course, the gate pad 13 may be arranged in a region along any of central portions of the first to fourth side surfaces 5A to 5D. As a matter of course, the gate pad 13 may be arranged in an arbitrary corner portion of the first principal surface 3 in plan view. Also, the gate pad 13 may be arranged in a central portion of the first principal surface 3 in plan view. In this embodiment, the gate pad 13 is formed in a quadrangle shape in plan view.

The semiconductor device 1 includes at least one (in this embodiment, a plurality of) gate wiring 14 that is led out onto the first principal surface 3 from the gate pad 13. The gate wirings 14 may be referred to as "wirings," "wiring electrodes," etc. In this embodiment, the plurality of gate wirings 14 are arranged on the active region 9.

The plurality of gate wirings 14 may have a laminated structure that includes a Ti-based metal film and an Al-based metal film that are laminated in that order from the first principal surface 3 side. In this embodiment, the plurality of gate wirings 14 include a first gate wiring 14A and a second gate wiring 14B.

The first gate wiring 14A is led out toward the first side surface 5A side from the gate pad 13 and extends in a line shape along the peripheral edge of the first principal surface 3 such as to intersect (specifically, be orthogonal to) portions (specifically, one end portions) of the plurality of trench structures 11. The first gate wiring 14A is electrically connected to the one end portions of the plurality of trench structures 11 at unillustrated positions.

The second gate wiring 14B is led out toward the third side surface 5C side from the gate pad 13 and extends in a line shape along the peripheral edge of the first principal surface 3 such as to intersect (specifically, be orthogonal to) portions (specifically, other end portions) of the plurality of trench structures 11. The second gate wiring 14B is electrically connected to the other end portions of the plurality of trench structures 11 at unillustrated positions.

The semiconductor device 1 includes a source pad 15 as an example of a first principal surface electrode that is arranged on the first principal surface 3 at intervals from the gate pad 13 and the gate wirings 14. The source pad 15 is an electrode to which a source potential is applied from the exterior. The source pad 15 may be referred to as a "source pad electrode," a "second pad electrode," etc. The source pad 15 may have a laminated structure that includes a Ti-based metal film and an Al-based metal film that are laminated in that order from the first principal surface 3 side.

In this embodiment, the source pad 15 is arranged on the active region 9 in plan view. In this embodiment, the source pad 15 is formed in a polygonal shape having a recess portion that is recessed along the gate pad 13 in plan view. As a matter of course, the source pad 15 may instead be formed in a quadrangle shape in plan view.

The semiconductor device 1 includes a drain pad 16 that covers the second principal surface 4. The drain pad 16 is an electrode to which a drain potential is applied from the exterior. The drain pad 16 may be referred to as a "drain pad electrode," a "third pad electrode," etc. The drain pad 16 forms an ohmic contact with the base layer 6 exposed from the second principal surface 4.

The drain pad 16 may cover an entire region of the second principal surface 4 such as to be continuous to the peripheral edges (the first to fourth side surfaces 5A to 5D) of the chip 2. The drain pad 16 may instead cover the second principal surface 4 at intervals inward from the peripheral edges of the chip 2 such as to expose peripheral edge portions of the chip 2.

A breakdown voltage applicable between the source pad 15 and the drain pad 16 (between the first principal surface 3 and the second principal surface 4) may be not less than 500 V and not more than 3000 V. The breakdown voltage may have a value belonging to any one range among not less than 500 V and not more than 1000 V, not less than 1000 V and not more than 1500 V, not less than 1500 V and not more than 2000 V, not less than 2000 V and not more than 2500 V, and not less than 2500 V and not more than 3000 V.

The semiconductor device 1 includes at least one (preferably 2 or more and not more than 20 of) field region 17 of the p-type formed in the outer peripheral region 10. The number of the plurality of field regions 17 is typically not less than 4 and not more than 8. The plurality of field regions 17 are formed in an electrically floating state and relax an electric field inside the chip 2 at peripheral edge portions of the first principal surface 3. The number, a width, a depth, a p-type impurity concentration, etc., of the field regions 17 are arbitrary and can take on various values in accordance with the electric field to be relaxed. In this embodiment, the plurality of field regions 17 are aligned at intervals from the peripheral edges of the first principal surface 3 (from the first to fourth side surfaces 5A to 5D).

The plurality of field regions 17 are formed in band shapes extending along the active region 9 in plan view. The plurality of field regions 17 each have portions extending in a band shape in the first direction X and portions extending in a band shape in the second direction Y. In this embodiment, the plurality of field regions 17 are formed in annular shapes (specifically, quadrangle annular shapes) surrounding the active region 9 (that is, the plurality of electric field relaxation layers 12) in plan view.

### [Detailed Structure of Active Region 9 of Semiconductor Device 1]

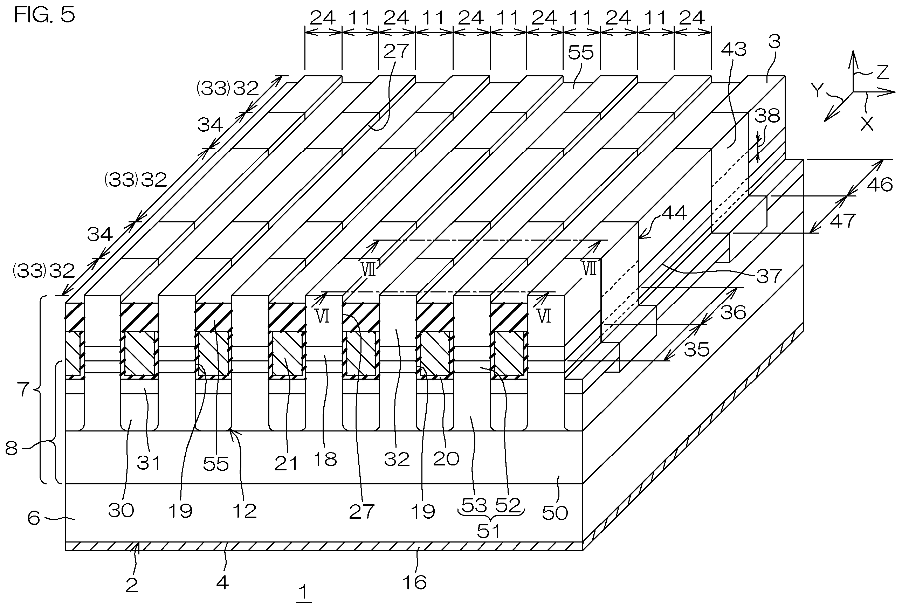

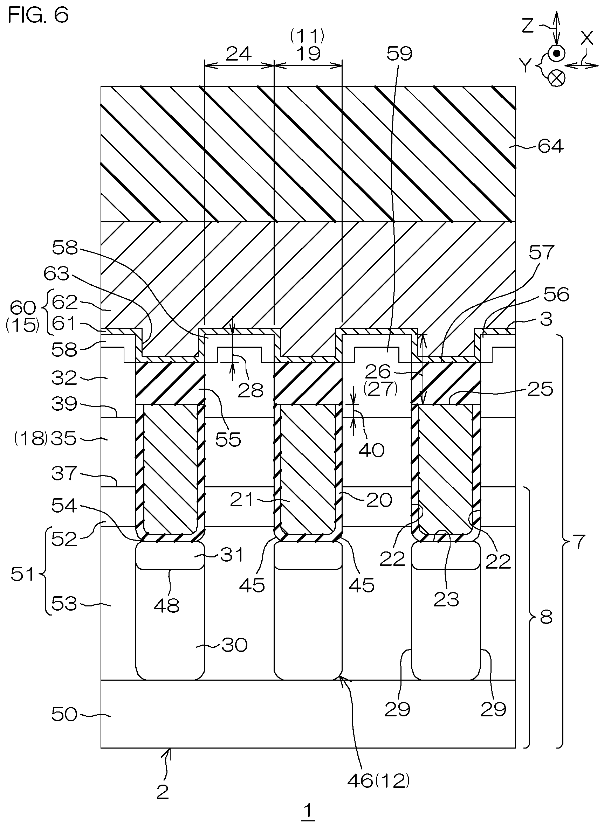

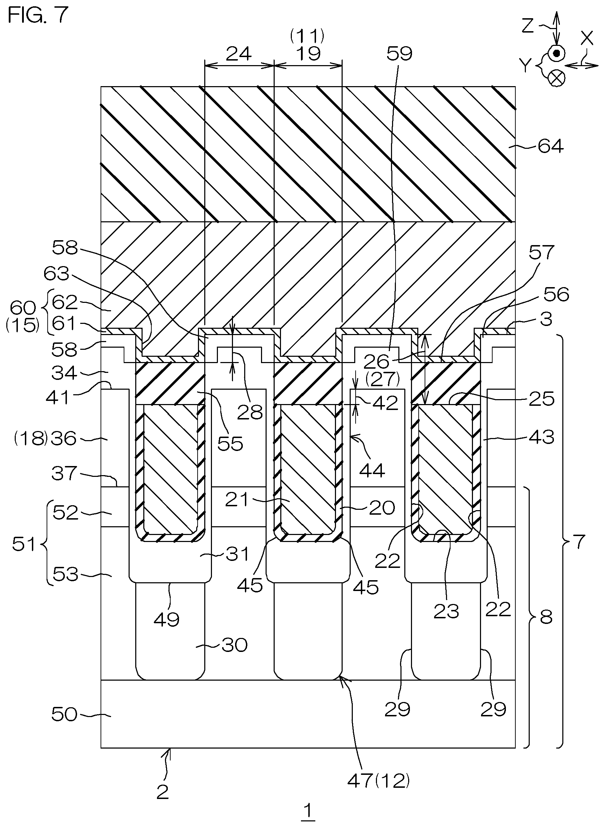

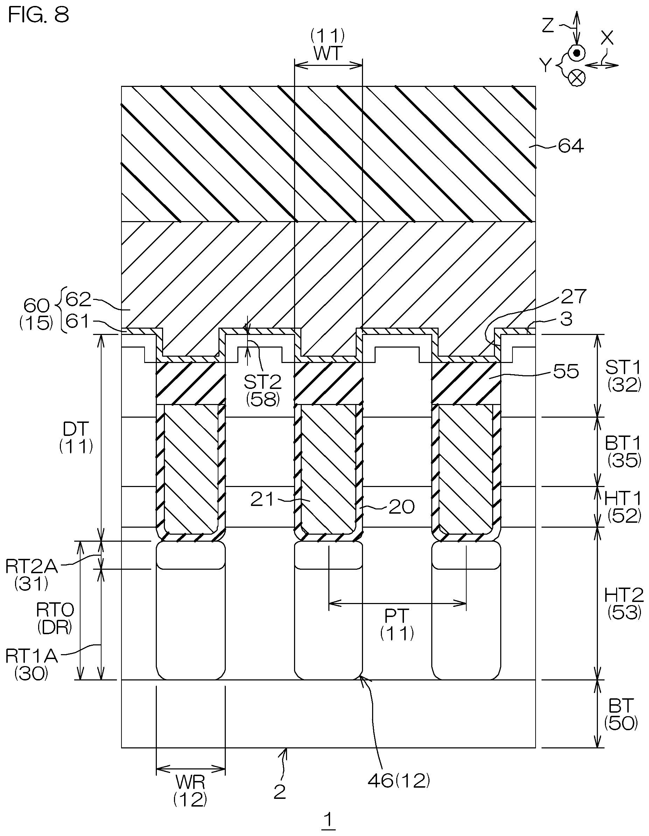

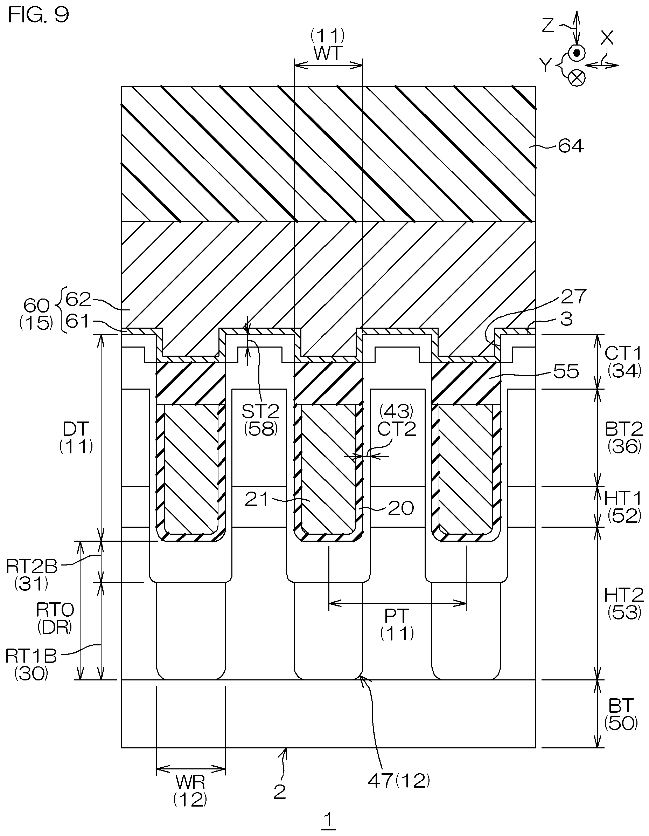

FIG. 5 is a perspective view showing the active region 9 and the trench structures 11. FIG. 6 is a sectional view taken along line VI-VI shown in FIG. 5. FIG. 7 is a sectional view taken along line VII-VII shown in FIG. 5. FIG. 8 is the same sectional view as FIG. 6 and is a diagram mainly showing dimensions of respective portions. FIG. 9 is the same sectional view as FIG. 7 and is a diagram mainly showing dimensions of respective portions. In the following, for clarity of drawings, dimensions (thickness, width, depth, etc.) of respective portions of the semiconductor device 1 are shown in FIG. 8 and FIG. 9 and omitted from illustration in FIG. 5 to FIG. 7. In FIG. 8 and FIG. 9, in addition to the dimensions of the respective portions, the signs of main components are attached.

Referring to FIG. 5 to FIG. 9, the semiconductor device 1 includes a body region 18 of the p-type that is formed in a surface layer portion of the drift region 8. In this embodiment, the body region 18 as an example of a second impurity region is formed in a layered shape extending along the first principal surface 3. The body region 18 may be formed in an entire region of the surface layer portion of the drift region 8 and be exposed from the first to fourth side surfaces 5A to 5D. Referring to FIG. 5, the body region 18 is formed at an interval to the first principal surface 3 side from the lower end of the semiconductor layer 7.

The body region 18 may have a p-type impurity concentration of not less than 1×10¹⁵ cm⁻³ and not more than 1×10¹⁸ cm⁻³ as a peak value. The p-type impurity concentration of the body region 18 is preferably adjusted by at least one type of trivalent element. The trivalent element of the body region 18 may be at least one type among boron, aluminum, gallium, and indium.

As mentioned above, the semiconductor device 1 includes the trench structures 11. Referring to FIG. 8 and FIG. 9, each trench structure 11 has a trench width WT in an alignment direction and has a trench depth DT in the vertical direction Z. The trench width WT is preferably less than the second thickness T2 of the semiconductor layer 7 (see FIG. 4). The trench width WT may be not less than 0.1 µm and not more than 5 µm.

The trench width WT may have a value belonging to any one range among not less than 0.1 µm and not more than 0.25 µm, not less than 0.25 µm and not more than 0.5 µm, not less than 0.5 µm and not more than 0.75 µm, not less than 0.75 µm and not more than 1 µm, not less than 1 µm and not more than 1.5 µm, not less than 1.5 µm and not more than 2 µm, not less than 2 µm and not more than 2.5 µm, not less than 2.5 µm and not more than 3 µm, not less than 3 µm and not more than 3.5 µm, not less than 3.5 µm and not more than 4 µm, not less than 4 µm and not more than 4.5 µm, and not less than 4.5 µm and not more than 5 µm.

The trench depth DT is preferably less than the second thickness T2 of the semiconductor layer 7. The trench depth DT is preferably greater than the trench width WT. That is, each of the plurality of trench structures 11 preferably has an aspect ratio DT/WT of extending in a vertically long columnar shape. The aspect ratio DT/WT is a ratio of the trench width WT with respect to the trench depth DT. The aspect ratio DT/WT may, for example, be not less than 1 and not more than 5 and is preferably not less than 1 and not more than 3.

The trench depth DT may be not less than 0.1 µm and not more than 5 µm. The trench depth DT may have a value belonging to any one range among not less than 0.1 µm and not more than 0.25 µm, not less than 0.25 µm and not more than 0.5 µm, not less than 0.5 µm and not more than 1 µm, not less than 1 µm and not more than 1.5 µm, not less than 1.5 µm and not more than 2 µm, not less than 2 µm and not more than 3 µm, not less than 3 µm and not more than 4 µm, and not less than 4 µm and not more than 5 µm. The trench depth DT is preferably not less than 0.1 µm and not more than 1.5 µm and more preferably not less than 0.5 µm and not more than 1.5 µm.

The plurality of trench structures 11 are aligned at intervals, each of a trench pitch PT, in the first direction X. The trench pitch PT is preferably less than the second thickness T2 of the semiconductor layer 7. The trench pitch PT is preferably less than the trench depth DT. The trench pitch PT may be not less than 0.1 µm and not more than 5 µm.

The trench pitch PT may have a value belonging to any one range among not less than 0.1 µm and not more than 0.25 µm, not less than 0.25 µm and not more than 0.5 µm, not less than 0.5 µm and not more than 0.75 µm, not less than 0.75 µm and not more than 1 µm, not less than 1 µm and not more than 1.5 µm, not less than 1.5 µm and not more than 2 µm, not less than 2 µm and not more than 2.5 µm, not less than 2.5 µm and not more than 3 µm, not less than 3 µm and not more than 3.5 µm, not less than 3.5 µm and not more than 4 µm, not less than 4 µm and not more than 4.5 µm, and not less than 4.5 µm and not more than 5 µm. The trench pitch PT is preferably not less than 0.5 µm and not more than 3 µm and more preferably not less than 0.5 µm and not more than 1.5 µm.

Referring to FIG. 5 to FIG. 7, each trench structure 11 includes a trench 19, a trench insulating film 20, and an embedded body 21. The trench 19 may be referred to as an "element trench," a "gate trench," etc. The trench insulating film 20 may be referred to as an "element insulating film," a "gate insulating film," etc. The embedded body 21 may be referred to as an "embedded electrode," a "gate electrode," etc.

The trench 19 is formed in the first principal surface 3 and demarcates inner surfaces (side surfaces 22 and a bottom surface 23 shown in FIG. 6 and FIG. 7) of the trench structure 11. The bottom surface 23 of the trench 19 preferably has a portion that extends flatly. A mesa portion 24, formed by a portion of the semiconductor layer 7, is formed between adjacent trenches 19. The mesa portion 24 may be referred to as an "element mesa portion."

As shown in FIG. 5, the plurality of trench structures 11 (the plurality of trenches 19) and the plurality of mesa portions 24 are of band shapes extending along the second direction Y and are aligned alternately in the first direction X. As a whole, the plurality of trenches 19 and the plurality of mesa portions 24 are aligned as stripes.

Referring to FIG. 6 and FIG. 7, the flat portion of the bottom surface 23 of each trench 19 particularly preferably extends substantially parallel to the first principal surface 3. That is, a bottom wall of the trench 19 preferably has the off angle θo inclined at the predetermined angle in the predetermined off direction Do with respect to the c-plane (see FIG. 4). That is, the bottom surface 23 of the trench 19 preferably has the flat portion that extends in the off direction Do. As a matter of course, the bottom surface 23 of the trench 19 may instead be curved in an arcuate shape toward the lower end side of the semiconductor layer 7.

The trench insulating film 20 covers the inner surfaces of the trench 19. The trench insulating film 20 may include at least one among a silicon oxide film, a silicon nitride film, and a silicon oxynitride film. In this embodiment, the trench insulating film 20 has a single layer structure constituted of the silicon oxide film. The trench insulating film 20 particularly preferably includes a silicon oxide film that consists of an oxide of the chip 2.

The embedded body 21 is embedded in the trench 19 and faces channels with the trench insulating film 20 interposed therebetween. In this embodiment, the embedded body 21 faces the body region 18 with the trench insulating film 20 interposed therebetween. The embedded body 21 may contain a conductive polysilicon of the p-type or the n-type.

Referring to FIG. 6 and FIG. 7, the embedded body 21 is embedded to an intermediate portion of the trench 19 in a depth direction. The embedded body 21 has an upper surface 25 positioned at the second principal surface 4 side with respect to the first principal surface 3. A level difference 26 downward towards the second principal surface 4 is formed between the upper surface 25 of the embedded body 21 and the first principal surface 3. A recess 27 demarcated by the upper surface 25 of the embedded body 21 and the side surfaces 22 of the trench 19 is formed at an upper portion of the trench 19 by the level difference 26.

The recess 27 is a space surrounded by both side surfaces 22 of the trench 19 and the upper surface 25 of the embedded body 21. As shown in FIG. 5, the recess 27 is formed in a band shape that is continuous in a front-back direction of the trench 19 (the second direction Y). The trench insulating film 20 is selectively formed in a region sandwiched between the inner surfaces of the trench 19 and embedded body 21 and side surfaces 22 of the recess 27 (portions of the side surfaces 22 of the trench 19) are exposed from the trench insulating film 20.

By the forming of the recesses 27, portions of the mesa portions 24 in the depth direction of the trenches 19 project, further to the first principal surface 3 side (to the upper side) than the embedded bodies 21, as projection portions 28. As shown in FIG. 5, the projection portion 28 of each mesa portion 24 is a portion of the mesa portion 24 that is sandwiched by adjacent recesses 27 and is formed in a band shape that is continuous in the front-back direction of the trench 19.

As mentioned above, the semiconductor device 1 includes the electric field relaxation layers 12. The electric field relaxation layers 12 are formed at the bottom portions of the trench structures 11. More specifically, the electric field relaxation layers 12 are formed at bottom portions of the trenches 19. The electric field relaxation layers 12 are exposed from the bottom surfaces 23 of the trenches 19 and contact the trench insulating films 20. Upper end portions of the electric field relaxation layers 12 are thus exposed at the bottom surfaces 23 of the trench structures 11 (the trenches 19).

In the depth direction of the trenches 19, the electric field relaxation layers 12 face the embedded bodies 21 via the trench insulating films 20. At the bottom portion of each trench 19, the trench insulating film 20 is sandwiched by the embedded body 21 and the electric field relaxation layer 12.

Referring to FIG. 5, each electric field relaxation layer 12 is formed at the bottom portion of the trench 19 across the entire front-back direction of the trench 19 and is formed in a band shape extending in the front-back direction of the trench 19. Referring to FIG. 6 and FIG. 7, the electric field relaxation layer 12 is formed such as to extend between one end portion and another end portion of the trench 19 in a width direction of the trench 19. In this embodiment, the electric field relaxation layer 12 has, in the depth direction of the trench 19, one side surface 29 formed on substantially the same plane as one side surface 22 in the width direction of the trench 19 and another side surface 29 formed on substantially the same plane as the other side surface 22 in the width direction of the trench 19.

In other words, each electric field relaxation layer 12 has, in the depth direction of the trench structure 11, the side surfaces 29 that are flush with and continuous to the both side surfaces 22 of the trench 19. The side surfaces 29 of the electric field relaxation layer 12 extend in the depth direction of the trench structure 11 and form boundary surfaces with respect to the semiconductor layer 7 (the drift region 8). Therefore, the electric field relaxation layer 12 is physically separated from the body region 18 in the depth direction of the trench structure 11 and forms the entire bottom surface 23 of the trench structure 11.

In this embodiment, the electric field relaxation layer 12 has a laminated structure of a first layer 30 and a second layer 31. The first layer 30 is a layer that is formed separated to the second principal surface 4 side from the bottom portion (in this embodiment, the bottom surface 23) of the trench 19. The second layer 31 is a layer that is formed between the first layer 30 and the bottom portion (in this embodiment, the bottom surface 23) of the trench 19. The second layer 31 is exposed from the bottom surface 23 of the trench 19 and contacts the trench insulating film 20. The second layer 31 is sandwiched between the first layer 30 and the trench 19 portion.

In regard to an impurity concentration of the electric field relaxation layer 12, the first layer 30 has a first impurity concentration and the second layer 31 has a second impurity concentration. In this embodiment, the second impurity concentration of the second layer 31 is higher than the first impurity concentration of the first layer 30. Also, the first impurity concentration of the first layer 30 may be equivalent to the impurity concentration of the body region 18. The second impurity concentration of the second layer 31 may be higher than the impurity concentration of the body region 18.

For example, the first impurity concentration of the first layer 30 may have a p-type impurity concentration of not less than 1×10¹⁵ cm⁻³ and not more than 1×10¹⁸ cm⁻³ as a peak value. The second impurity concentration of the second layer 31 may have a p-type impurity concentration of not less than 1×10¹⁸ cm⁻³ and not more than 1×10²¹ cm⁻³ as a peak value. The p-type impurity concentrations of the first layer 30 and the second layer 31 are preferably adjusted by at least one type of trivalent element. The trivalent element of the first layer 30 and the second layer 31 may be at least one type among boron, aluminum, gallium, and indium.

The laminated structure of the first layer 30 and the second layer 31 is continuous in the front-back direction of the trench 19. In this embodiment, as shown in FIG. 5, the electric field relaxation layer 12 is formed in the band shape extending in the front-back direction of the trench 19 such that the laminated structure of the first layer 30 and the second layer 31 is continuous across the entire front-back direction of the trench 19. For example, the plurality of electric field relaxation layers 12 are aligned at intervals in the m-axis direction and extend in the a-axis direction of the SiC monocrystal. The plurality of electric field relaxation layers 12 are formed as stripes extending in the a-axis direction (the second direction Y) and an extension direction of the plurality of electric field relaxation layers 12 coincides with the off direction Do of the semiconductor layer 7 (see FIG. 4).

The plurality of electric field relaxation layers 12 overlap with the plurality of trench structures 11 in the depth direction of the trenches 19. Specifically, the plurality of electric field relaxation layers 12 overlap with the plurality of trench structures 11 in one-to-one correspondence in the thickness direction of the chip 2. In this embodiment, the plurality of electric field relaxation layers 12 are respectively connected to the bottom surfaces 23 of the corresponding trench structures 11.

Referring to FIG. 8 and FIG. 9, each electric field relaxation layer 12 has a relaxation depth DR in the vertical direction Z.

The relaxation depth DR may have a value belonging to any one range among exceeding 0.25 µm and being not more than 0.5 µm, being not less than 0.5 µm and not more than 1 µm, being not less than 1 µm and not more than 1.5 µm, being not less than 1.5 µm and not more than 2 µm, being not less than 2 µm and not more than 3 µm, being not less than 3 µm and not more than 4 µm, and being not less than 4 µm and not more than 5 µm. The relaxation depth DR is preferably not less than 1.5 µm and not more than 2.5 µm.

The plurality of electric field relaxation layers 12 each have a relaxation width WR in an alignment direction. The relaxation width WR may be not less than 0.25 µm and not more than 5 µm. The relaxation width WR may have a value belonging to any one range among not less than 0.25 µm and not more than 0.5 µm, not less than 0.5 µm and not more than 0.75 µm, not less than 0.75 µm and not more than 1 µm, not less than 1 µm and not more than 1.5 µm, not less than 1.5 µm and not more than 2 µm, not less than 2 µm and not more than 2.5 µm, not less than 2.5 µm and not more than 3 µm, not less than 3 µm and not more than 3.5 µm, not less than 3.5 µm and not more than 4 µm, not less than 4 µm and not more than 4.5 µm, and not less than 4.5 µm and not more than 5 µm.

Referring to FIG. 5 and FIG. 6, the semiconductor device 1 includes source regions 32 as an example of a third impurity region in a surface layer portion of the first principal surface 3. The source regions 32 are formed in regions between the plurality of trench structures 11. The source regions 32 are formed in a surface layer portion of the body region 18.

In this embodiment, a plurality of the source regions 32 are each formed to reach from one side surface 22 to another side surface 22 of the mesa portion 24 (one side surface 22 and another side surface 22 of the trenches 19) such as to cross the mesa portion 24 in the width direction. In each mesa portion 24, the plurality of source regions 32 are aligned at intervals along the front-back direction of the trenches 19. Thereby, in each mesa portion 24, a plurality of channel sections 33 are aligned at intervals in the second direction Y (the front-back direction of the trenches 19). In each channel section 33, channels are formed in both of the side surfaces 22 of the trenches 19 at both sides in the first direction X of the mesa portion 24.

Each source region 32 has a higher n-type impurity concentration (peak value) than the semiconductor layer 7 (the drift region 8). The source region 32 may have an n-type impurity concentration of not less than 1×10¹⁸ cm⁻³ and not more than 1×10²¹ cm⁻³ as a peak value.

Referring to FIG. 8, the source region 32 has a source thickness ST1. The source thickness ST1 may be a thickness of the source region 32 in the vertical direction Z from the first principal surface 3. The source thickness ST1 may, for example, be not less than 0.2 µm and not more than 1.0 µm and preferably be not less than 0.4 µm and not more than 0.8 µm.

Referring to FIG. 5 and FIG. 7, the semiconductor device 1 includes first contact regions 34 in the surface layer portion of the first principal surface 3. The first contact regions 34 are formed in regions between the plurality of trench structures 11. The first contact regions 34 are formed adjacent to the source regions 32 in the surface layer portion of the body region 18.

In this embodiment, a plurality of the first contact regions 34 are formed to reach from one side surface 22 to another side surface 22 of each mesa portion 24 such as to cross the mesa portion 24 in the width direction. In each mesa portion, the plurality of source regions 32 and the plurality of first contact regions 34 are aligned alternately along the front-back direction of the trenches 19. Each source region 32 and each first contact region 34 are respectively exposed from both of the side surfaces 22 of the trenches 19 (both of the side surfaces 22 of the mesa portion 24).

Mainly comparing FIG. 6 and FIG. 7, the body region 18 includes first body portions 35 (FIG. 6) formed directly below the source regions 32 and second body portions 36 (FIG. 7) formed directly below the first contact regions 34. The first body portions 35 are portions of the body region 18 that are sandwiched between the source regions 32 and the drift region 8 in the depth direction of the trenches 19. The second body portions 36 are portions of the body region 18 that are sandwiched between the first contact regions 34 and the drift region 8 in the depth direction of the trenches 19.

Referring to FIG. 8 and FIG. 9, each first body portion 35 has a first body thickness BT1 and each second body portion 36 has a second body thickness BT2. The second body thickness BT2 is greater than the first body thickness BT1. Referring to FIG. 5 to FIG. 7, the body region 18 forms a base boundary surface 37 with the drift region 8. The base boundary surface 37 is positioned, along the front-back direction of the trenches 19, at a fixed depth from the bottom surfaces 23 of the trenches 19. As shown in FIG. 5, the body region 18 has body projection portions 38 projecting selectively to the first principal surface 3 side directly below the first contact regions 34. Due to the body projection portions 38, the body region 18 has the second body portions 36 that are selectively thick with respect to the base boundary surface 37.

Referring to FIG. 6, first boundary surfaces 39 between the first body portions 35 and the source regions 32 are positioned further to the second principal surface 4 side than the upper surfaces 25 of the embedded bodies 21. Each of the first boundary surfaces 39 is formed at a position lower than the upper surface 25 of the embedded body 21 and a first level difference 40 is formed between the upper surface 25 of the embedded body 21 and the first boundary surface 39. A portion (for example, a lower end portion) of each source region 32 faces the embedded body 21 via the trench insulating film 20. Forming of channels between a source and a drain is thereby secured.

Referring to FIG. 7, second boundary surfaces 41 between the second body portions 36 and the first contact regions 34 are positioned further to the first principal surface 3 side than the upper surfaces 25 of the embedded bodies 21. Each of the second boundary surfaces 41 is formed at a position higher than the upper surface 25 of the embedded body 21 and a second level difference 42 is formed between the upper surface 25 of the embedded body 21 and the second boundary surface 41. A portion (for example, an upper end portion) of each second body portion 36 projects further to the first principal surface 3 side (the upper side) than the embedded body 21. The first contact regions 34 are not regions that directly contribute to the forming of channels between the source and the drain and therefore, unlike the source regions 32, do not need to face the embedded bodies 21 via the trench insulating films 20.

Referring to FIG. 5 and FIG. 7, the semiconductor device 1 includes second contact regions 43 in the surface layer portion of the first principal surface 3. The second contact regions 43 connect the first contact regions 34 and the electric field relaxation layers 12. The second contact regions 43 are formed from the first contact regions 34 toward the second principal surface 4 along the side surfaces 22 of the trenches 19 and are connected to the electric field relaxation layers 12. In this embodiment, the second contact regions 43 are formed along both the one side surface 22 and the other side surface 22 of each mesa portion 24 from the first contact region 34 exposed from both side surfaces 22 of the mesa portion 24.

Each second contact region 43 is formed across the entire depth direction of the trench 19 from the upper portion to the bottom portion of the trench 19. The second contact region 43 has a lower end portion in a vicinity of the bottom portion of the trench 19 and has an upper end portion in a vicinity of the upper portion of the trench 19.

The second contact region 43 penetrates through the body region 18 and extends between the body region 18 and the electric field relaxation layer 12. The second contact region 43 forms a boundary with the body region 18 and is connected to the body region 18. The second contact region 43 is further connected to the semiconductor layer 7 (the drift region 8) below the body region 18 as well. That is, in a section between the body region 18 and the electric field relaxation layer 12, a pn junction portion is formed by the second contact region 43 and the drift region 8.

Referring to FIG. 7, the second contact region 43 is exposed from the side surface 22 of the trench 19 and contacts the trench insulating film 20 at the side surface 22 of the trench 19. A lower end portion of the second contact region 43 contacts the second layer 31 of the electric field relaxation layer 12. Thereby, an integral impurity region 44 of the p-type is formed by the first contact regions 34, the second contact regions 43, and the second layers 31 in the semiconductor layer 7.

Referring to FIG. 7, at the side surfaces 22 and the bottom surface 23 of each trench 19, the integral impurity region 44 partially covers the embedded body 21 with the trench insulating film 20 interposed therebetween. More specifically, at each of second relaxation portions 47, both end corner portions 45 in the width direction of the trench 19 are covered by the integral impurity region 44 of substantially Z-shape in cross-sectional view. Electric field concentration at the corner portions 45 of the trench 19 can thereby be suppressed.

On the other hand, referring to FIG. 6, at each of first relaxation portions 46, a portion of the electric field relaxation layer 12 (the second layer 31) may be separated from the corner portions of the trench 19. That is, in the front-back direction of the trench 19, each corner portion 45 of the trench 19 may have portions covered by the electric field relaxation layer 12 and portions not covered by the electric field relaxation layer 12.

In this embodiment, a plurality of the integral impurity regions 44 are formed at intervals along the front-back direction of the trenches 19. Along the front-back direction of the trenches 19, the first contact regions 34 and the second contact regions 43 have the same width and form the integral impurity region 44 of band shape of fixed width at the upper surfaces of the mesa portions 24 (the first principal surface 3) and the side surfaces 22 of the mesa portions 24 (the side surfaces 22 of the trenches 19).

Comparing FIG. 6 and FIG. 7, in the width direction of each trench 19, the integral impurity region 44 has a wider width than the first layer 30 of the electric field relaxation layer 12. This is because the second contact regions 43 are connected to side portions of the second layer 31 and a portion of the second layer 31 integrated with the second contact regions 43 is selectively made wider.

Referring to FIG. 9, each second contact region 43 has a second contact thickness CT2. The second contact thickness CT2 may be a thickness of the second contact region 43 in the horizontal direction from the side surface 22 of the trench 19. The second contact thickness CT2 may, for example, be not less than 10 nm and not more than 200 nm and preferably be not less than 20 nm and not more than 100 nm.

Referring to FIG. 9, each first contact region 34 has a first contact thickness CT1. The first contact thickness CT1 may be a thickness of the first contact region 34 in the vertical direction Z from the first principal surface 3. In this embodiment, the first contact thickness CT1 is greater than the second contact thickness CT2. The first contact thickness CT1 may, for example, be not less than 0.1 µm and not more than 1.0 µm and preferably be not less than 0.2 µm and not more than 0.5 µm.

Referring to FIG. 8 and FIG. 9, in this embodiment, a ratio of thicknesses of the first layer 30 and the second layer 31 of each electric field relaxation layer 12 differs between the first relaxation portion 46 (FIG. 6) formed directly below the source region 32 and the second relaxation portion 47 (FIG. 7) formed directly below the first contact region 34.

More specifically, it shall be premised that the first layer 30 has a first relaxation thickness RT1A (RT1B) and the second layer 31 has a second relaxation thickness RT2A (RT2B). In this case, a thickness ratio (RT2A/RT1A) of the second relaxation thickness RT2A with respect to the first relaxation thickness RT1A in the first relaxation portion 46 shown in FIG. 8 is less than a thickness ratio (RT2B/RT1B) in the second relaxation portion 47 shown in FIG. 9. As a matter of course, the thickness ratio (RT2A/RT1A) may be the same as the thickness ratio (RT2B/RT1B).

For example, when a total thickness RT0 (RT1A+RT2A or RT1B+RT2B) defined by the relaxation depth DR of the electric field relaxation layer 12 is the same in the first relaxation portion 46 and the second relaxation portion 47, the first relaxation thickness RT1A in the first relaxation portion 46 is greater than the first relaxation thickness RT1B in the second relaxation portion 47. Oppositely, the second relaxation thickness RT2A in the first relaxation portion 46 is less than the second relaxation thickness RT2B in the second relaxation portion 47. However, when the thickness ratio (RT2A/RT1A) is the same as the thickness ratio (RT2B/RT1B), the first relaxation thickness RT1A may be equal to the first relaxation thickness RT1B and the second relaxation thickness RT2A may be equal to the second relaxation thickness RT2B.

In this embodiment, the first relaxation thickness RT1A may be not less than 0.2 µm and not more than 1.0 µm and the second relaxation thickness RT2A may be not less than 0.2 µm and not more than 1.0 µm. The first relaxation thickness RT1A is preferably not less than 0.4 µm and not more than 0.8 µm and the second relaxation thickness RT2A is preferably not less than 0.4 µm and not more than 0.8 µm.

The first relaxation thickness RT1B may be not less than 0.1 µm and not more than 0.6 µm and the second relaxation thickness RT2B may be not less than 0.1 µm and not more than 0.6 µm. The first relaxation thickness RT1B is preferably not less than 0.2 µm and not more than 0.5 µm and the second relaxation thickness RT2B is preferably not less than 0.2 µm and not more than 0.5 µm.

Referring to FIG. 6 and FIG. 7, a first boundary surface 48 between the first layer 30 and the second layer 31 in each first relaxation portion 46 is positioned further to the first principal surface 3 side than a second boundary surface 49 between the first layer 30 and the second layer 31 in each second relaxation portion 47. Oppositely, the second boundary surface 49 is positioned further to the second principal surface 4 side than the first boundary surface 48.

Referring to FIG. 5 to FIG. 7, the drift region 8 includes a laminated structure of a base region 50 and a high concentration region 51.

The base region 50 is formed further separated to the second principal surface 4 side from the body region 18 than the electric field relaxation layers 12. At a position separated to the second principal surface 4 side from the body region 18 and the trenches 19, the base region 50 is formed as a layer extending along the first principal surface 3. The base region 50 may be formed in an entire region of a surface layer portion at the second principal surface 4 side of the semiconductor layer 7 and be exposed from the first to fourth side surfaces 5A to 5D. The base region 50 forms a boundary surface with the base layer 6 in the semiconductor layer 7.

Referring to FIG. 8 and FIG. 9, the base region 50 has a base thickness BT. The base thickness BT may be not less than 0.5 µm and not more than 20 µm. The base thickness BT is preferably not less than 1 µm and not more than 10 µm.

An n-type impurity concentration of the base region 50 is preferably less than the n-type impurity concentration of the base layer 6. The base region 50 may have an n-type impurity concentration of not less than 1×10¹⁵ cm⁻³ and not more than 5×10¹⁶ cm⁻³ as a peak value. The n-type impurity concentration of the base region 50 may be substantially fixed in a thickness direction. As a matter of course, the n-type impurity concentration of the base region 50 may have a concentration gradient that increases gradually and/or decreases gradually toward the thickness direction (a crystal growth direction) of the chip 2.

Referring to FIG. 5 to FIG. 7, in regard to a relationship between the electric field relaxation layers 12 and the base region 50, the first layer 30 of each electric field relaxation layer 12 is formed to depth reaching the base region 50 in the thickness direction of the chip 2. More specifically, a bottom portion of the first layer 30 of the electric field relaxation layer 12 contacts the base region 50 and forms a boundary portion with the base region 50.

The high concentration region 51 is formed at sides of the trenches 19 and the electric field relaxation layers 12 between the base region 50 and the body region 18. In this embodiment, the high concentration region 51 further includes a laminated structure of a first high concentration region 52 and a second high concentration region 53.

The first high concentration region 52 forms an upper layer of the laminated structure of the high concentration region 51. The first high concentration region 52 is formed as a layer that contacts the body region 18 and extends along the first principal surface 3. The first high concentration region 52 may be formed in an entire region of a surface layer portion at the first principal surface 3 side of the drift region 8 and be exposed from the first to fourth side surfaces 5A to 5D. In this embodiment, the first high concentration region 52 forms a boundary surface with the body region 18 in the drift region 8.

An n-type impurity concentration of the first high concentration region 52 is preferably higher than the n-type impurity concentration of the base region 50. The first high concentration region 52 may have an n-type impurity concentration of not less than 1×10¹⁸ cm⁻³ and not more than 1×10¹⁹ cm⁻³ as a peak value. The n-type impurity concentration of the first high concentration region 52 may be substantially fixed in a thickness direction. As a matter of course, the n-type impurity concentration of the first high concentration region 52 may have a concentration gradient that increases gradually and/or decreases gradually toward the thickness direction (the crystal growth direction) of the chip 2.

The first high concentration region 52 is formed to a depth shallower than the bottom portions of the trenches 19 from the body region 18 in the thickness direction of the chip 2.

The second high concentration region 53 forms a lower layer of the laminated structure of the high concentration region 51. The second high concentration region 53 is formed to the second principal surface 4 side with respect to the first high concentration region 52. In the thickness direction of the chip 2, the second high concentration region 53 is sandwiched by the first high concentration region 52 and the base region 50. The second high concentration region 53 may be formed as a layer extending along the first principal surface 3 and be exposed from the first to fourth side surfaces 5A to 5D. In this embodiment, the second high concentration region 53 contacts side portions of the first layers 30 and the second layers 31 of the electric field relaxation layers 12 across an entirety from the first principal surface 3 side to the second principal surface 4 side in the thickness direction of the chip 2. Also, the second high concentration region 53 covers boundary portions 54 between the bottom portions of the trenches 19 and the electric field relaxation layers 12 (see FIG. 6).

An n-type impurity concentration of the second high concentration region 53 is preferably lower than the n-type impurity concentration of the first high concentration region 52. The first high concentration region 52 may have an n-type impurity concentration of not less than 1×10¹⁶ cm⁻³ and not more than 1×10¹⁸ cm⁻³ as a peak value. The n-type impurity concentration of the second high concentration region 53 may be substantially fixed in a thickness direction. As a matter of course, the n-type impurity concentration of the second high concentration region 53 may have a concentration gradient that increases gradually and/or decreases gradually toward the thickness direction (the crystal growth direction) of the chip 2.

Referring to FIG. 8 and FIG. 9, in regard to thicknesses of the first high concentration region 52 and the second high concentration region 53, a first thickness HT1 of the first high concentration region 52 is greater than a second thickness HT2 of the second high concentration region 53. For example, the first thickness HT1 of the first high concentration region 52 may be not less than 0.1 µm and not more than 0.5 µm and the second thickness HT2 of the second high concentration region 53 may be not less than 0.5 µm and not more than 2.0 µm. The first thickness HT1 is preferably not less than 0.15 µm and not more than 0.4 µm and the second thickness HT2 is preferably not less than 0.8 µm and not more than 1.5 µm.

In this embodiment, the n-type impurity concentrations of the base region 50, the first high concentration region 52 and the second high concentration region 53 are adjusted by nitrogen. The base region 50, the first high concentration region 52 and the second high concentration region 53 may have n-type impurity concentrations adjusted by at least one type of pentavalent element. For example, the n-type impurity concentrations of the base region 50, the first high concentration region 52 and the second high concentration region 53 may be adjusted by at least one type among nitrogen, phosphorus, arsenic, antimony, and bismuth.

The semiconductor device 1 includes interlayer insulating layers 55 that are embedded in the recesses 27 of the semiconductor layer 7. The interlayer insulating layers 55 may be referred to as "insulating films," "interlayer films," "intermediate insulating films," etc. In this embodiment, the interlayer insulating layers 55 may include at least one among silicon oxide films, silicon nitride films, and silicon oxynitride films.

Referring to FIG. 6 and FIG. 7, each interlayer insulating layer 55 is embedded in the recess 27 such that upper edges 56 of the trench 19 are exposed from the first principal surface 3. The upper edges 56 of the trench 19 may be portions at which the side surfaces 22 of the trench 19 and the first principal surface 3 intersect at a top portion of the trench 19. That is, the interlayer insulating layer 55 does not cover a peripheral portion of the trench 19 in the first principal surface 3 and fits in an inner region of the trench 19 in the width direction of the trench 19. In this embodiment, an upper surface 57 of the interlayer insulating layer 55 is positioned further to the bottom portion side of the trench 19 than the first principal surface 3 in the depth direction of the trench 19.

Referring to FIG. 5, the interlayer insulating layer 55 is embedded in the recess 27 across the entire front-back direction of the trench 19 and is formed in a band shape extending in the front-back direction of the trench 19. Referring to FIG. 6 and FIG. 7, the interlayer insulating layer 55 contacts the source regions 32 and the first contact regions 34 at the side surfaces 22 of the recesses 27 (the side surfaces 22 of the trenches 19).

Referring to FIG. 6 and FIG. 7, the semiconductor device 1 includes silicide layers 58 formed on respective front surfaces of the source regions 32 and the first contact regions 34. By the forming of the silicide layers 58, contact resistance with respect to the source regions 32 and the first contact regions 34 can be reduced.

In this embodiment, the silicide layers 58 are selectively formed on the projection portions 28 of the respective mesa portions 24. More specifically, these are formed along upper surfaces (the first principal surface 3) and the side surfaces 22 (the side surfaces 22 of the recesses 27) of the projection portions 28 of the mesa portions 24. At an inner portion of the projection portion 28 of each mesa portion 24 that is separated inward from the upper surface (the first principal surface 3) and the side surfaces 22 of the mesa portion 24, a non-silicide portion 59 demarcated (surrounded at three sides) by the silicide layer 58 may be formed.

The silicide layers 58 may, for example, be of nickel silicide, titanium silicide, aluminum silicide, copper silicide, etc. Also, a thickness ST2 of each silicide layer 58 may, for example, be not less than 50 nm and not more than 500 nm in the vertical direction Z from the upper surface (the first principal surface 3) and the side surfaces 22 of the projection portion 28 of the mesa portion 24. The thickness ST2 of the silicide layer 58 is preferably not less than 80 nm and not more than 300 nm.

Referring to FIG. 6 and FIG. 7, the semiconductor device 1 includes a first principal surface electrode 60. The first principal surface electrode 60 is formed on the first principal surface 3 such as to cover the interlayer insulating layers 55. The first principal surface electrode 60 has a laminated structure including a barrier layer 61 and a main body layer 62 that are laminated in that order from the first principal surface 3 side.

The barrier layer 61 is formed as a film along the first principal surface 3 and inner surfaces of the recesses 27 (the side surfaces 22 of the recesses 27 and the upper surfaces 57 of the interlayer insulating layers 55). The barrier layer 61 is in ohmic contact with the silicide layers 58. The barrier layer 61 further demarcates second recesses 63 inside the recesses 27.

The barrier layer 61 may include at least one among a Ti layer, a Pd layer, a Cr layer, a V layer, an Mo layer, a W layer, a Pt layer, and an Ni layer. A thickness of the barrier layer 61 may be not less than 0.05 µm and not more than 0.3 µm. The thickness of the barrier layer 61 is preferably not less than 0.1 µm and not more than 0.2 µm.

The main body layer 62 is formed on the barrier layer 61. The main body layer 62 covers an entire region of a principal surface of the barrier layer 61. The main body layer 62 is partially embedded in the second recesses 63. The main body layer 62 is electrically connected to the source regions 32 and the first contact regions 34 via the barrier layer 61 and the silicide layers 58. In this embodiment, the first principal surface electrode 60 is connected to the source regions 32 and the first contact regions 34 at the side surfaces 22 of the recesses 27 and the first principal surface 3. Therefore, in the semiconductor device 1, the first principal surface electrode 60 may include the source pad 15 described above. The electric field relaxation layers 12 are fixed at the source potential via the first contact regions 34 and the second contact regions 43.

The main body layer 62 includes at least one among a pure Al layer (refers to an Al layer constituted of Al of a purity of not less than 99%), an AlSi alloy layer, an AlCu alloy layer, and AlSiCu alloy layer.

A thickness of the main body layer 62 exceeds the thickness of the barrier layer 61. The thickness of the main body layer 62 may be not less than 1 µm and not more than 10 µm. The thickness of the main body layer 62 is preferably not less than 3 µm and not more than 6 µm.

The semiconductor device 1 includes a resin layer 64 that covers the first principal surface electrode 60. The resin layer 64 is formed as a film along a principal surface of the first principal surface electrode 60. The resin layer 64 may contain a photosensitive resin. The photosensitive resin may be of a negative type or a positive type. The resin layer 64 may contain at least one among a polyimide, a polyamide, and a polybenzoxazole. In this embodiment, the resin layer 64 contains a polybenzoxazole. Here, a passivation film (not shown) constituted of an insulating film, for example, of silicon nitride, etc., may be interposed between the resin layer 64 and the first principal surface electrode 60.

### [Method for Manufacturing the Semiconductor Device 1]

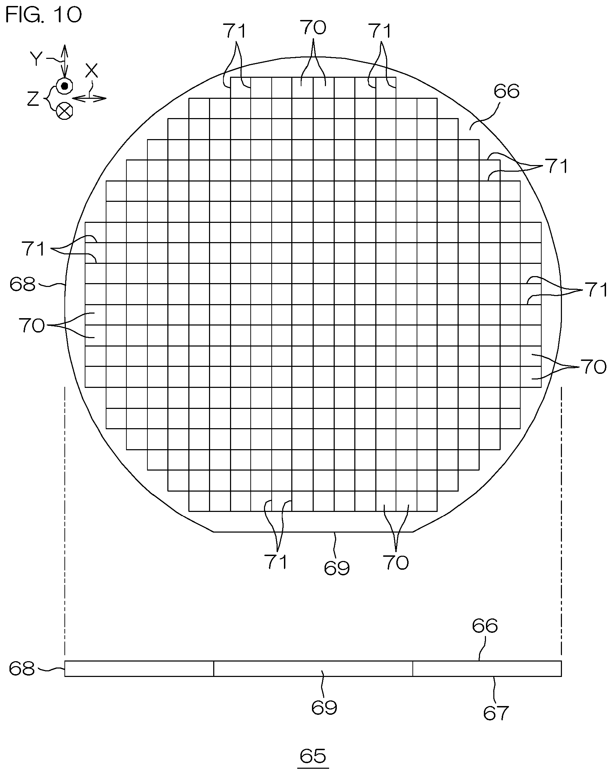

FIG. 10 is a schematic view showing a wafer 65 used in manufacture of the semiconductor device 1. The wafer 65 is a base material of the base layer 6 and includes the SiC monocrystal. The wafer 65 is formed in a flat disc shape. As a matter of course, the wafer 65 may be formed in a flat rectangular parallelepiped shape instead. The wafer 65 has a first wafer principal surface 66 at one side, a second wafer principal surface 67 at another side, and a wafer side surface 68 that connects the first wafer principal surface 66 and the second wafer principal surface 67.

The first wafer principal surface 66 corresponds to the upper end of the base layer 6 and the second wafer principal surface 67 corresponds to a lower end of the base layer 6. The first wafer principal surface 66 and the second wafer principal surface 67 are formed by c-planes of the SiC monocrystal. The first wafer principal surface 66 is formed by a silicon plane of the SiC monocrystal and the second wafer principal surface 67 is formed by a carbon plane of the SiC monocrystal. The wafer 65 (the first wafer principal surface 66 and the second wafer principal surface 67) has the off direction Do and the off angle θo described above.

The wafer 65 has, on the wafer side surface 68, a mark 69 that indicates a crystal orientation of the SiC monocrystal. The mark 69 may include either or both of an orientation flat and an orientation notch. The orientation flat is constituted of a notched portion that is notched rectilinearly in plan view. The orientation notch is constituted of a notched portion that is notched in a recessed shape (for example, a tapered shape) toward a central portion of the first wafer principal surface 66 in plan view.

The mark 69 may include either or both of a first orientation flat that extends in the m-axis direction and a second orientation flat that extends in the a-axis direction. The mark 69 may include either or both of an orientation notch that is recessed in the m-axis direction and an orientation notch that is recessed in the a-axis direction. In FIG. 10, the orientation flat that extends in the m-axis direction (the first direction X) in plan view is shown.

For example, a plurality of device regions 70 and a plurality of intended cutting lines 71 are set by alignment marks, etc., in the wafer 65. Each device region 70 is a region corresponding to the semiconductor device 1. The plurality of device regions 70 are each set in a quadrangle shape in plan view.

In this embodiment, the plurality of device regions 70 are set in a matrix along the first direction X and the second direction Y in plan view. The plurality of device regions 70 are each set at intervals inward from a peripheral edge of the first wafer principal surface 66 in plan view. The plurality of intended cutting lines 71 are set in a lattice extending along the first direction X and the second direction Y such as to demarcate the plurality of device regions 70.

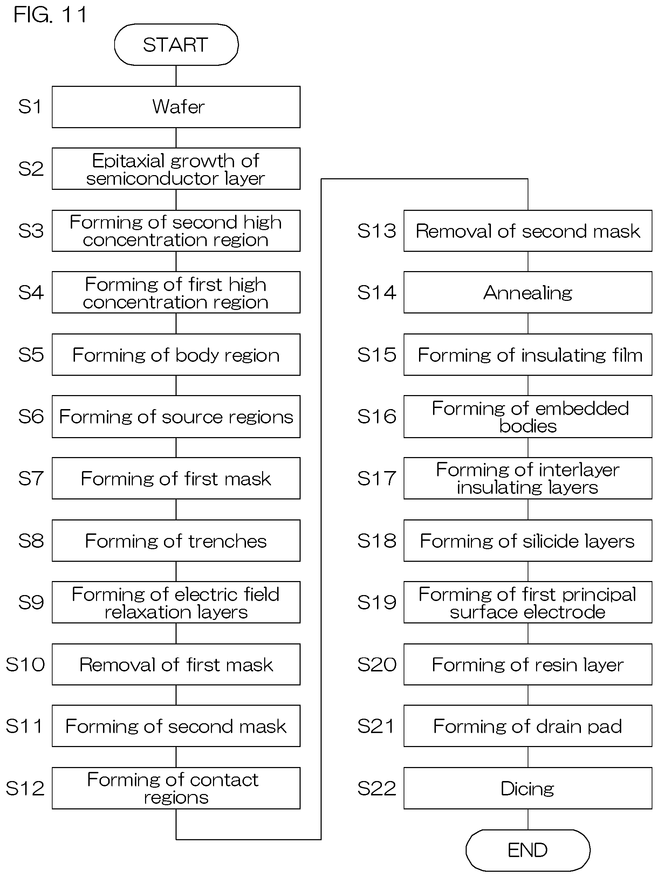

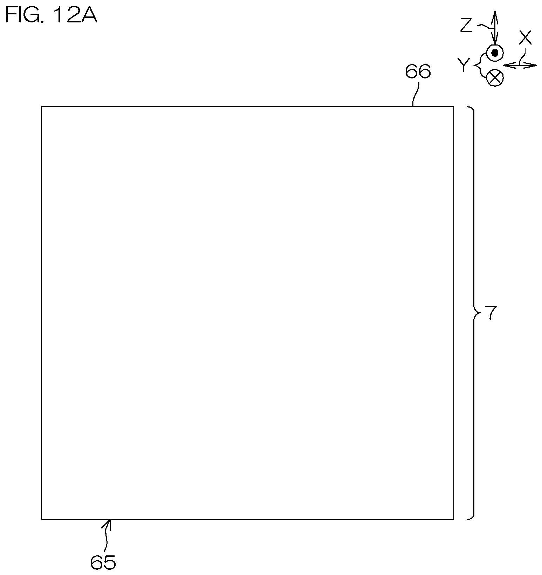

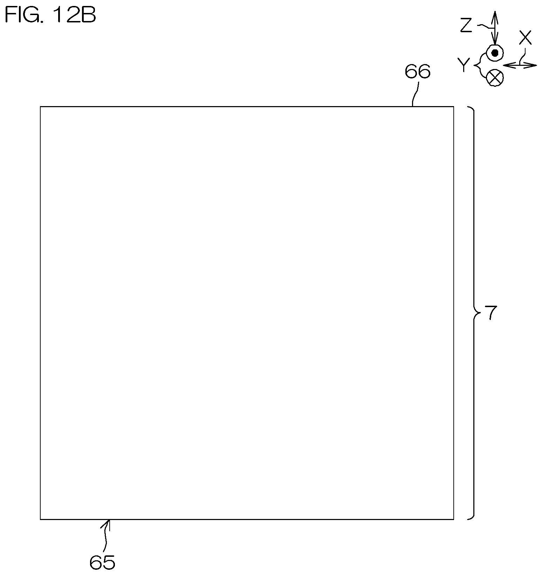

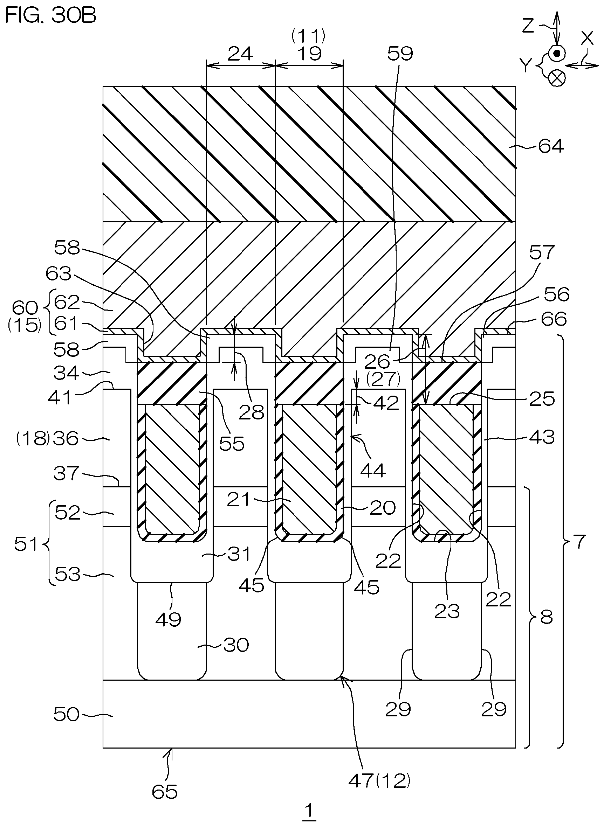

FIG. 11 is a flowchart showing a manufacturing method example of the semiconductor device 1. FIG. 12A and FIG. 12B to FIG. 30A and FIG. 30B are cross-sectional views showing the manufacturing method example of the semiconductor device 1. Among FIG. 12A and FIG. 12B to FIG. 30A and FIG. 30B, the diagrams with "A" indicated are diagrams corresponding to FIG. 6 and the diagrams with "B" indicated are diagrams corresponding to FIG. 7.

First, referring to FIG. 12A and FIG. 12B, a preparation step of the wafer 65 described above is performed (step S1 of FIG. 11). Next, a forming step of the semiconductor layer 7 is performed (step S2 of FIG. 11). The semiconductor layer 7 is formed by an epitaxial growth method with the first wafer principal surface 66 (the wafer 65) as a starting point.

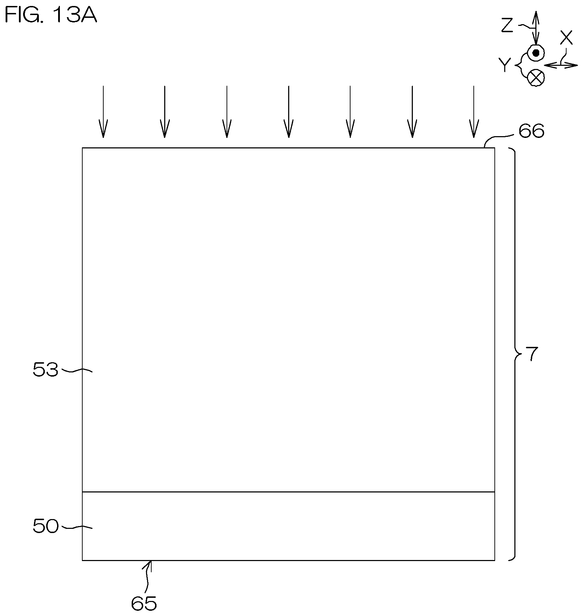

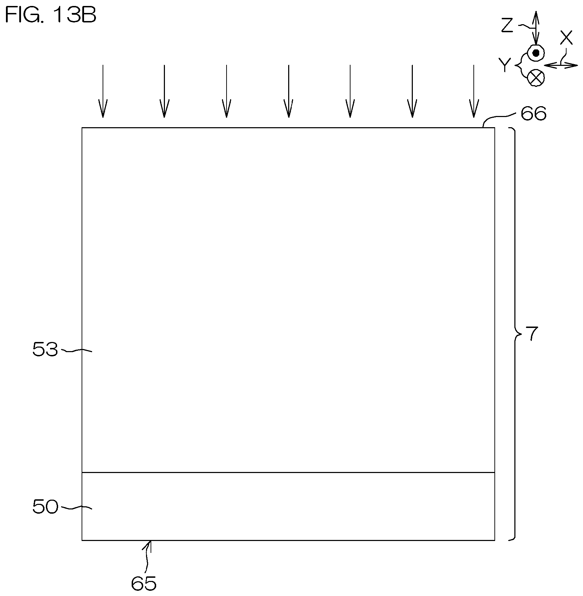

Next, referring to FIG. 13A and FIG. 13B, a forming step of the second high concentration region 53 is performed (step S3 of FIG. 11). In the forming step of the second high concentration region 53, the n-type impurity is introduced into an entire region of the semiconductor layer 7. Thereby, the second high concentration region 53 is formed in an entire region of a surface layer portion of the semiconductor layer 7. At the same time, the base region 50 separated from the second high concentration region 53 is formed.

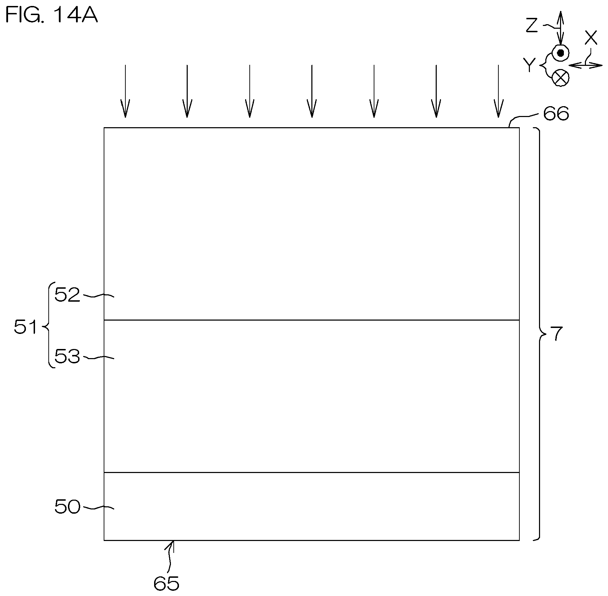

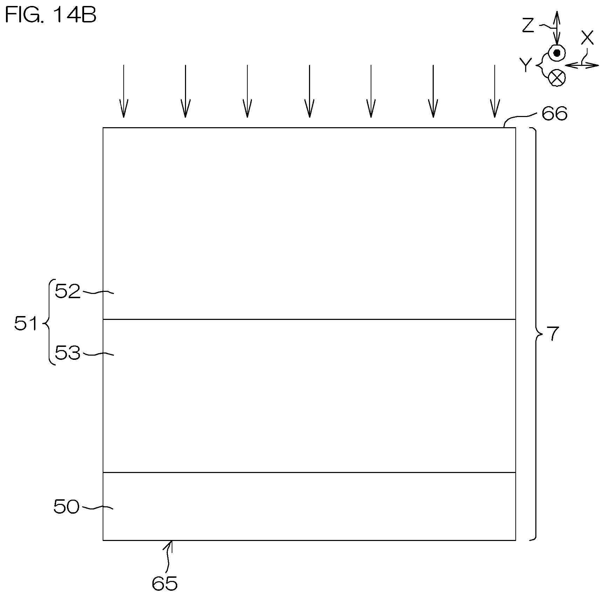

Next, referring to FIG. 14A and FIG. 14B, a forming step of the first high concentration region 52 is performed (step S4 of FIG. 11). In the forming step of the first high concentration region 52, the n-type impurity is introduced into the entire region of the semiconductor layer 7. Thereby, the first high concentration region 52 is formed in an entire region of a surface layer portion of the second high concentration region 53.

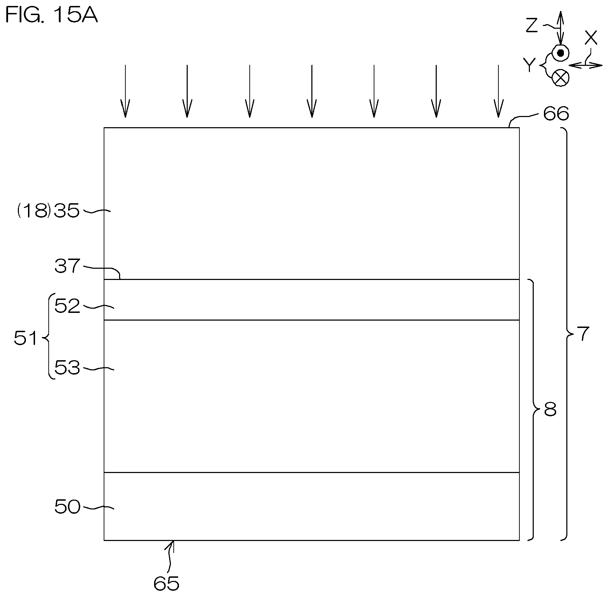

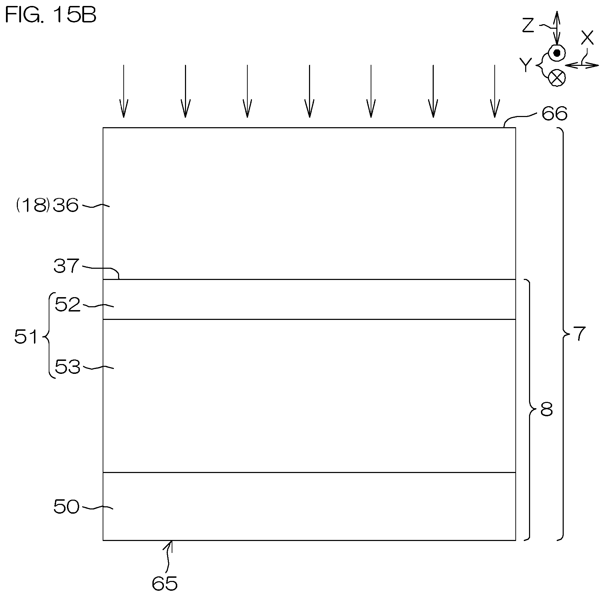

Next, referring to FIG. 15A and FIG. 15B, a forming step of the body region 18 is performed (step S5 of FIG. 11). In the forming step of the body region 18, the p-type impurity is introduced into the entire region of the semiconductor layer 7. Thereby, the body region 18 is formed in an entire region of a surface layer portion of the first high concentration region 52.

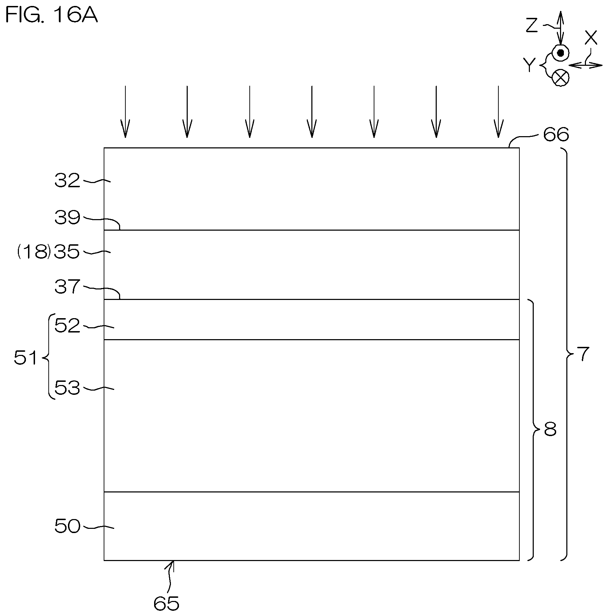

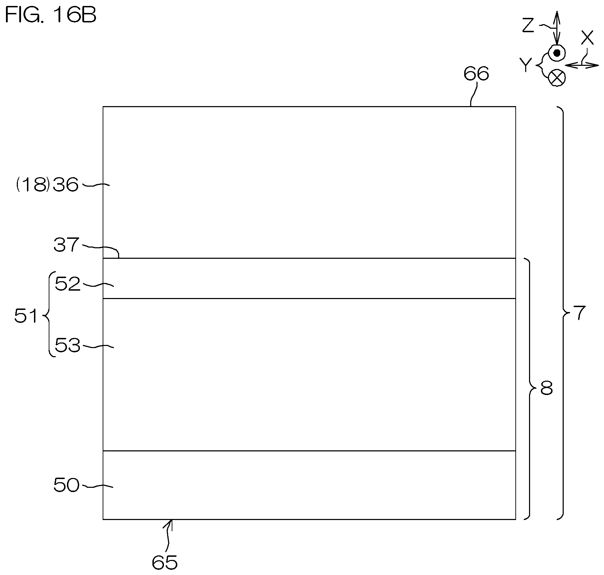

Next, referring to FIG. 16A and FIG. 16B, a forming step of the source regions 32 is performed (step S6 of FIG. 11). In the forming step of the source regions 32, the n-type impurity is selectively introduced into the semiconductor layer 7 (the surface layer portion of the body region 18). Thereby, the source regions 32 are formed in the surface layer portion of the body region 18. In this process, regions in which the first contact regions 34 are to be formed are selectively covered by a mask (not shown) and the introduction of the n-type impurity is prevented.

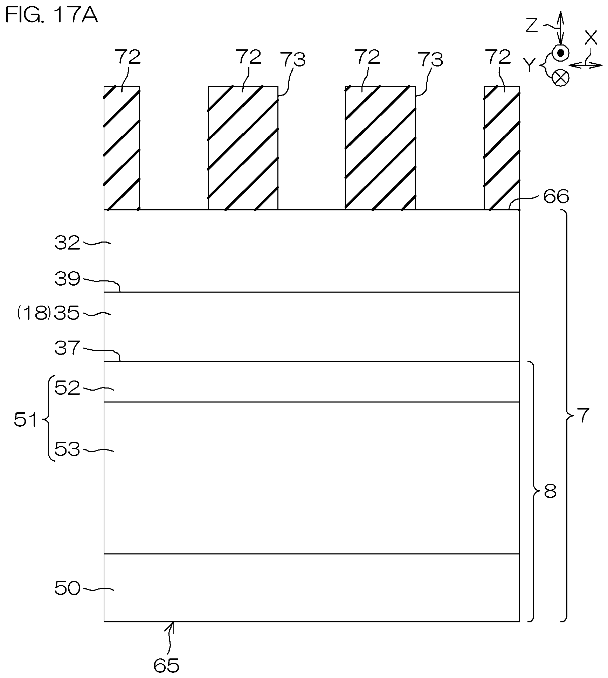

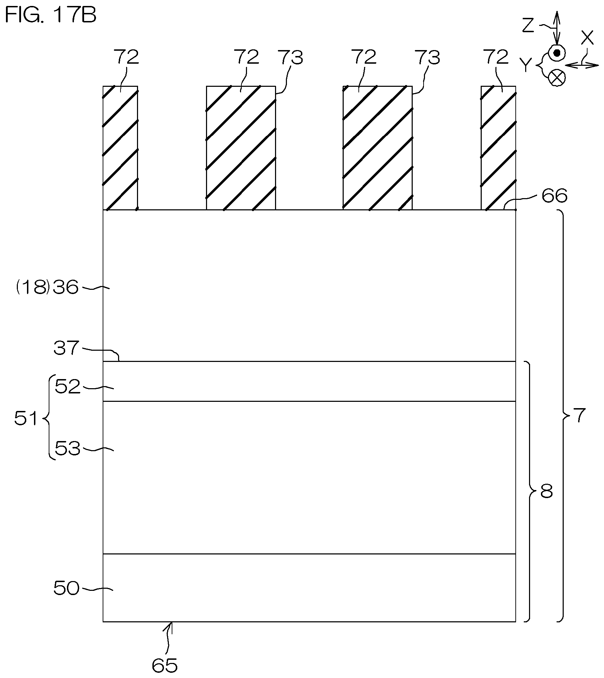

Next, a forming step of the plurality of trenches 19 is performed. First, referring to FIG. 17A and FIG. 17B, a first mask 72 having a predetermined pattern is formed (step S7 of FIG. 11). The first mask 72 is preferably an inorganic mask (a hard mask). The first mask 72 has a plurality of first openings 73 that expose regions in which the plurality of trenches 19 are to be formed.

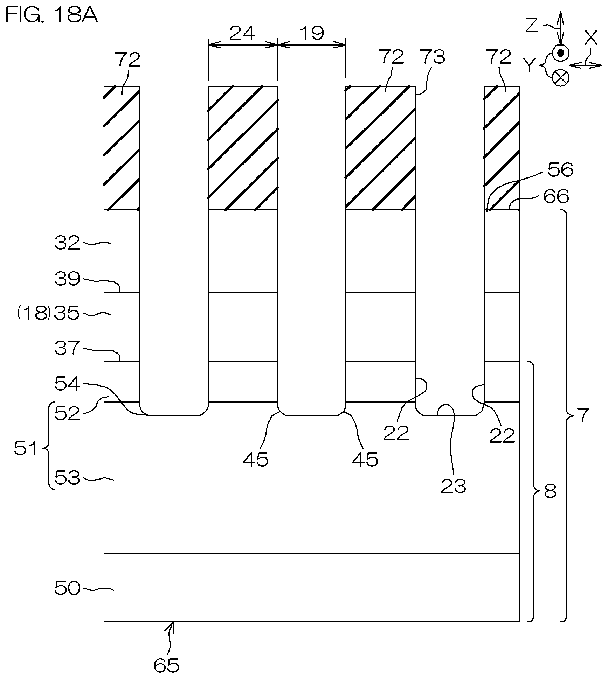

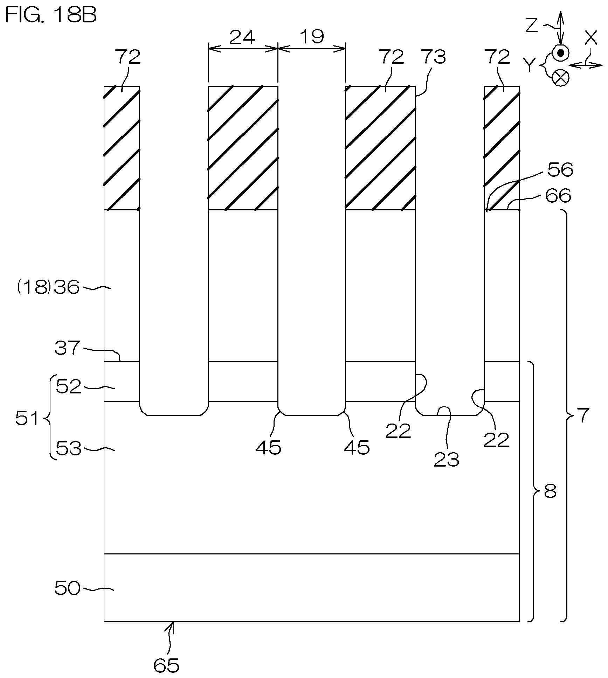

Next, referring to FIG. 18A and FIG. 18B, unnecessary portions of the semiconductor layer 7 are removed by an etching method via the first mask 72. The etching method may be either or both of a wet etching method and a dry etching method. The etching method is preferably an RIE (reactive ion etching) method. The plurality of trenches 19 are thereby formed in the upper end of the semiconductor layer 7 (step S8 of FIG. 11). At the same time, the mesa portions 24 are formed between adjacent trenches 19.

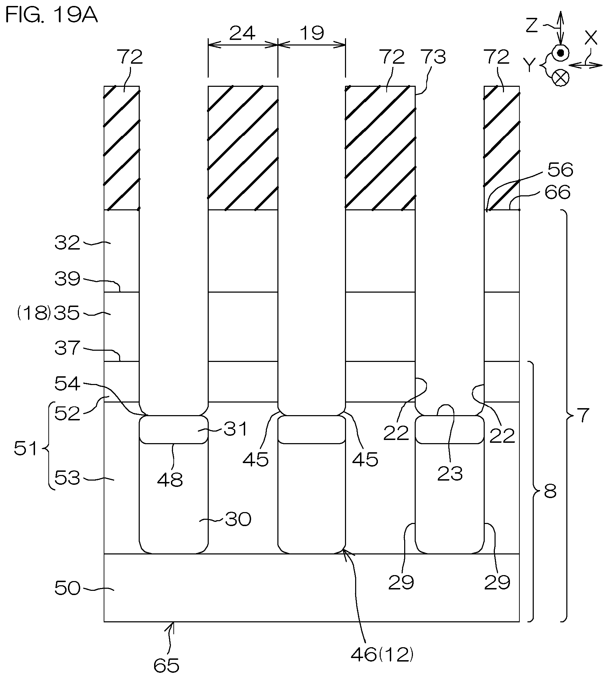

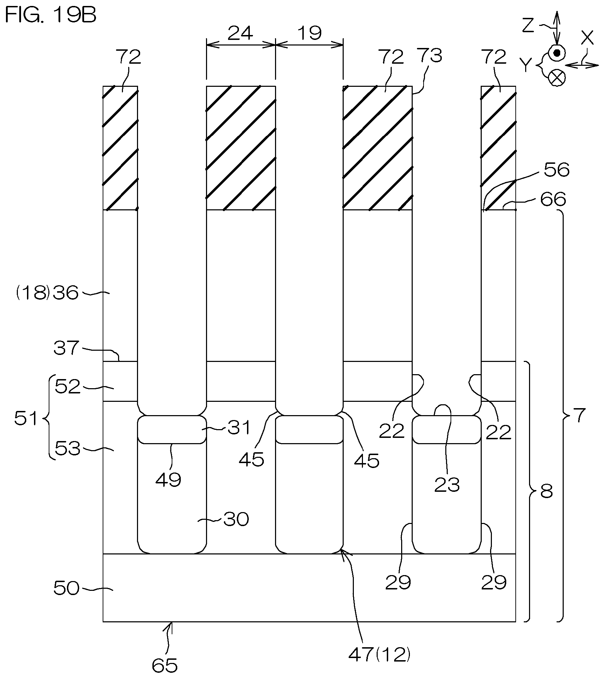

Next, referring to FIG. 19A and FIG. 19B, a forming step of the plurality of electric field relaxation layers 12 is performed while leaving the first mask 72 on the semiconductor layer 7 (step S9 of FIG. 11). In the forming step of the electric field relaxation layers 12, the p-type impurity is selectively introduced into the semiconductor layer 7 via the first mask 72. The electric field relaxation layers 12 are thereby formed at the bottom portions of the respective trenches 19.

More specifically, a first step in which the p-type impurity is introduced at a relatively high first energy and a relatively low first dosage and a second step in which the p-type impurity is introduced at a second energy lower than the first energy and a second dosage higher than the first dosage are performed. First, by the first step being performed, the first layers 30 are formed at the bottom portions of the trenches 19. Next, by the second step being performed, the second layers 31 are formed in surface layer portions of the first layers 30. Also, at this point the second relaxation thickness RT2A (see FIG. 8) of the second layers 31 of the first relaxation portions 46 and the second relaxation thickness RT2B (see FIG. 9) of the second layers 31 of the second relaxation portions 47 are the same.

As a forming method of the electric field relaxation layers 12, various ion implantation methods can be applied. For example, the electric field relaxation layers 12 may be formed by a channeling implantation method. A channeling implantation step is performed based on data (information) on the off angle θo. With the in-channeling implantation step, the electric field relaxation layers 12 can easily be formed selectively at deep positions of the semiconductor layer 7. In a case where the electric field relaxation layers 12 are formed by a channeling ion implantation method, the electric field relaxation layers 12 may be formed before the body region 18. Thereafter, the first mask 72 is removed.

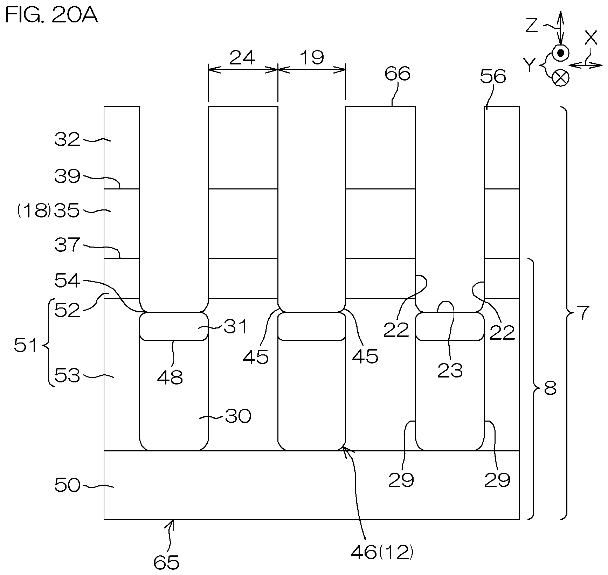

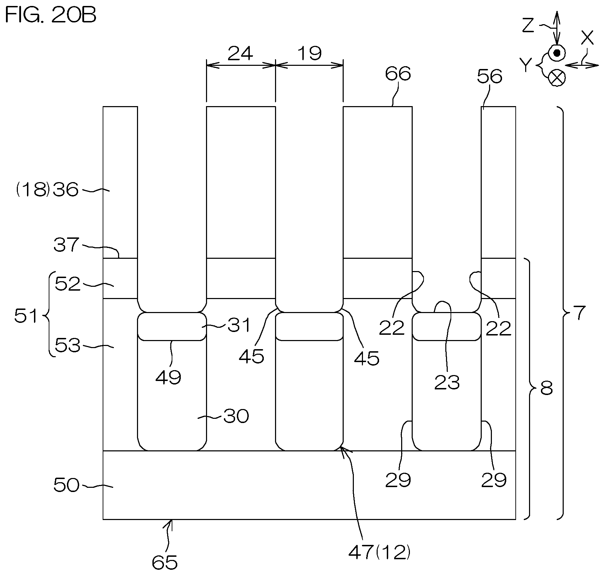

Next, referring to FIG. 20A and FIG. 20B, the first mask 72 is removed (step S10 of FIG. 11).

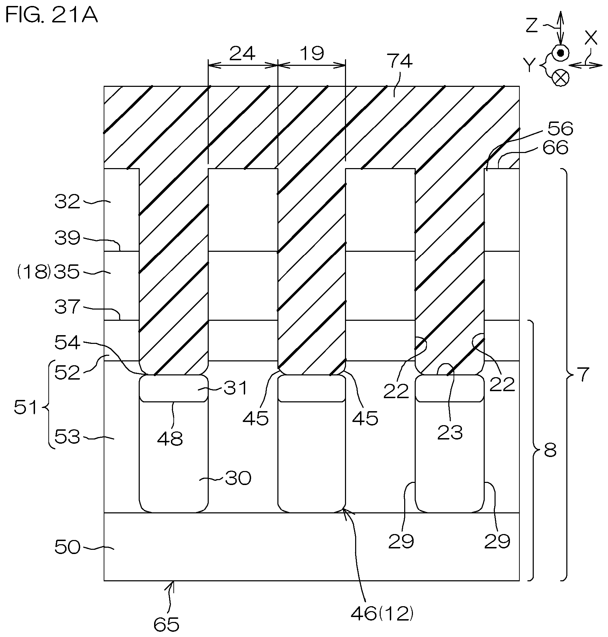

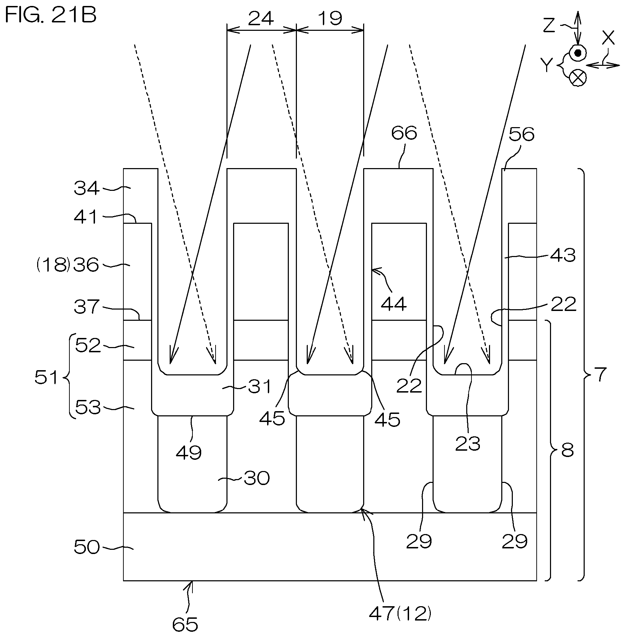

Next, referring to FIG. 21A and FIG. 21B, the first contact regions 34 and the second contact regions 43 are formed. In this step, first, a second mask 74 having a predetermined pattern is formed (step S11 of FIG. 11). The second mask 74 is preferably a photoresist. The second mask 74 has a plurality of second openings 75 that expose regions in which the first contact regions 34 and the second contact regions 43 are to be formed. More specifically, the second mask 74 selectively covers the first body portions 35 of the respective mesa portions 24 and the first relaxation portions 46 and has the second openings 75 that selectively expose the second body portions 36 and the second relaxation portions 47.

Next, the p-type impurity is introduced into the surface layer portion of the semiconductor layer 7 by an ion implantation method via the second mask 74. Thereby, the p-type impurity is introduced into front surfaces of the mesa portions 24 and the inner surfaces of the trenches 19 that are exposed from the second openings 75 and the first contact regions 34 and the second contact regions 43 are formed (step S12 of FIG. 11). In this embodiment, oblique implantation at a predetermined angle with respect to the first wafer principal surface 66 is performed. Ions can thereby also be implanted into the side surfaces 22 of the trenches 19 in addition to the first wafer principal surface 66 and the bottom surfaces 23 of the trenches 19. On the other hand, as described above, the trench structures 11 have the aspect ratio DT/WT (of, for example, not less than 1 and not more than 5) of extending in a vertically long columnar shape and the trench depth DT is far greater than the trench width WT. An implantation angle must thus be made large in order to perform ion implantation uniformly across entireties of the side surfaces 22 of the trenches 19. Consequently, an ion implantation depth from the side surfaces 22 of the trenches 19 becomes shallow and the second contact thickness CT2 becomes smaller than the first contact thickness CT1 (see FIG. 9).

In this process, since the p-type impurity is also introduced into the bottom surfaces 23 of the trenches 19, the second layers 31 of the second relaxation portions 47 are selectively thickened. A difference between the second relaxation thickness RT2A (see FIG. 8) and the second relaxation thickness RT2B (see FIG. 9) thereby arises. At the same time the thickness ratio (RT2A/RT1A) in the first relaxation portions 46 becomes smaller than the thickness ratio (RT2B/RT1B) in the second relaxation portions 47. Here, the second layers 31 of the second relaxation portions 47 do not have to be thickened. For example, when an implantation depth of the p-type impurity for the first contact regions 34 and the second contact regions 43 is shallower than the second layers 31, the second layers 31 of the second relaxation portions 47 are not selectively thickened. The thickness ratio (RT2A/RT1A) is thereby maintained to be the same as the thickness ratio (RT2B/RT1B).

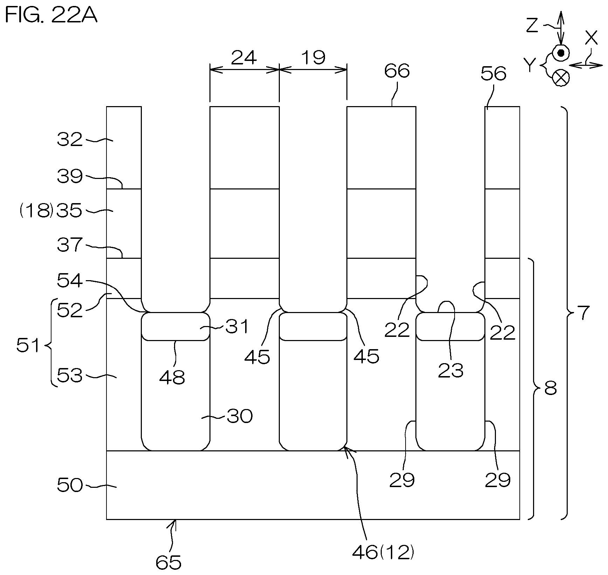

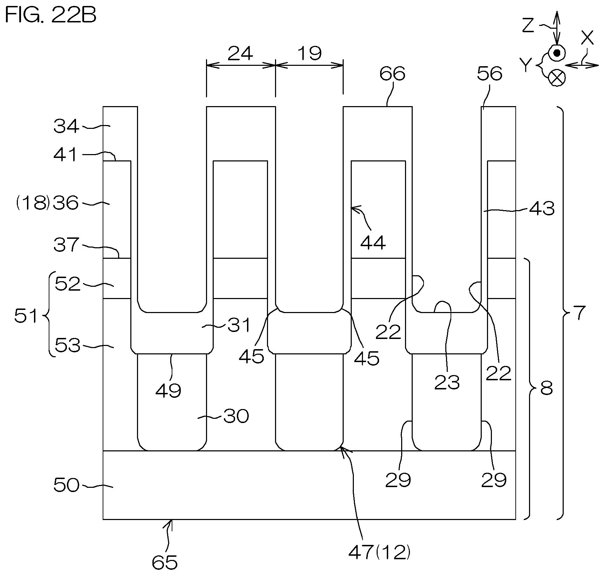

Next, referring to FIG. 22A and FIG. 22B, after the second mask 74 is removed (step S13 of FIG. 11), an annealing that activates the impurity regions is performed (step S14 of FIG. 11).

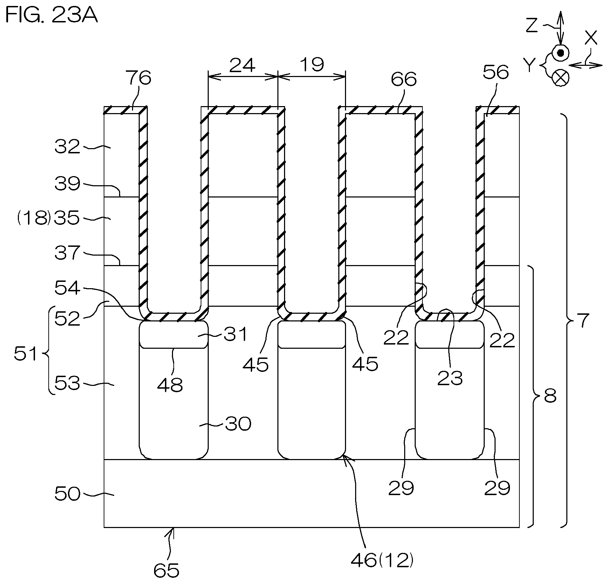

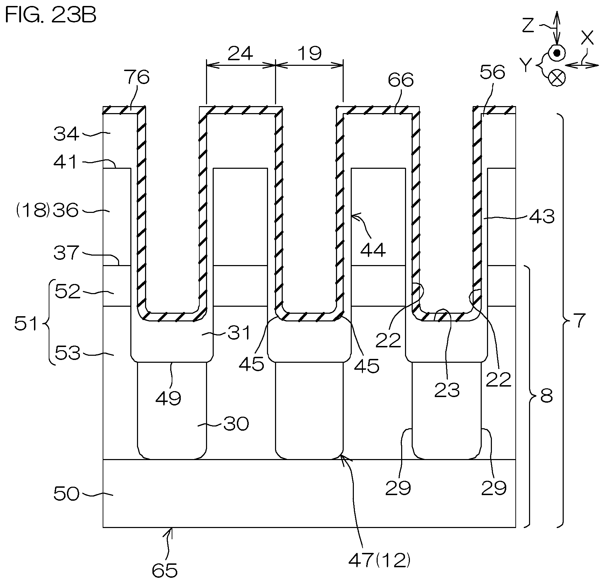

Next, referring to FIG. 23A and FIG. 23B, a forming step of an insulating film 76 is performed (step S15 of FIG. 11). The forming step of the insulating film 76 also serves as a forming step of the trench insulating films 20. The insulating film 76 may be formed by either or both of a CVD (chemical vapor deposition) method and an oxidation treatment method. In this embodiment, the insulating film 76 is formed by the CVD method. The insulating film 76 is formed as a film on the wall surfaces of the plurality of trenches 19 and is also formed on an entire region of the first wafer principal surface 66.

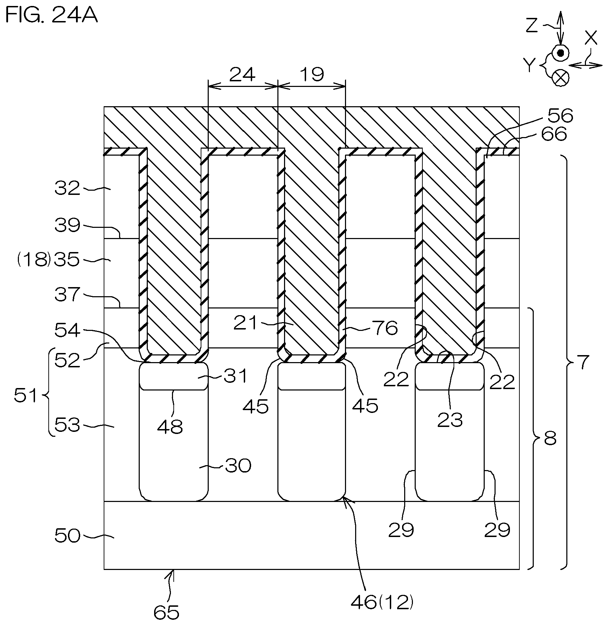

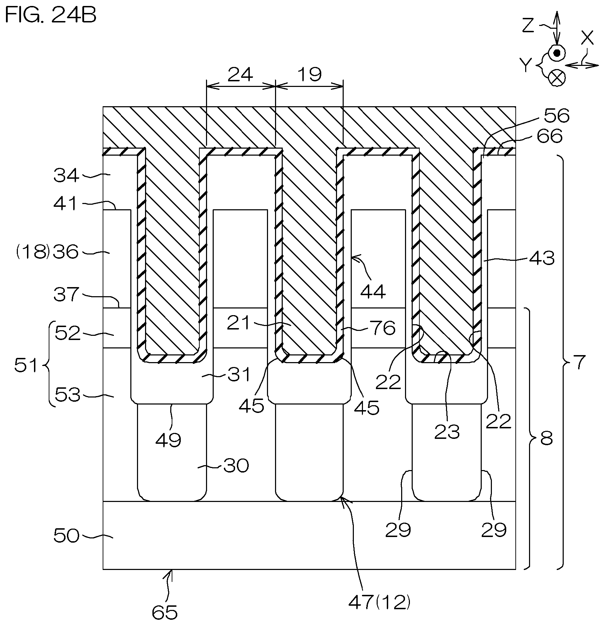

Next, a forming step of the embedded bodies 21 is performed (step S16 of FIG. 11). Referring to FIG. 24A and FIG. 24B, in this step, a step of forming a base electrode film 77 on the insulating film 76 is performed. In this embodiment, the base electrode film 77 contains a conductive polysilicon. The base electrode film 77 backfills the plurality of trenches 19 and covers the first wafer principal surface 66 of the semiconductor layer 7. The base electrode film 77 may be formed by a CVD method.

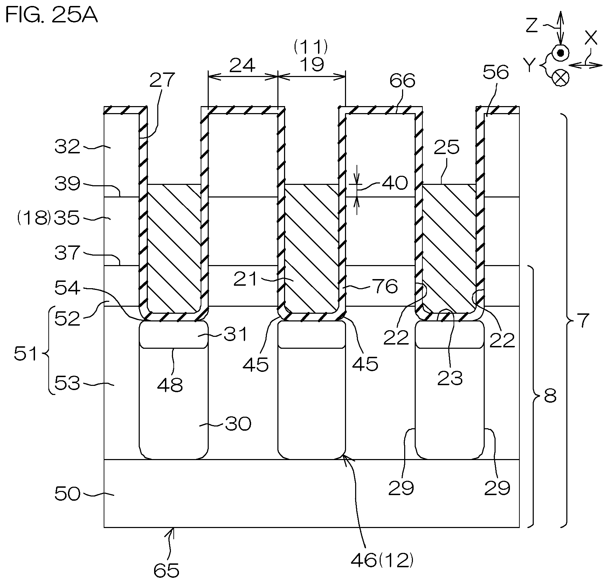

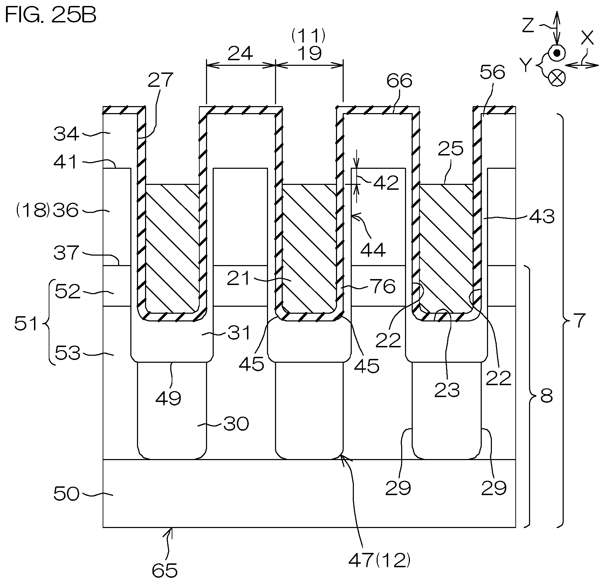

Next, referring to FIG. 25A and FIG. 25B, unnecessary portions of the base electrode film 77 are removed by an etching method. The unnecessary portions of the base electrode film 77 are removed until the insulating film 76 is exposed and the upper surfaces 25 of the base electrode film 77 are positioned intermediately in the depth direction of the trenches 19. The etching method may be either or both of a wet etching method and a dry etching method. Thereby, the plurality of embedded bodies 21 are respectively embedded inside the plurality of trenches 19 and the plurality of trench structures 11 are formed. Also, the recesses 27 are formed inside the respective trenches 19.

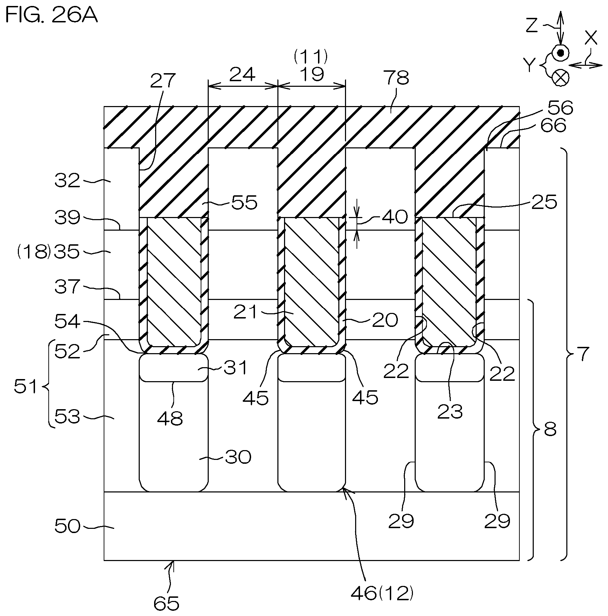

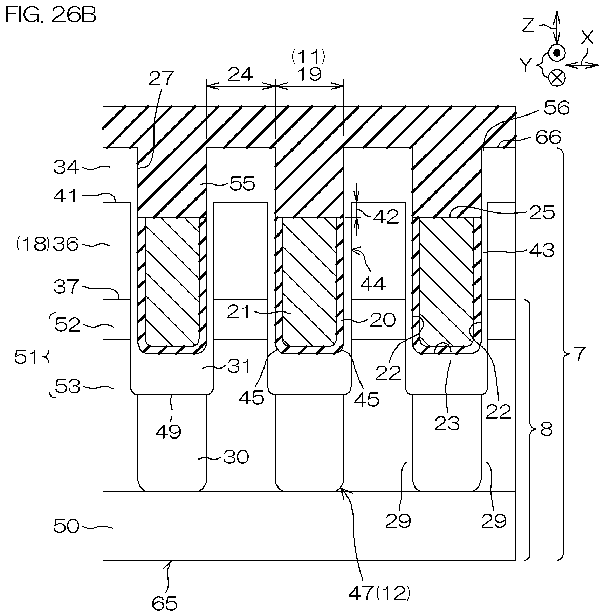

Next, a forming step of the interlayer insulating layers 55 is performed (step S17 of FIG. 11). Referring to FIG. 26A and FIG. 26B, in this step, a step of forming a base insulating film 78 on the first wafer principal surface 66 is performed. In this embodiment, the base insulating film 78 includes at least one among a silicon oxide film, a silicon nitride film, and a silicon oxynitride film. The base insulating film 78 backfills the recesses 27 of the plurality of trenches 19, becomes integral with the insulating film 76, and covers the first wafer principal surface 66 of the semiconductor layer 7. The base insulating film 78 may be formed by a CVD method. Thereby, the insulating film 76 remaining between the embedded bodies 21 and the inner surfaces of the trenches 19 are formed as the trench insulating films 20.

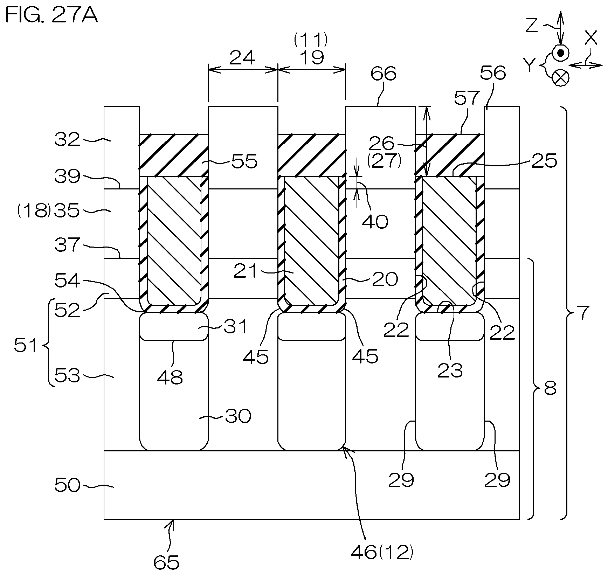

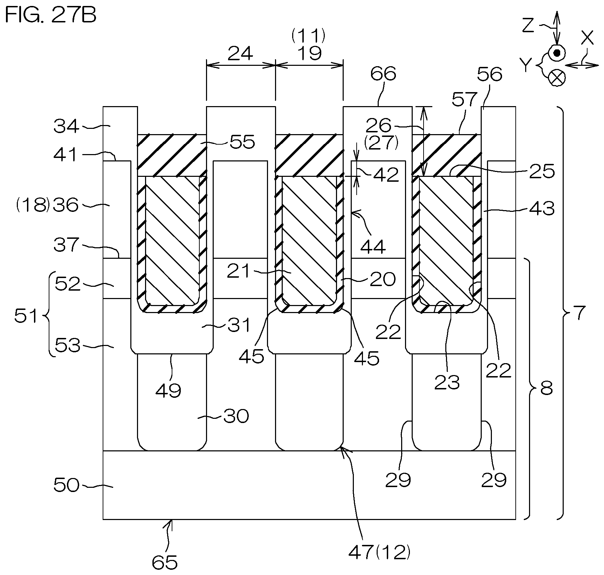

Next, referring to FIG. 27A and FIG. 27B, unnecessary portions of the base insulating film 78 are removed by an etching method. The removal of the unnecessary portions of the base insulating film 78 is continued until the base insulating film 78 outside the trenches 19 is removed and the insulating film 76 on the first wafer principal surface 66 is further removed. Thereby, the first wafer principal surface 66 is exposed and the upper surface 57 of the base insulating film 78 is positioned intermediately in the depth direction of the trenches 19. Also, the side surfaces 22 of the recesses 27 are exposed by the removal of the insulating film 76. The etching method may be either or both of a wet etching method and a dry etching method. Thereby, the plurality of interlayer insulating layers 55 are respectively embedded inside the plurality of trenches 19.

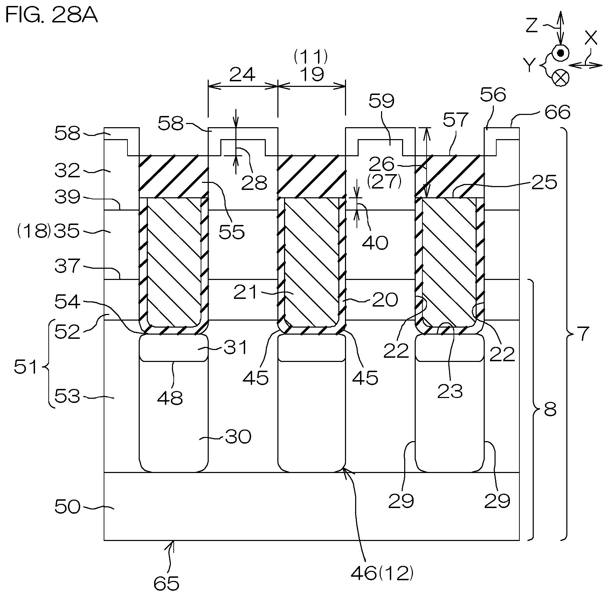

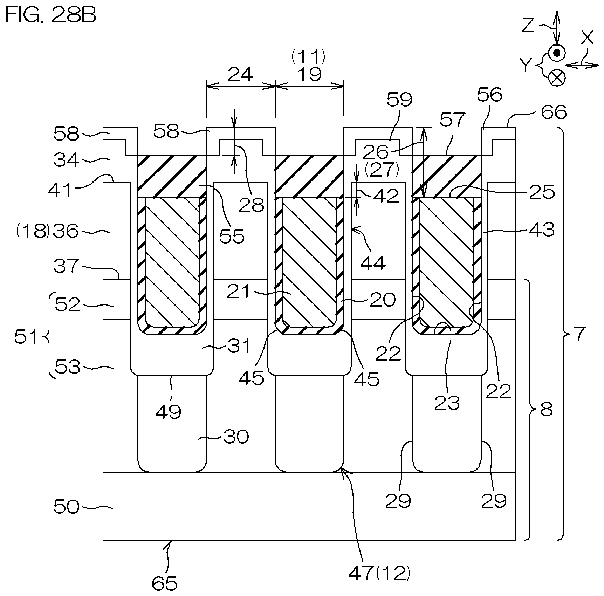

Next, referring to FIG. 28A and FIG. 28B, a forming step of the silicide layers 58 is performed (step S18 of FIG. 11). Specifically, a metal film (for example, a nickel film, a titanium film, etc.) for silicide forming is formed on the first wafer principal surface 66. The metal film is deposited on an entire region of the first wafer principal surface 66, for example, by a sputtering method. Next, by annealing (for example, RTA: rapid thermal annealing), the metal film and the silicon in the semiconductor layer 7 react and the silicide layers 58 (metal silicide) are formed. Thereafter, the metal film is peeled off.

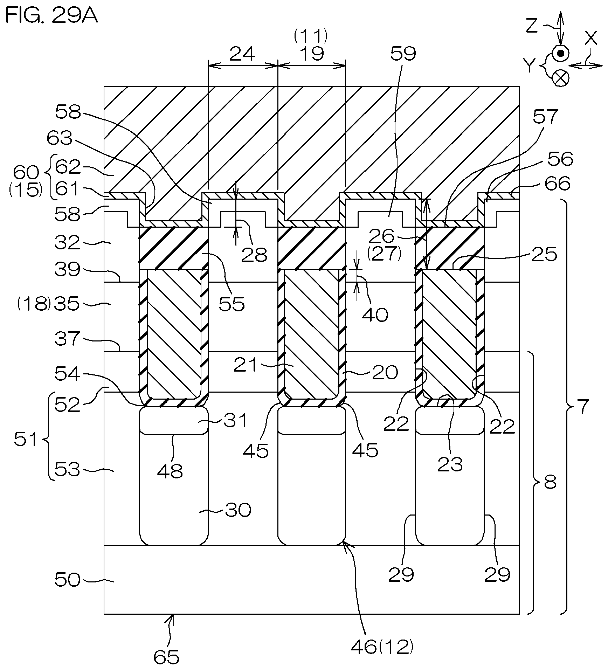

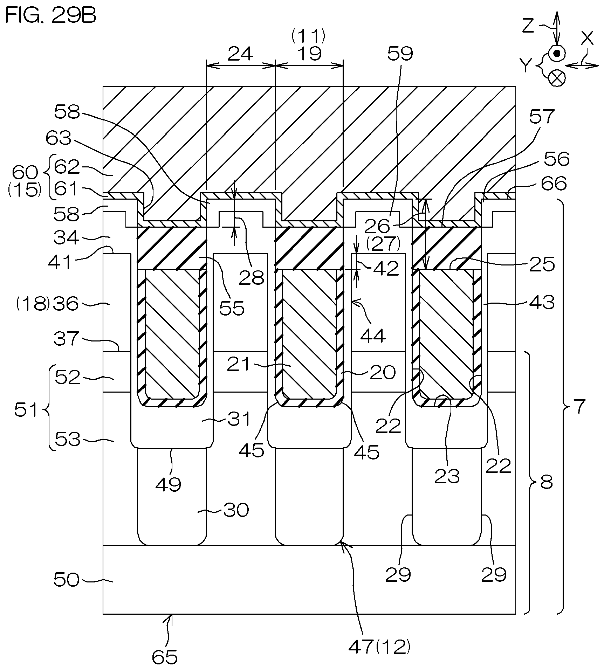

Next, referring to FIG. 29A and FIG. 29B, a forming step of the first principal surface electrode 60 that includes the gate pad 13, the source pad 15, etc., is performed (step S19 of FIG. 11). The first principal surface electrode 60 is formed by a first metal film that is to be a base of the barrier layer 61 and a second metal film that is to be a base of the main body layer 62 being deposited successively on the first wafer principal surface 66 by a sputtering method and thereafter being formed to a predetermined layout by an etching method via a mask (not shown) having the predetermined layout.

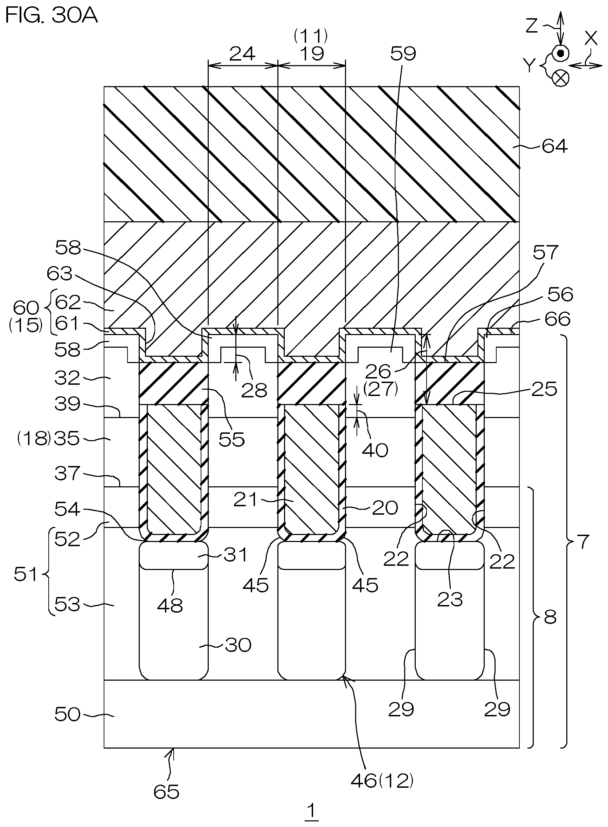

Next, referring to FIG. 30A and FIG. 30B, a forming step of the resin layer 64 is performed (step S20 of FIG. 11). The resin layer 64 is formed by a resin material that is to be a base of the resin layer 64 being coated and cured on the first principal surface electrode 60 and pad openings being formed selectively thereafter.

Next, a forming step of the drain pad 16 is performed (step S21 of FIG. 11). The drain pad 16 is formed by a metal film being deposited on the second wafer principal surface 67 by a sputtering method. Thereafter, the wafer 65 is cut along the plurality of intended cutting lines 71 (step S22 of FIG. 11). Through steps including the above, a plurality of the semiconductor devices 1 are manufactured from a single wafer 65.

### [Actions and Effects of the Semiconductor Device 1]

With the semiconductor device 1, the impurity concentration of the first layers 30 of the electric field relaxation layers 12 is of low concentration relative to the second layers 31. Since depletion layers can be extended comparatively widely from first pn junctions between the first layers 30 and the semiconductor layer 7 (the drift region 8), a device withstand voltage can be improved. On the other hand, the impurity concentration of the second layers 31 of the electric field relaxation layers 12 is of high concentration relative to the first layers 30. A width of depletion layers extending from second pn junctions between the second layers 31 and the semiconductor layer 7 can be made narrower than a width of the depletion layers extending from the first pn junctions. Thereby, depletion layers extending toward the bottom portions of the trenches 19 from the second pn junction portions can be made narrow and electric field strengths applied to the trench insulating films 20 can be relaxed. That is, both relaxation of the electric field strengths applied to the trench insulating films 20 and improvement of the device withstand voltage can be achieved at the same time.

Also, the laminated structures of the first layers 30 and the second layers 31 extend in the front-back direction of the trenches 19. Thereby, the electric field strengths applied to the trench insulating films 20 can be relaxed across a wide range in the front-back direction of the trenches 19 and the device withstand voltage can be improved.

Also, the first principal surface electrode 60 connected to the source regions 32 is electrically connected to the first layers 30 of the electric field relaxation layers 12 via the first contact regions 34 and the second contact regions 43. Thereby, a potential of the first layers 30 of the electric field relaxation layers 12 can be fixed at the same potential as the source regions 32.

Also, since the plurality of source regions 32 and the plurality of first contact regions 34 are aligned alternately along the front-back direction of the trenches 19, current paths (channels) formed in the depth direction of the trenches 19 can be formed in a well-balanced manner along the front-back direction of the trenches 19. In particular, since the source regions 32 and the first contact regions 34 are arranged adjacently in the front-back direction of the trenches 19 in each mesa portion 24, miniaturization of the device can be accommodated.

Also, the interlayer insulating layers 55 are embedded in the recesses 27 of the trenches 19 and the upper edges 56 of the trenches 19 are exposed. Thereby, the source regions 32 can be exposed over wide areas in the first principal surface 3. Therefore, even in situations where a miniaturized structure is required, a sufficient contact area between the first principal surface electrode 60 and the source regions 32 can be secured. Further, there is no need to form contact openings in the interlayer insulating layers 55. Since a need to consider positional deviation margins in the forming of contact openings is eliminated, the miniaturization of the device can be promoted further.

Further, the upper surfaces 57 of the interlayer insulating layers 55 are positioned further to the bottom portion side of the trenches 19 than the first principal surface 3 in the depth direction of the trenches 19 and the first principal surface electrode 60 is connected to the source regions 32 at the side surfaces 22 of the recesses 27 and the first principal surface 3. Thereby, the contact area between the first principal surface electrode 60 and the source regions 32 can be widened and a contact resistance between these can be reduced.

Also, the high concentration region 51 having the impurity concentration higher than the base region 50 is formed at sides of the electric field relaxation layers 12. Depletion layers having a wide width can thereby be extended by the base region 50 of relatively low concentration when the device (in this embodiment, a MISFET) is off and therefore, improvement of the device withstand voltage can be secured. In addition, by arranging the high concentration region 51 of relatively high concentration at the sides of the electric field relaxation layers 12, the depletion layers can be suppressed from spreading excessively in peripheries of the electric field relaxation layers 12 when the device (in this embodiment, a MISFET) is on. Since current paths can be secured by the suppression of expansion of the depletion layers, increase in on resistance can be suppressed.

Further, the first high concentration region 52, which is of relatively high concentration in the high concentration region 51, is formed to a shallower depth than the bottom portions of the trenches 19. The first high concentration region 52 serves the role of a current spreading layer (CSL) that spreads a current flowing via the channels across entire intervals between adjacent trenches 19 and can reduce the on resistance. Further, a bottom portion of the first high concentration region 52 is shallower than the bottom portions of the trenches 19 and does not contact the boundary portions 54 between the bottom portions of the trenches 19 and the electric field relaxation layers 12. Thereby, even when the concentration of the first high concentration region 52 is made high, influences on the device withstand voltage and the electric field with respect to the trench insulating films 20 can be lessened. In addition, by arranging the second high concentration region 53 of relatively low concentration at the second principal surface 4 side of the first high concentration region 52, an improvement effect of the device withstand voltage can be obtained.

Also, the first layers 30 of the electric field relaxation layers 12 are formed to a depth reaching the base region 50 in the thickness direction of the chip 2. The first pn junctions can thereby be formed between the first layers 30 and the base region 50 and therefore, the depletion layers can be extended wider and the device withstand voltage can be improved further.

Further, the bottom portions of the first layers 30 of the electric field relaxation layers 12 contact the base region 50 and form the boundary portions with the base region 50. Thereby, although the first layers 30 contact the base region 50, contact areas thereof can be prevented from becoming too wide. Consequently, while enabling the depletion layers to be extended widely, an extension range of the depletion layers can be made suitable in extent and sufficient current paths can be secured.

### [Other Preferred Embodiments of the Semiconductor Device 1]

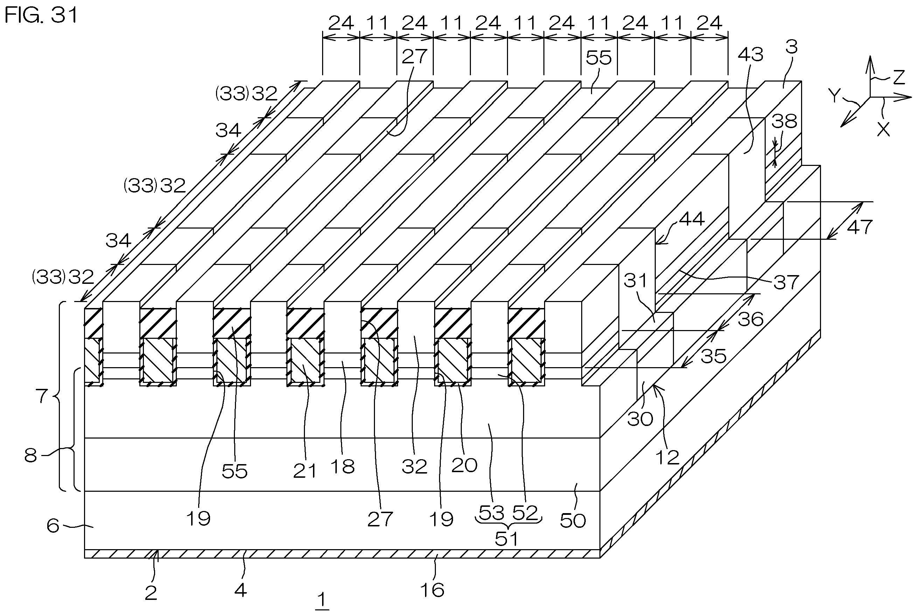

Referring to FIG. 31 to FIG. 69, other preferred embodiments of the semiconductor device 1 shall be described. In the following, portions different from the structure of the semiconductor device 1 shown in FIG. 5 to FIG. 9 shall mainly be described and description shall be omitted for portions in common with FIG. 5 to FIG. 9.

### (1) Embodiment of FIG. 31

FIG. 31 shows another preferred embodiment of the semiconductor device 1 and is a perspective view corresponding to FIG. 5. Referring to FIG. 31, the electric field relaxation layers 12 may be aligned at intervals in the front-back direction of the trenches 19. For example, the layers may be formed selectively at portions corresponding to the second body portions 36 of the mesa portions 24 and not be formed at portions corresponding to the first body portions 35. That is, the electric field relaxation layers 12 may be formed selectively at portions avoiding the channel sections 33 in the mesa portions 24. Since the electric field relaxation layers 12 are not formed in the channel sections 33, the current paths can be secured widely in the channel sections 33.

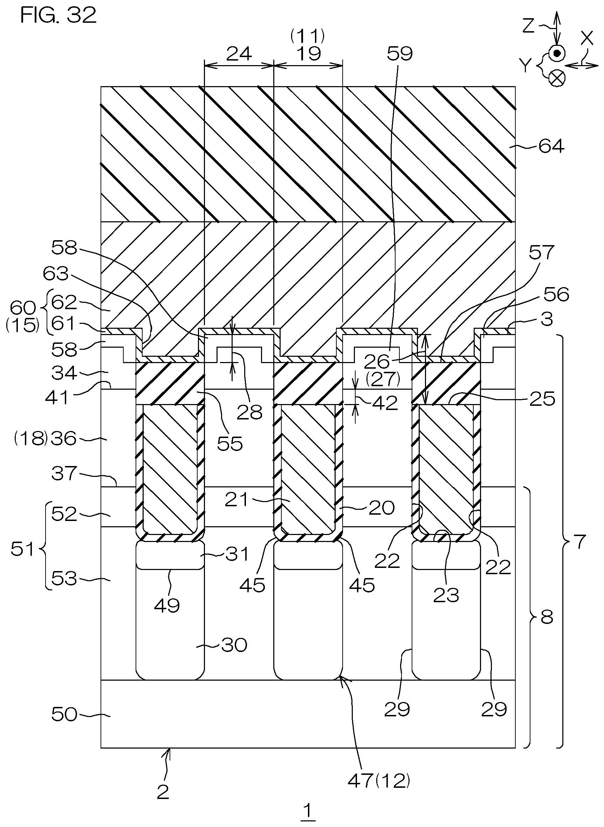

### (2) Embodiment of FIG. 32

FIG. 32 shows another preferred embodiment of the semiconductor device 1 and is a sectional view corresponding to FIG. 7. Referring to FIG. 32, when the electric field relaxation layers 12 do not need to be fixed at the source potential, the second contact regions 43 do not have to be formed. In this case, the first contact regions 34 and the electric field relaxation layers 12 are electrically separated by the drift region 8 being interposed therebetween.

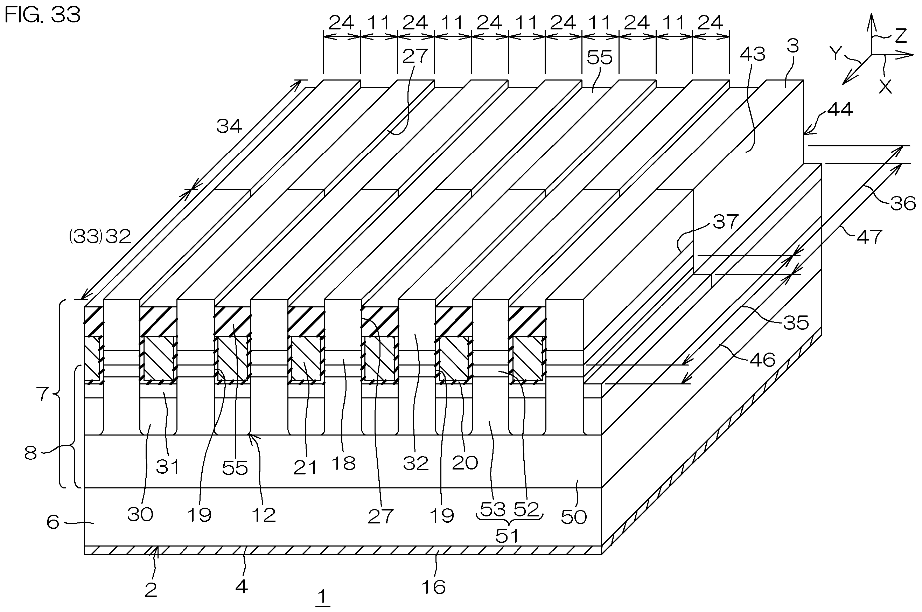

### (3) Embodiment of FIG. 33

FIG. 33 shows another preferred embodiment of the semiconductor device 1 and is a perspective view corresponding to FIG. 5. Referring to FIG. 33, an upper portion of each mesa portion 24 (the surface layer portion of the body region 18) may be divided into two regions, and the source region 32 of a band shape extending in the front-back direction of the trench 19 may be arranged in one of the regions (in this embodiment, toward the front side of the sheet in FIG. 33). The first contact region 34 extending in the front-back direction of the trench 19 may be arranged in the other region (in this embodiment, toward the back side of the sheet in FIG. 33). That is, with the semiconductor device 1, the plurality of source regions 32 and the plurality of first contact regions 34 do not have to be aligned alternately along the front-back direction of the trenches 19.

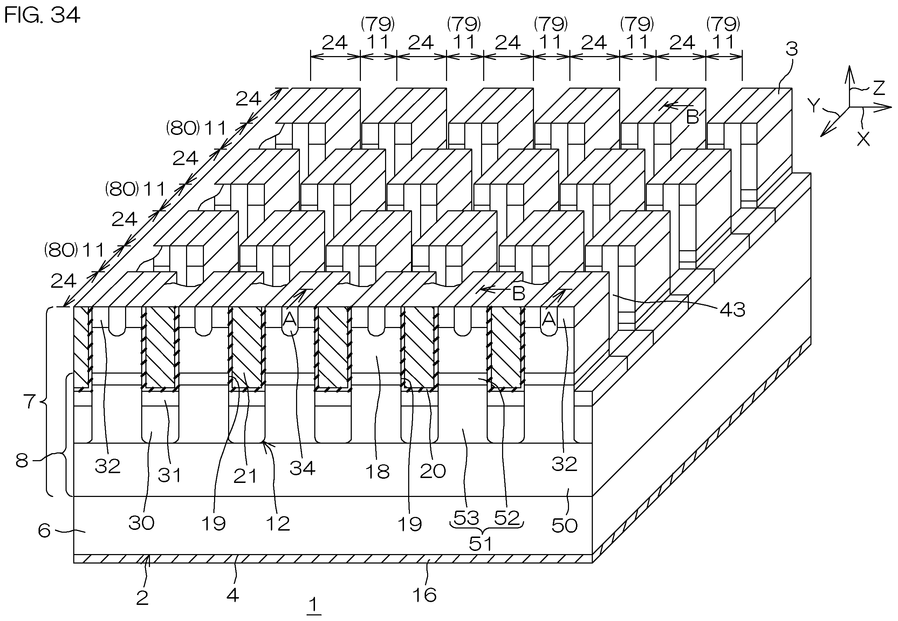

### (4) Embodiment of FIG. 34 to FIG. 36

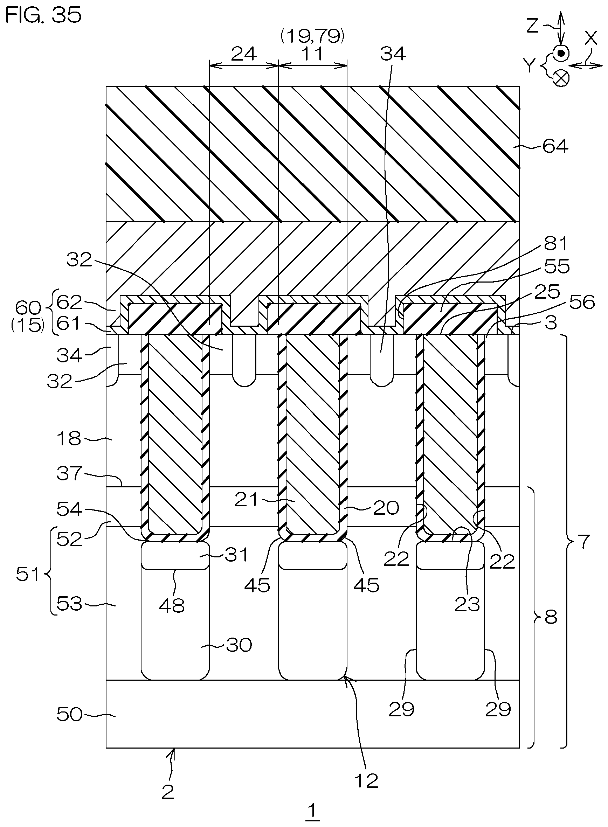

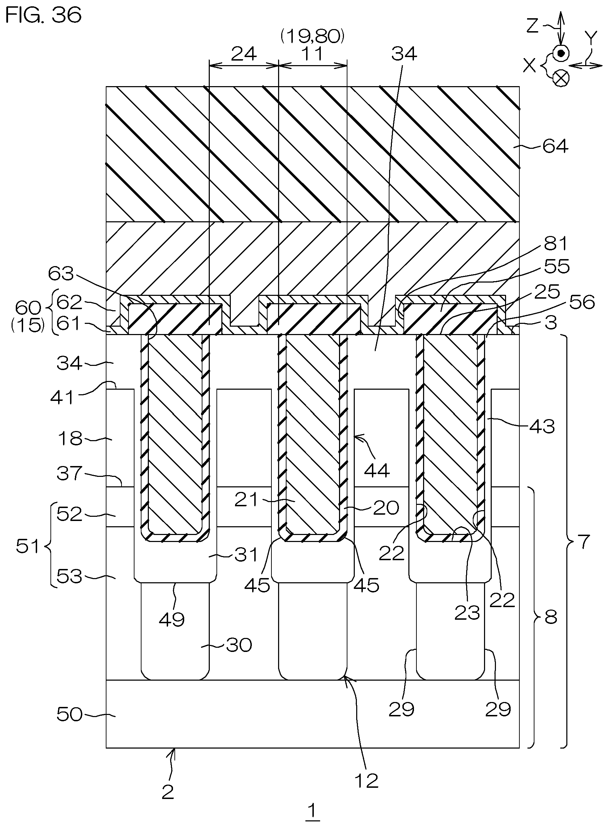

FIG. 34 shows another preferred embodiment of the semiconductor device 1 and is a perspective view corresponding to FIG. 5. FIG. 35 is a sectional view taken along line A-A shown in FIG. 34. FIG. 36 is a sectional view taken along line B-B shown in FIG. 34.

Referring to FIG. 34 to FIG. 36, the trenches 19 may be formed in a lattice by a plurality of first trenches 79 of stripe shape extending in the second direction Y and a plurality of second trenches 80 of stripe shape extending in the first direction X. Thereby, each mesa portion 24 is formed in a window portion of the trenches 19 of lattice shape. The plurality of mesa portions 24 are arrayed in a matrix.

In each mesa portion 24, the source regions 32 are formed at both the one side surface 22 side and the other side surface 22 side in the first direction X of the mesa portion 24. As shown in FIG. 34 and FIG. 35, in this embodiment, in each mesa portion 24, a pair of the source regions 32 of band shape extend in the front-back direction of the second trenches 80 from the one side surface 22 to the other side surface 22 in the second direction Y.

Also, each first contact region 34 is formed in a central portion in the first direction X of the mesa portion 24 between the pair of source regions 32. The first contact region 34 is sandwiched by the pair of source regions 32 in the first direction X. The first contact region 34 penetrates through the source regions 32 in the thickness direction and is connected to the body region 18. In each mesa portion 24, the first contact region 34 extends in the front-back direction of the second trenches 80 from the one side surface 22 to the other side surface 22 in the second direction Y. Thereby, in each mesa portion 24, the first contact region 34 and the pair of source regions 32 that sandwich the first contact region 34 from both sides are formed, in each mesa portion 24, as stripes extending in the front-back direction of the second trenches 80.

The electric field relaxation layers 12 are formed across an entirety of the bottom portions of the trenches 19 of lattice shape. The electric field relaxation layers 12 are therefore formed in a lattice in plan view.

The second contact regions 43 are selectively formed on the side surfaces 22 oriented along the first direction X of each mesa portion 24 and are not formed on the side surfaces 22 oriented along the second direction Y. Thereby, in each mesa portion 24, the channel sections 33 are secured at the side surfaces 22 oriented along the second direction Y. On the other hand, by the second contact regions 43 being formed on the side surfaces 22 oriented along the first direction X, the electric field relaxation layers 12 can be fixed at the source potential. Referring to FIG. 36, the first contact regions 34 of the plurality of mesa portions 24 aligned along the second direction Y are electrically connected to each other via the second contact regions 43 and the electric field relaxation layers 12 (the second layer 31) extending across adjacent mesa portions 24.

Referring to FIG. 35 and FIG. 36, in this embodiment, the embedded bodies 21 are embedded up to the first principal surface 3 in the trenches 19. Thereby, the recesses 27 are not formed and the upper surfaces 25 of the embedded bodies 21 and the first principal surface 3 are formed to be substantially flat with respect to each other. The interlayer insulating layers 55 are formed on the first principal surface 3 such as to cover the embedded bodies 21 and the upper edges 56 of the trenches 19. The interlayer insulating layers 55 have contact openings 81 and the first principal surface electrode 60 is connected to the source regions 32 and the first contact regions 34 via the contact openings 81.

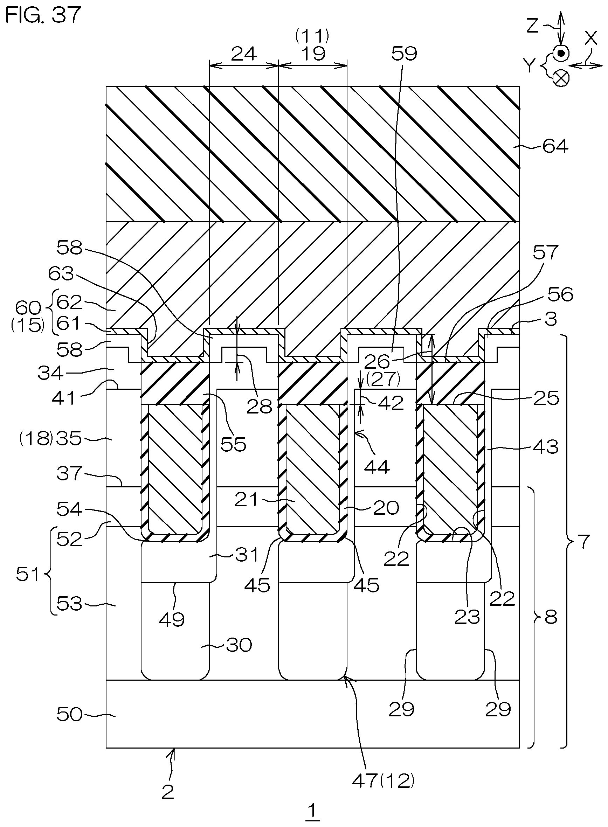

### (5) Embodiment of FIG. 37

FIG. 37 shows another preferred embodiment of the semiconductor device 1 and is a sectional view corresponding to FIG. 7. Referring to FIG. 37, each second contact region 43 may be formed selectively at one side among the one side surface 22 and the other side surface 22 of the mesa portion 24. Thereby, channels can be formed in the side surface 22 in which the second contact region 43 is not formed and therefore, a channel area of the device can be enlarged. Consequently, the on resistance can be reduced.

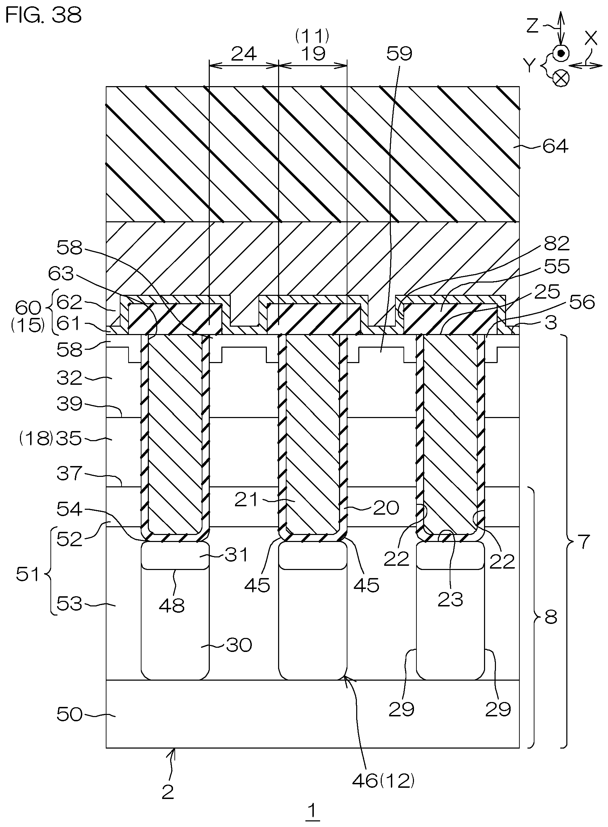

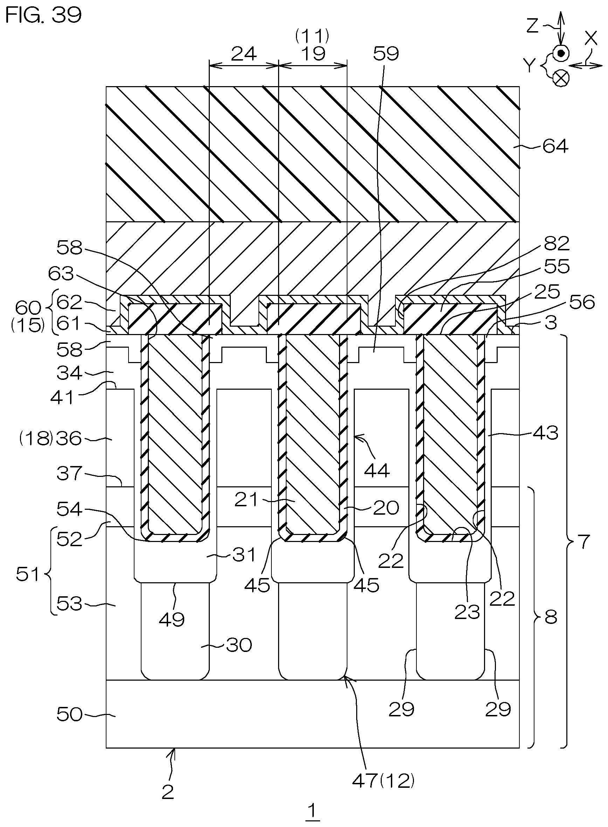

### (6) Embodiment of FIG. 38 and FIG. 39

FIG. 38 shows another preferred embodiment of the semiconductor device 1 and is a sectional view corresponding to FIG. 6. FIG. 39 shows the other preferred embodiment of the semiconductor device 1 and is a sectional view corresponding to FIG. 7. Referring to FIG. 38 and FIG. 39, the embedded bodies 21 are embedded up to the first principal surface 3 in the trenches 19. Thereby, the recesses 27 are not formed and the upper surfaces 25 of the embedded bodies 21 and the first principal surface 3 are formed to be substantially flat with respect to each other.

The interlayer insulating layers 55 are formed on the first principal surface 3 such as to cover the embedded bodies 21 and the upper edges 56 of the trenches 19. The interlayer insulating layers 55 have contact openings 82 and the first principal surface electrode 60 is connected to the source regions 32 and the first contact regions 34 via the contact openings 82.

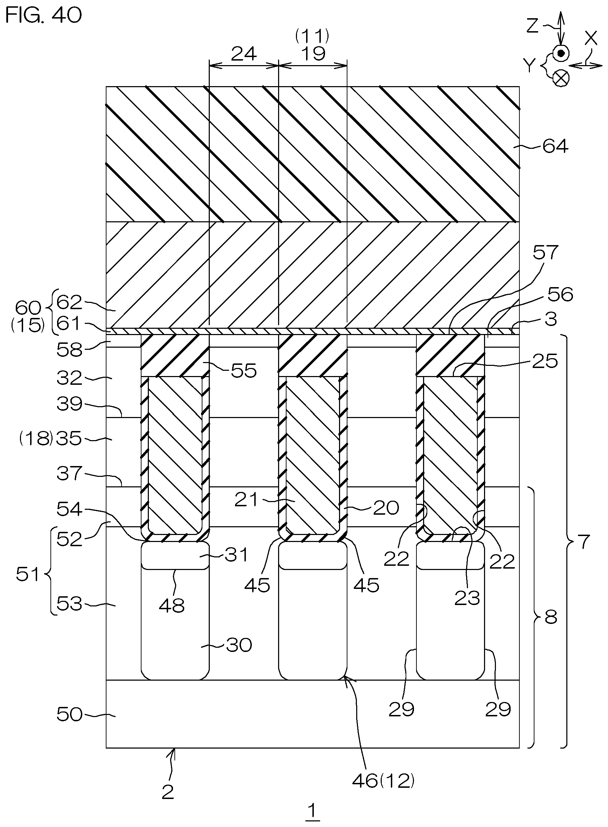

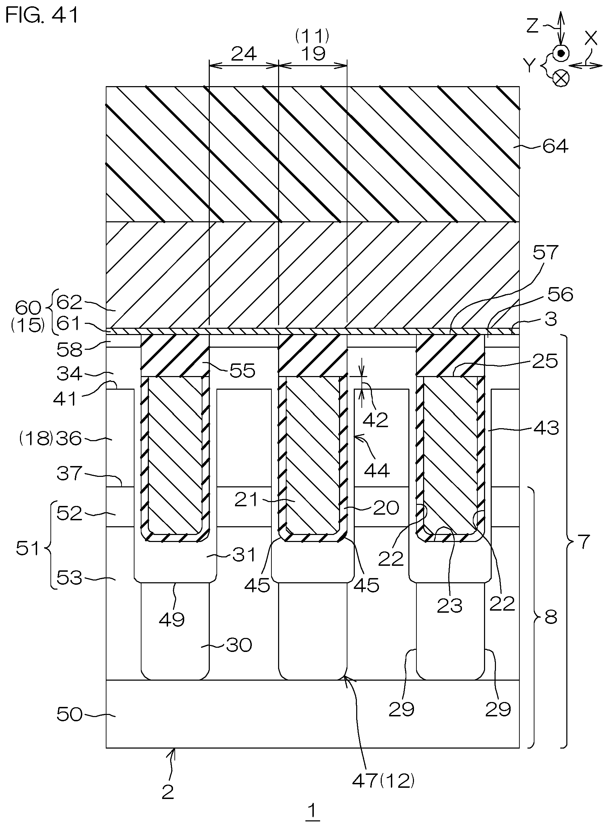

### (7) Embodiment of FIG. 40 and FIG. 41

FIG. 40 shows another preferred embodiment of the semiconductor device 1 and is a sectional view corresponding to FIG. 6. FIG. 41 shows the other preferred embodiment of the semiconductor device 1 and is a sectional view corresponding to FIG. 7. Referring to FIG. 40 and FIG. 41, the interlayer insulating layers 55 are embedded up to the first principal surface 3 in the trenches 19.

Thereby, the recesses 27 do not remain on the interlayer insulating layers 55 and the upper surfaces 57 of the interlayer insulating layers 55 and the first principal surface 3 are formed to be substantially flat with respect to each other. Even in this embodiment, the upper edges 56 of the trenches 19 are not covered by the interlayer insulating layers 55 and therefore, the source regions 32 can be exposed over wide areas in the first principal surface 3. Therefore, even in situations where a miniaturized structure is required, a sufficient contact area between the first principal surface electrode 60 and the source regions 32 can be secured. Further, there is no need to form contact openings in the interlayer insulating layers 55. Since a need to consider positional deviation margins in the forming of contact openings is eliminated, the miniaturization of the device can be promoted further.

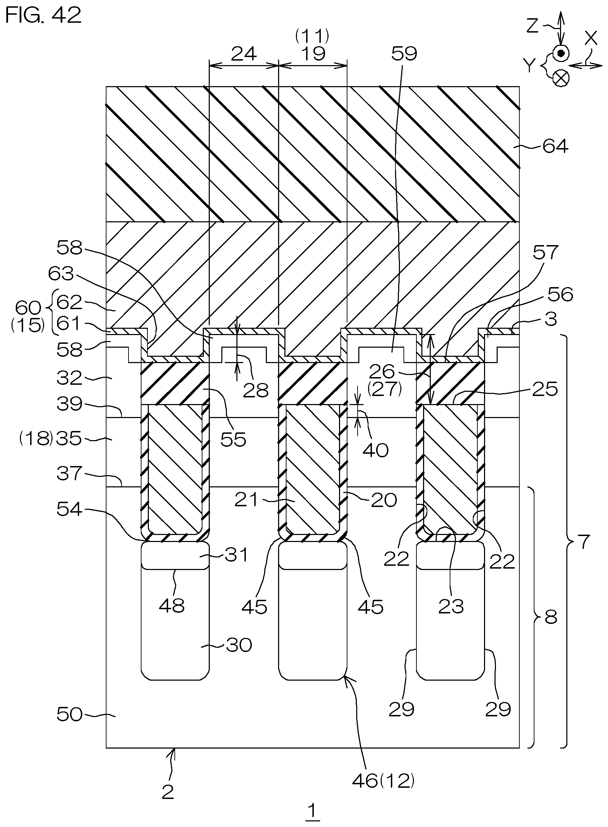

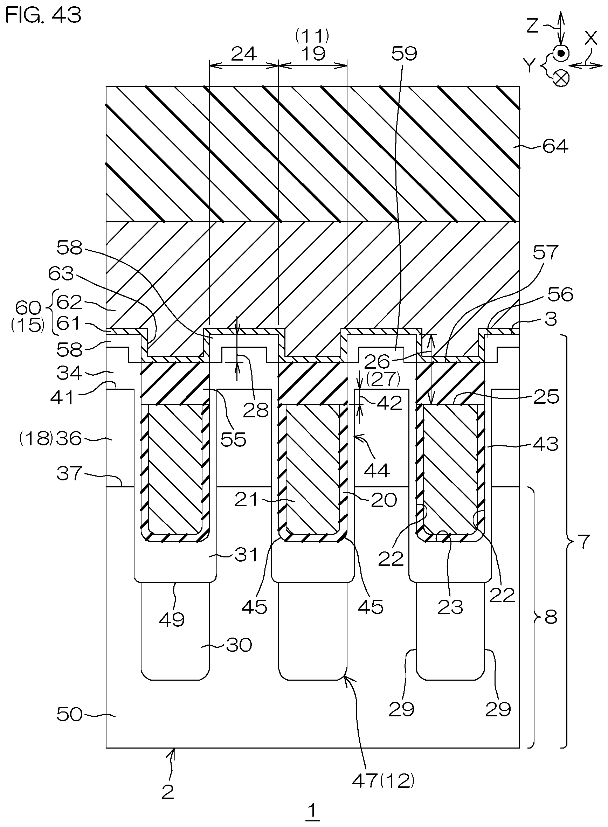

### (8) Embodiment of FIG. 42 and FIG. 43

FIG. 42 shows another preferred embodiment of the semiconductor device 1 and is a sectional view corresponding to FIG. 6. FIG. 43 shows the other preferred embodiment of the semiconductor device 1 and is a sectional view corresponding to FIG. 7. Referring to FIG. 42 and FIG. 43, the drift region 8 may be formed of a single layer of the base region 50. That is, the high concentration region 51 may be omitted in the semiconductor layer 7.

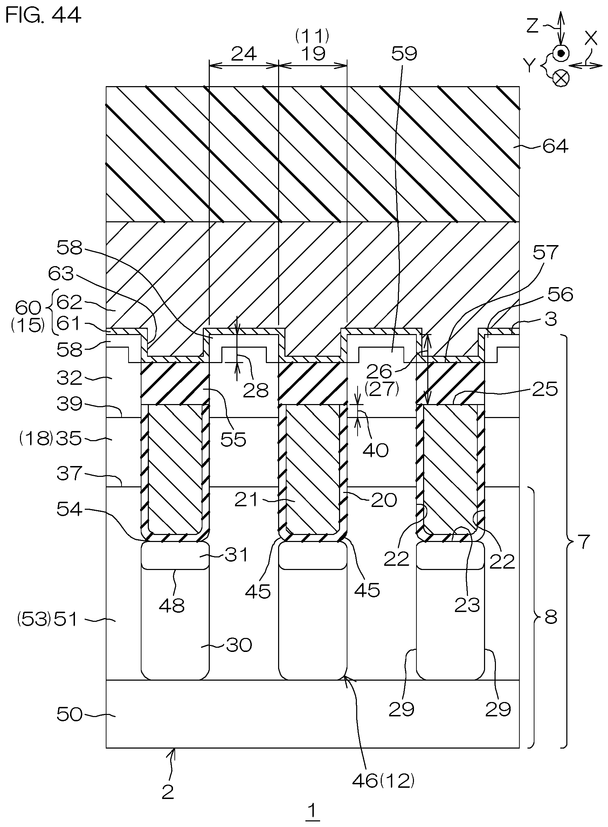

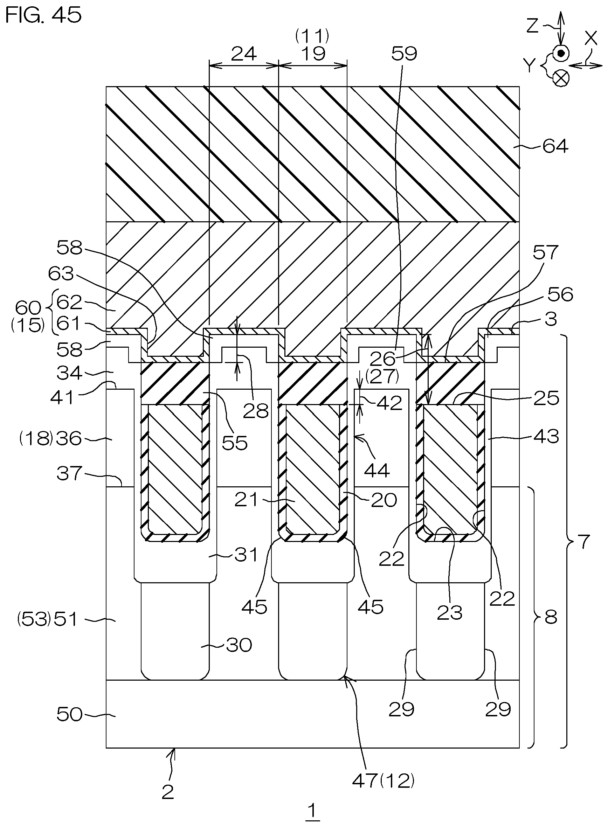

### (9) Embodiment of FIG. 44 and FIG. 45

FIG. 44 shows another preferred embodiment of the semiconductor device 1 and is a sectional view corresponding to FIG. 6. FIG. 45 shows the other preferred embodiment of the semiconductor device 1 and is a sectional view corresponding to FIG. 7. Referring to FIG. 44 and FIG. 45, the high concentration region 51 may be formed of a single layer of either of the first high concentration region 52 and the second high concentration region 53. In this embodiment, the high concentration region 51 is formed of the single layer of the second high concentration region 53.

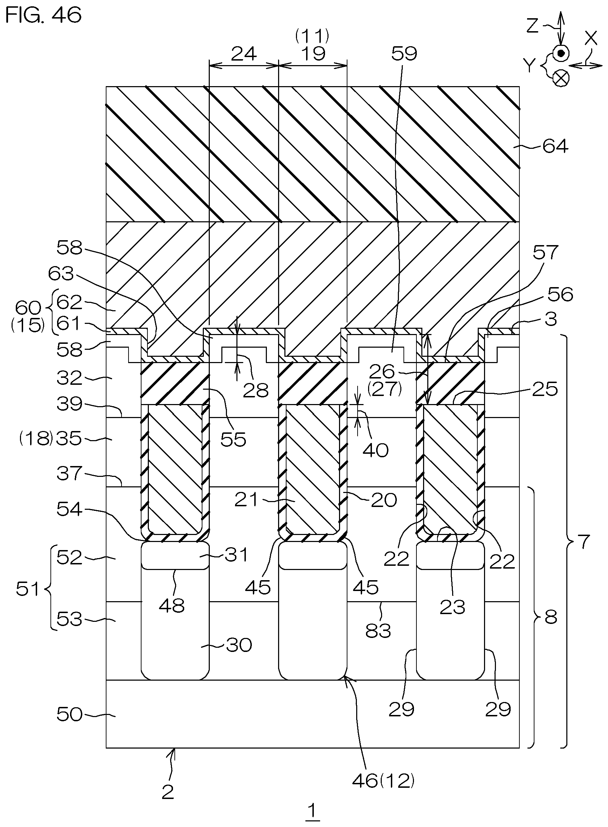

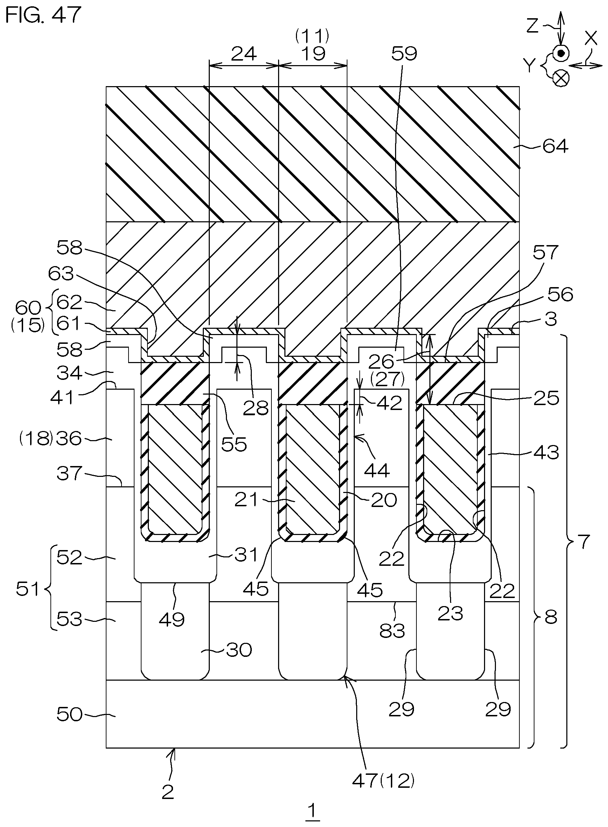

### (10) Embodiment of FIG. 46 and FIG.47

FIG. 46 shows another preferred embodiment of the semiconductor device 1 and is a sectional view corresponding to FIG. 6. FIG. 47 shows the other preferred embodiment of the semiconductor device 1 and is a sectional view corresponding to FIG. 7. Referring to FIG. 46 and FIG. 47, the bottom portion of the first high concentration region 52 (a boundary surface 83 between the first high concentration region 52 and the second high concentration region 53) is positioned further to the second principal surface 4 side than the first boundary surfaces 48 between the first layers 30 and the second layers 31 in the first relaxation portions 46 (FIG. 46) and is also positioned further to the second principal surface 4 side than the second boundary surfaces 49 between the first layers 30 and the second layers 31 in the second relaxation portions 47 (FIG. 47).

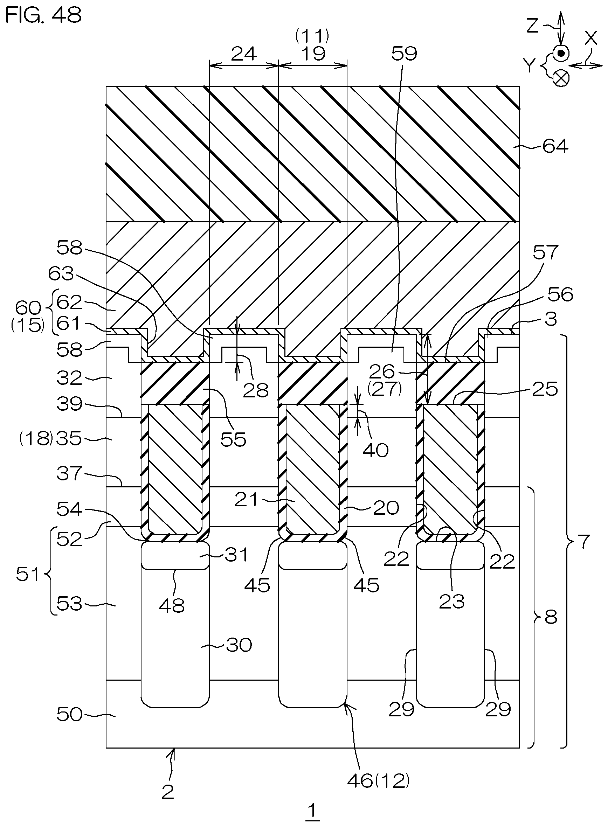

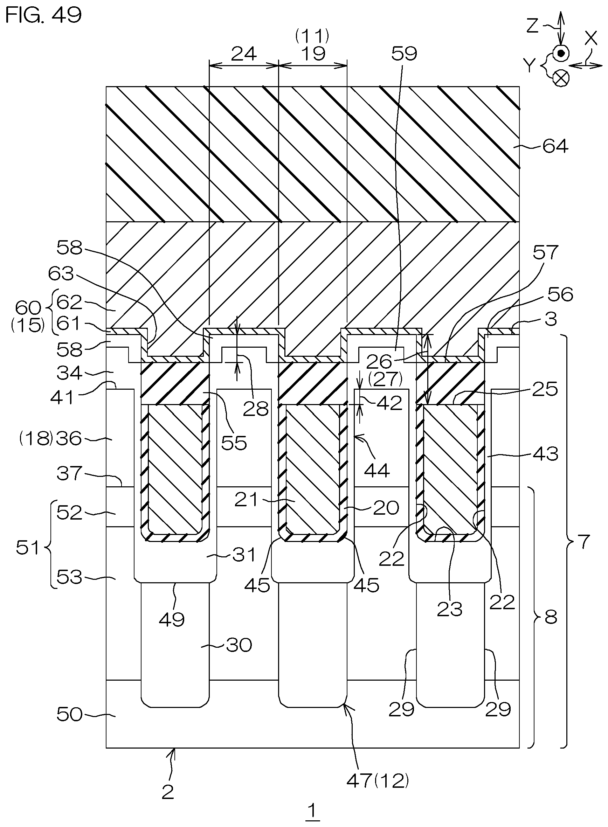

### (11) Embodiment of FIG. 48 and FIG. 49

FIG. 48 shows another preferred embodiment of the semiconductor device 1 and is a sectional view corresponding to FIG. 6. FIG. 49 shows the other preferred embodiment of the semiconductor device 1 and is a sectional view corresponding to FIG. 7. Referring to FIG. 48 and FIG. 49, in the thickness direction of the chip 2, the first layers 30 of the electric field relaxation layers 12 reach the base region 50 and are further formed to a depth reaching a thickness direction intermediate portion of the base region 50. That is, the first layers 30 exceed a boundary surface between the base region 50 and the high concentration region 51 to the second principal surface 4 side and are partially embedded in the base region 50.

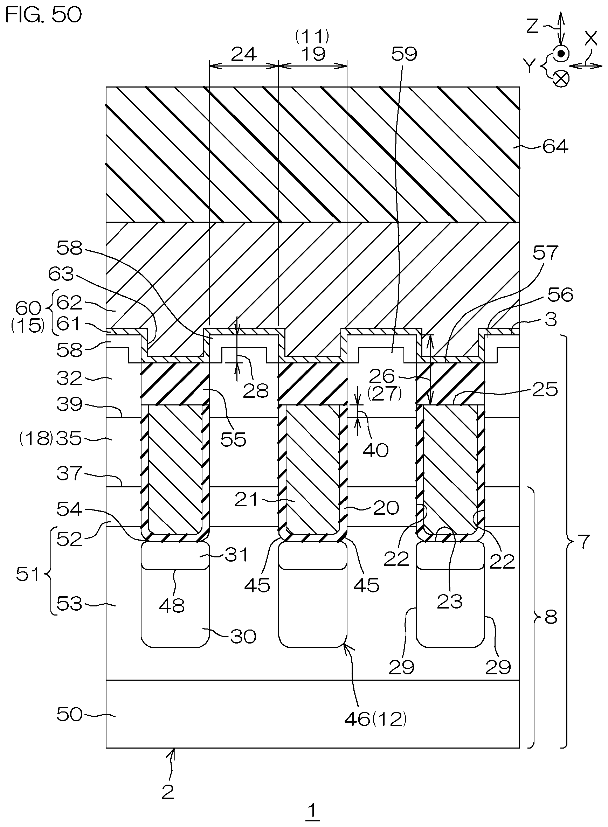

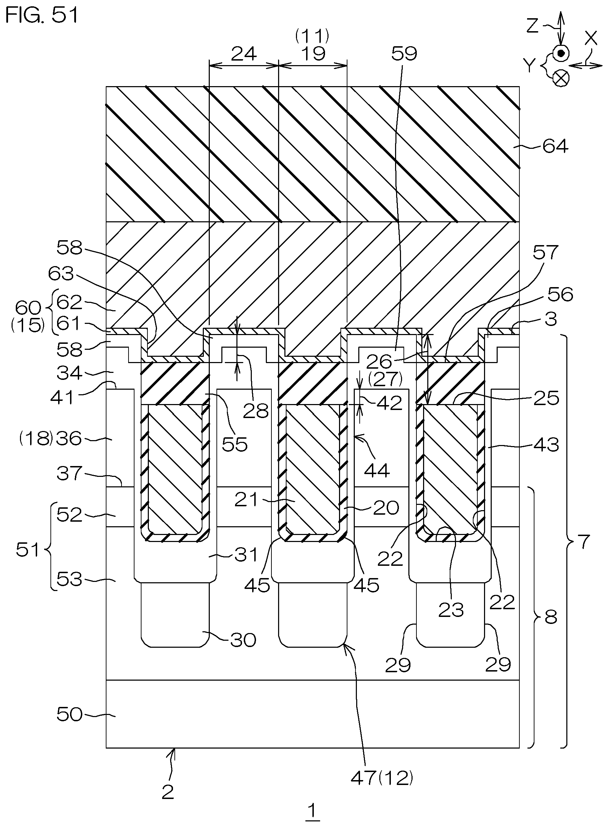

### (12) Embodiment of FIG. 50 and FIG. 51

FIG. 50 shows another preferred embodiment of the semiconductor device 1 and is a sectional view corresponding to FIG. 6. FIG. 51 shows the other preferred embodiment of the semiconductor device 1 and is a sectional view corresponding to FIG. 7. Referring to FIG. 50 and FIG. 51, in the thickness direction of the chip 2, the first layers 30 of the electric field relaxation layers 12 may be separated to the first principal surface 3 side from the base region 50. That is, in the thickness direction of the chip 2, a portion of the high concentration region 51 (in this embodiment, the second high concentration region 53) may be interposed between the bottom portions of the first layers 30 and the base region 50.

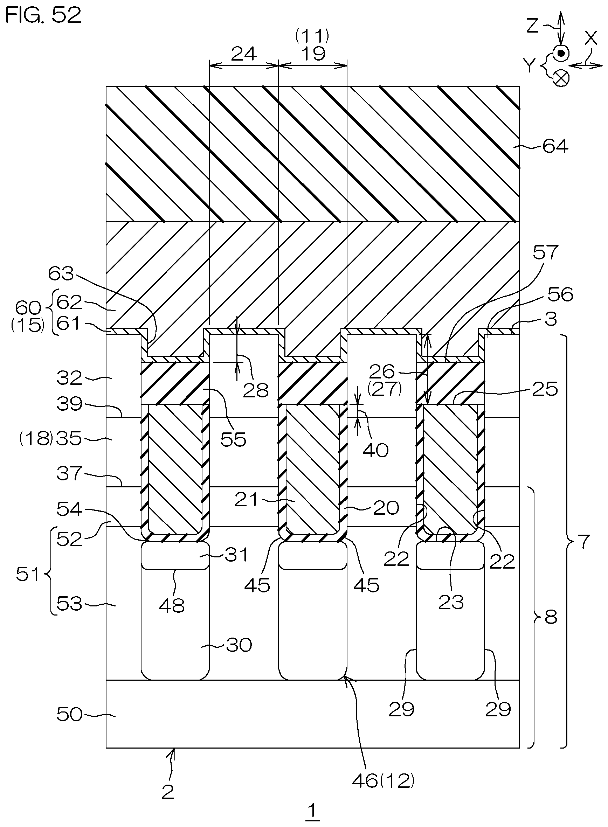

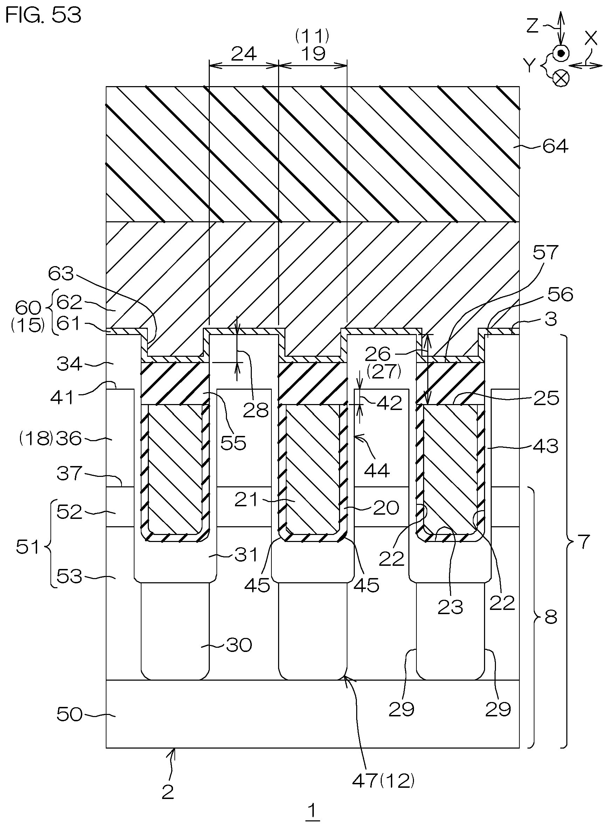

### (13) Embodiment of FIG. 52 and FIG. 53

FIG. 52 shows another preferred embodiment of the semiconductor device 1 and is a sectional view corresponding to FIG. 6. FIG. 53 shows the other preferred embodiment of the semiconductor device 1 and is a sectional view corresponding to FIG. 7. Referring to FIG. 52 and FIG. 53, the silicide layers 58 do not have to be formed on the respective front surfaces of the source regions 32 and the first contact regions 34.

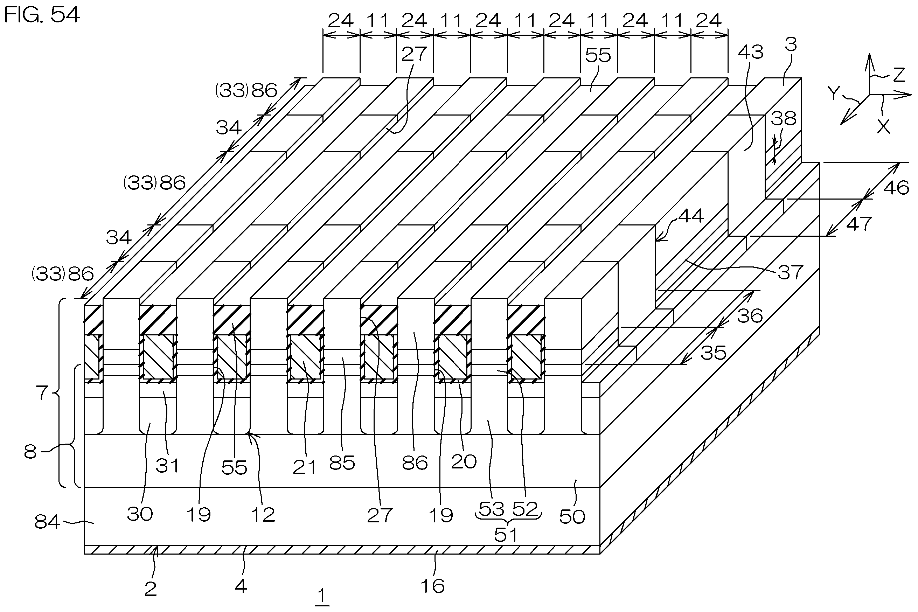

### (14) Embodiment of FIG. 54

FIG. 54 shows another preferred embodiment of the semiconductor device 1 and is a perspective view corresponding to FIG. 5. Referring to FIG. 54, the element structure of the semiconductor device 1 may be an IGBT (insulated gate bipolar transistor) structure instead of a MISFET structure. In this case, a collector region 84 of the p-type may be formed in place of the base layer 6. Also, a base region 85 of the p-type may be formed by the body region 18 and emitter regions 86 of the n-type may be formed by the source regions 32.

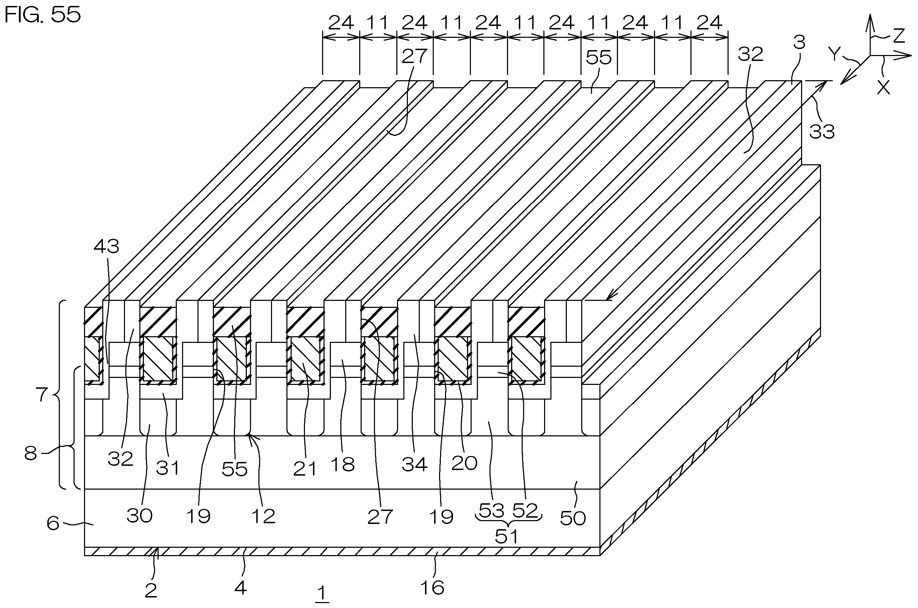

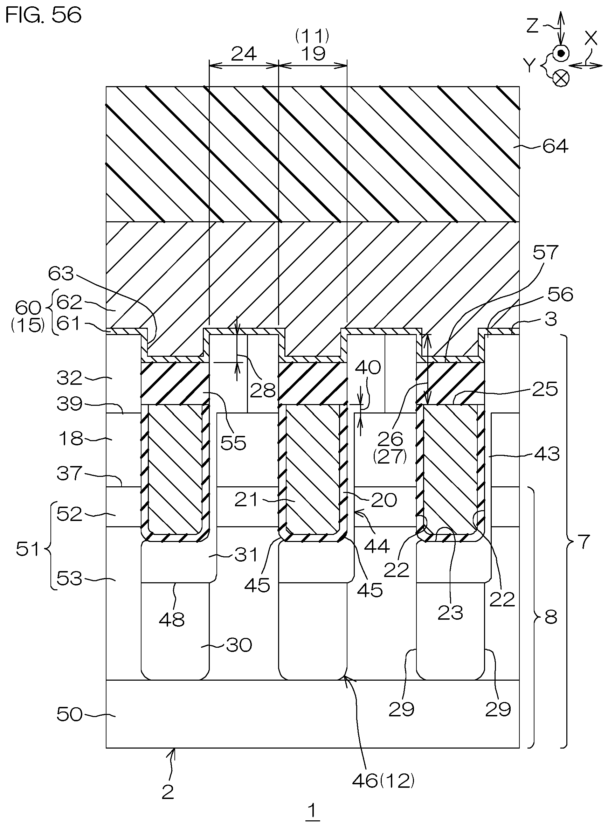

### (15) Embodiment of FIG. 55 and FIG. 56

FIG. 55 shows another preferred embodiment of the semiconductor device 1 and is a perspective view corresponding to FIG. 5. FIG. 56 shows the other preferred embodiment of the semiconductor device 1 and is a sectional view corresponding to FIG. 6. Referring to FIG. 55 and FIG. 56, each source region 32 is selectively formed, at an interval from one side surface 22 of the mesa portion 24, at the other side surface 22 side of the mesa portion 24. On the other hand, the first contact region 34 is adjacent to the source region 32 in the width direction of the mesa portion 24 and is selectively formed at the one side surface 22 side of the mesa portion 24.

In each mesa portion 24, the source region 32 and the first contact region 34 extend in parallel in band shapes in the front-back direction of the trench 19. That is, in this embodiment, in each mesa portion 24, one each of the source region 32 and the first contact region 34 are formed as stripes as whole. The channel section 33 in which the channels are formed is selectively formed at the width direction other side of the mesa portion 24. On the other hand, the second contact region 43 is selectively formed at the one side of the mesa portion 24.

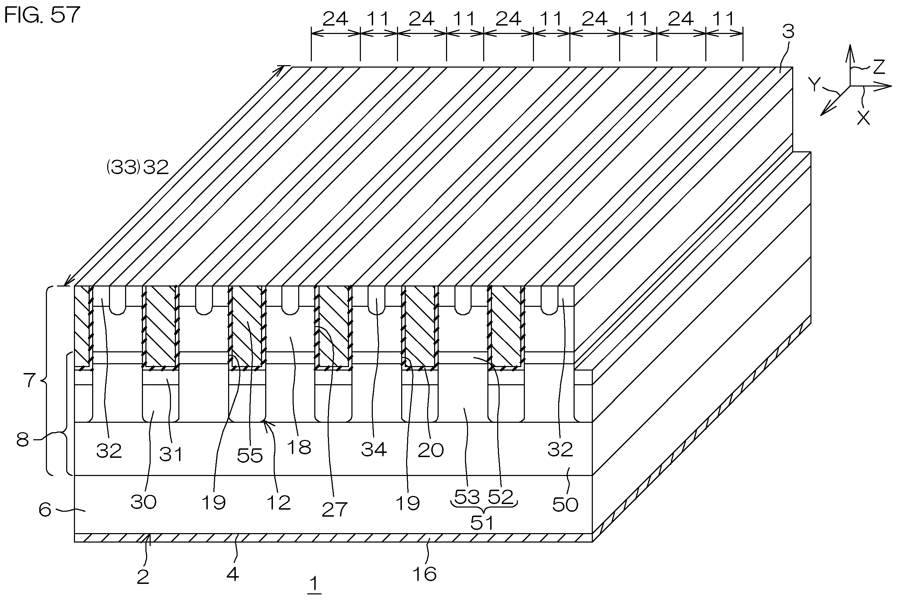

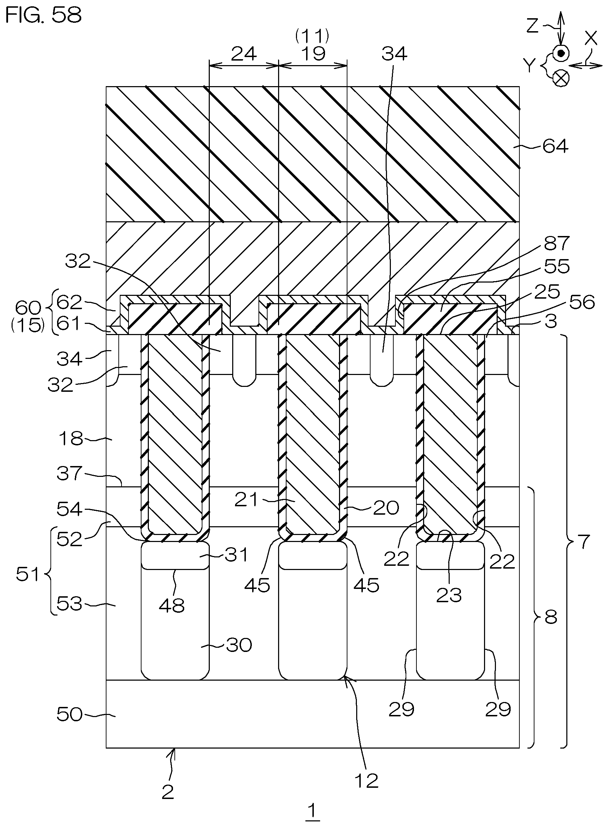

### (16) Embodiment of FIG. 57 and FIG. 58

FIG. 57 shows another preferred embodiment of the semiconductor device 1 and is a perspective view corresponding to FIG. 5. FIG. 58 shows the other preferred embodiment of the semiconductor device 1 and is a sectional view corresponding to FIG. 6.

Referring to FIG. 57 and FIG. 58, in each mesa portion 24, the source regions 32 are formed at both of one side surface 22 side and the other side surface 22 side in the first direction X of the mesa portion 24. In this embodiment, in each mesa portion 24, a pair of the source regions 32 of band shape extend as stripes in the front-back direction of the trenches 19.

Also, each first contact region 34 is formed in a central portion in the first direction X of the mesa portion 24 between the pair of source regions 32. The first contact region 34 is sandwiched by the pair of source regions 32 in the first direction X. The first contact region 34 penetrates through the source regions 32 in the thickness direction and is connected to the body region 18. In each mesa portion 24, the first contact region 34 extends in a band shape in the front-back direction of the trenches 19. Thereby, in each mesa portion 24, the first contact region 34 and the pair of source regions 32 that sandwich the first contact region 34 from both sides are formed, in each mesa portion 24, as stripes extending in the front-back direction of the trenches 19.

Referring to FIG. 58, the embedded bodies 21 are embedded up to the first principal surface 3 in the trenches 19. Thereby, the recesses 27 are not formed and the upper surfaces 25 of the embedded bodies 21 and the first principal surface 3 are formed to be substantially flat with respect to each other. The interlayer insulating layers 55 are formed on the first principal surface 3 such as to cover the embedded bodies 21 and the upper edges 56 of the trenches 19. The interlayer insulating layers 55 have contact openings 87 and the first principal surface electrode 60 is connected to the source regions 32 and the first contact regions 34 via the contact openings 87.

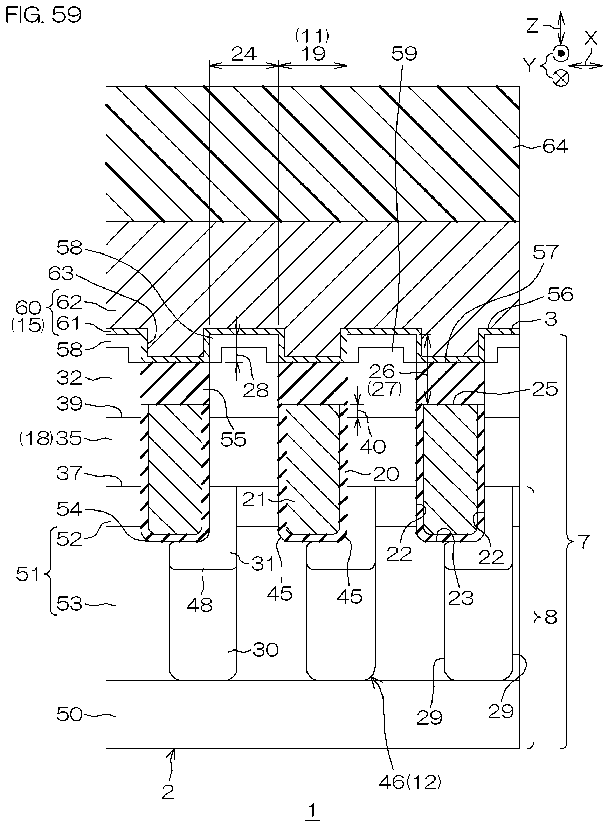

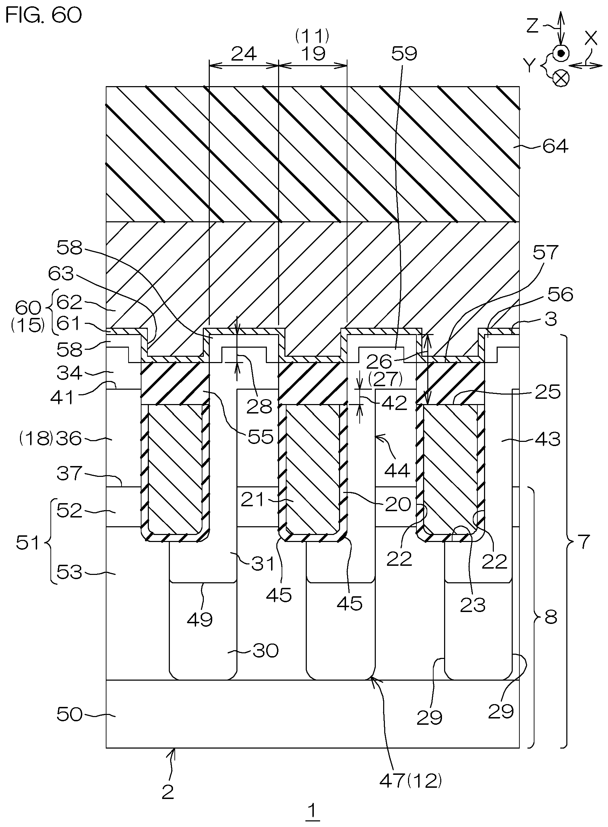

### (17) Embodiment of FIG. 59 and FIG. 60

FIG. 59 shows another preferred embodiment of the semiconductor device 1 and is a sectional view corresponding to FIG. 6. FIG. 60 shows the other preferred embodiment of the semiconductor device 1 and is a sectional view corresponding to FIG. 7.

Referring to FIG. 59 and FIG. 60, each electric field relaxation layer 12 is formed separated from one side end portion of the trench 19 in the width direction of the trench 19 to the other side. More specifically, the electric field relaxation layer 12 is formed integral to the body region 18 and is selectively formed on the other side in the first direction X with respect to the trench 19. In this embodiment, the electric field relaxation layer 12 extends lower than the bottom surface 23 of the trench 19 in the vertical direction Z from a portion of the body region 18 of each mesa portion 24 and spreads along the horizontal direction along the first principal surface 3 and is overlapped with the bottom surface 23 of the trench 19.

The electric field relaxation layer 12 forms at least a portion of each of the side surface 22 at the other side among the pair of mutually facing pair of side surfaces 22 of the trench 19 and the bottom surface 23 and contacts the trench insulating film 20. Inside each trench 19, the electric field relaxation layer 12 has an exposed surface of substantially L-shape that is exposed as a lower portion of the side surface 22 of the trench 19 and the bottom surface 23 of the trench 19 that is continuous with the lower portion of the side surface 22.

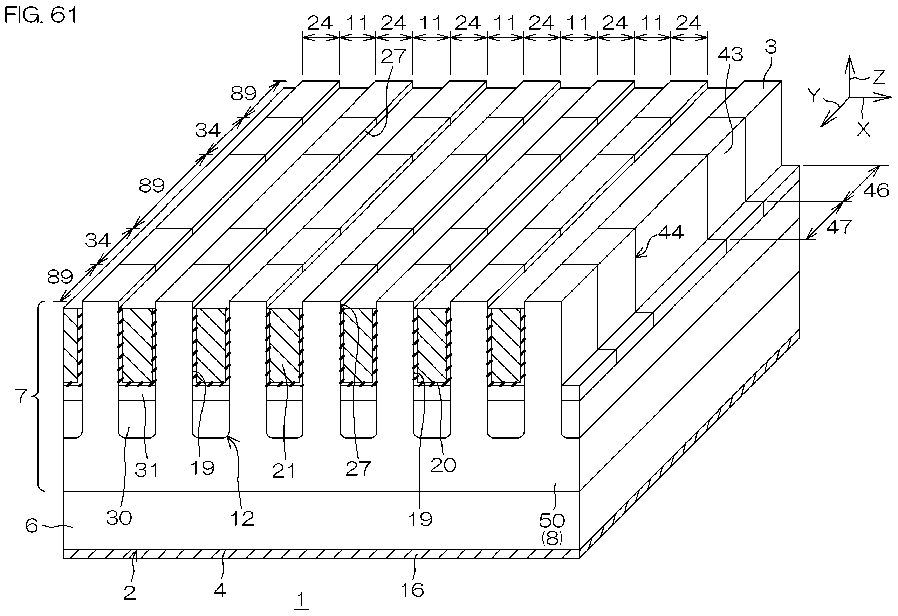

### (18) Embodiment of FIG. 61 to FIG. 63

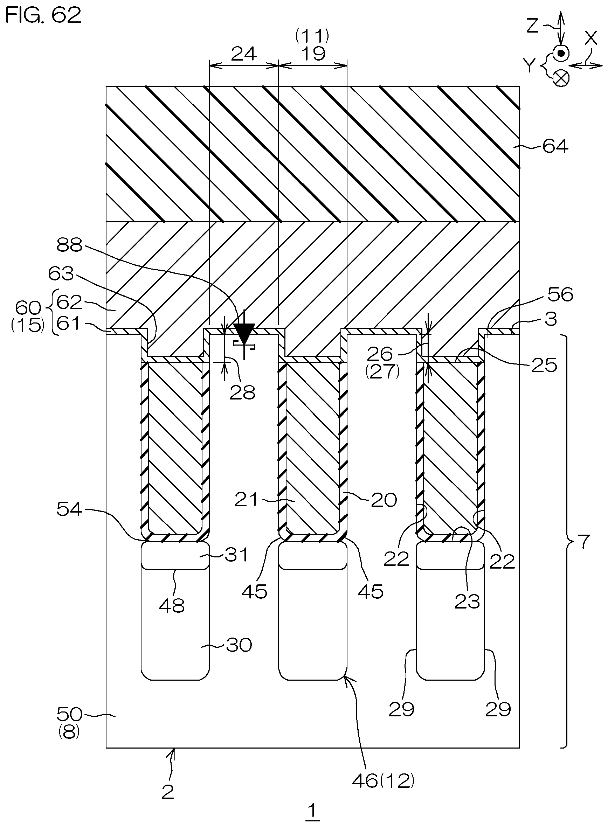

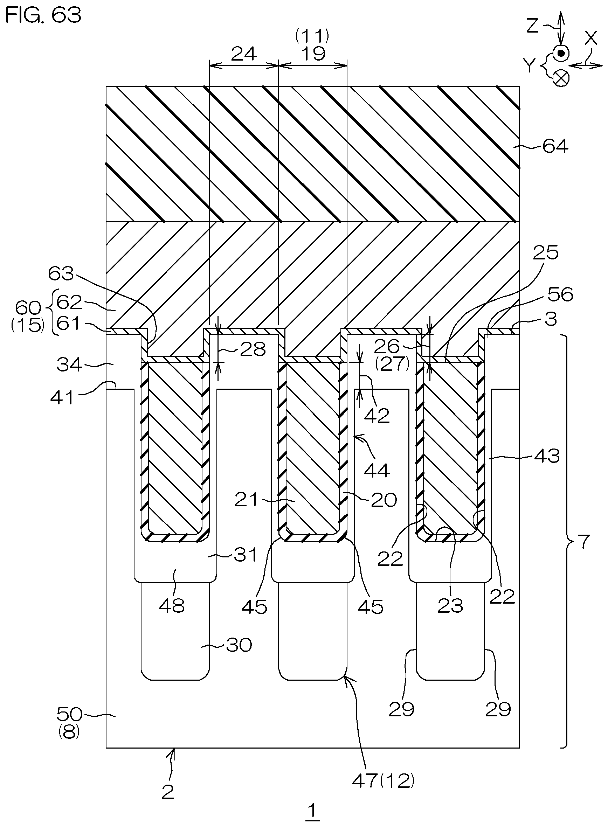

FIG. 61 shows another preferred embodiment of the semiconductor device 1 and is a perspective view corresponding to FIG. 5. FIG. 62 shows the other preferred embodiment of the semiconductor device 1 and is a sectional view corresponding to FIG. 6. FIG. 63 shows the other preferred embodiment of the semiconductor device 1 and is a sectional view corresponding to FIG. 7. Referring to FIG. 61 to FIG. 63, in this embodiment, a Schottky barrier diode 88 is formed as an element structure.

More specifically, the semiconductor layer 7 is formed as a single layer of the base region 50 (the drift region 8). The first principal surface electrode 60 is in Schottky junction with the drift region 8. Thereby, a Schottky barrier is formed between the first principal surface electrode 60 (Schottky electrode) and the drift region 8 and the Schottky barrier diode 88 is formed. As shown in FIG. 61, in each mesa portion 24, a plurality of Schottky regions 89 in which Schottky barriers are formed and the plurality of first contact regions 34 are aligned alternately in the front-back direction of the trenches 19.

Also, in this embodiment, the silicide layers 58 and the interlayer insulating layers 55 are not provided. By omitting the silicide layers 58, the Schottky junctions between the drift region 8 and the first principal surface electrode 60 can be secured. The first principal surface electrode 60 (the barrier layer 61) is directly connected to the embedded bodies 21.

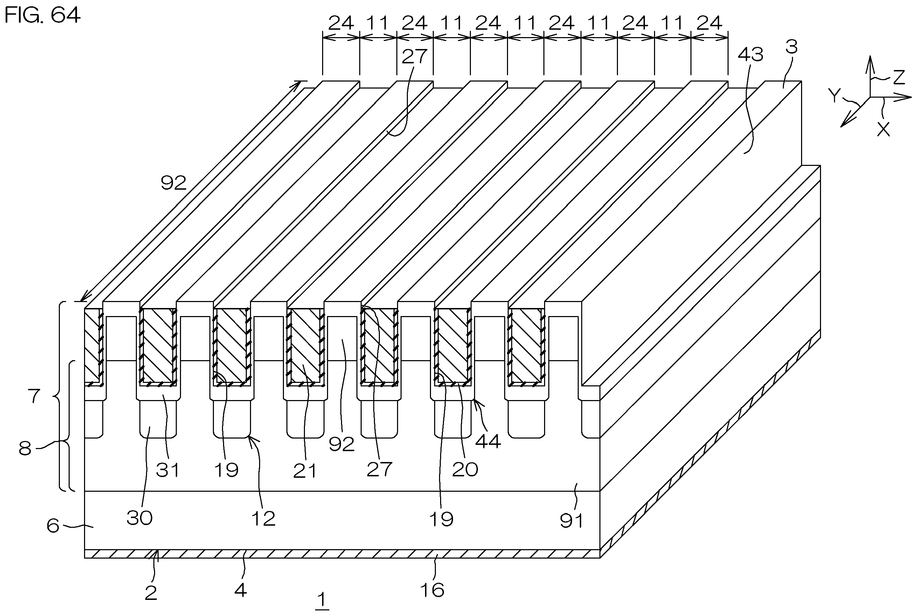

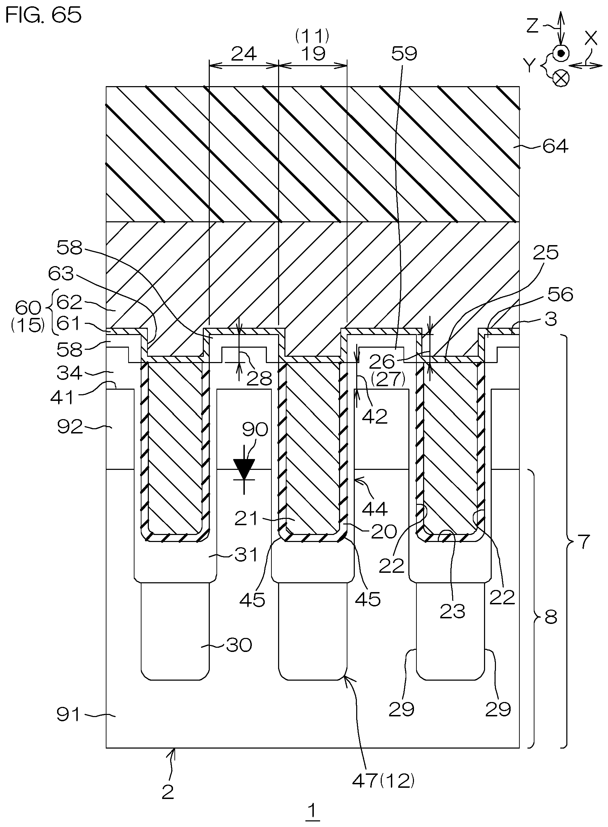

### (19) Embodiment of FIG. 64 and FIG. 65

FIG. 64 shows another preferred embodiment of the semiconductor device 1 and is a perspective view corresponding to FIG. 5. FIG. 65 shows the other preferred embodiment of the semiconductor device 1 and is a sectional view corresponding to FIG. 6. Referring to FIG. 64 and FIG. 65, in this embodiment, a pn diode 90 is formed as an element structure.

More specifically, the semiconductor layer 7 (the drift region 8) is formed as a single layer of a cathode region 91. The drain pad 16 (in this embodiment, a cathode electrode) is electrically connected to the cathode region 91 via the base layer 6. Also, the body region 18 is formed as an anode region 92 and is exposed from the first principal surface 3. The first principal surface electrode 60 (in this embodiment, an anode electrode), is in ohmic contact with the anode region 92. A pn junction is formed between the anode region 92 and the cathode region 91 and the pn diode 90 is formed. As shown in FIG. 64, in each mesa portion 24, the integral impurity region 44 of the p-type is formed across an entire surface of the first principal surface 3.

Also, in this embodiment, the interlayer insulating layers 55 are not provided. The first principal surface electrode 60 (the barrier layer 61) is directly connected to the embedded bodies 21.

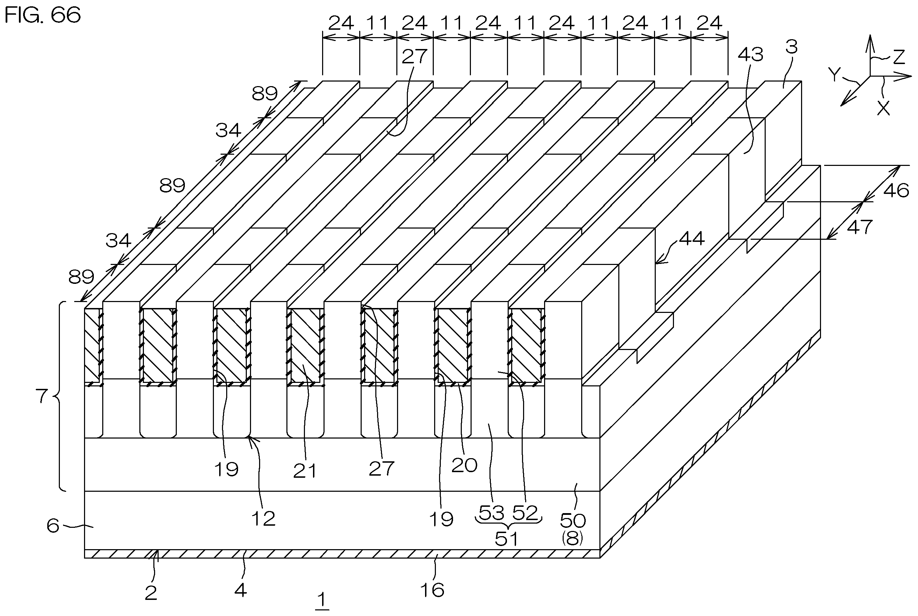

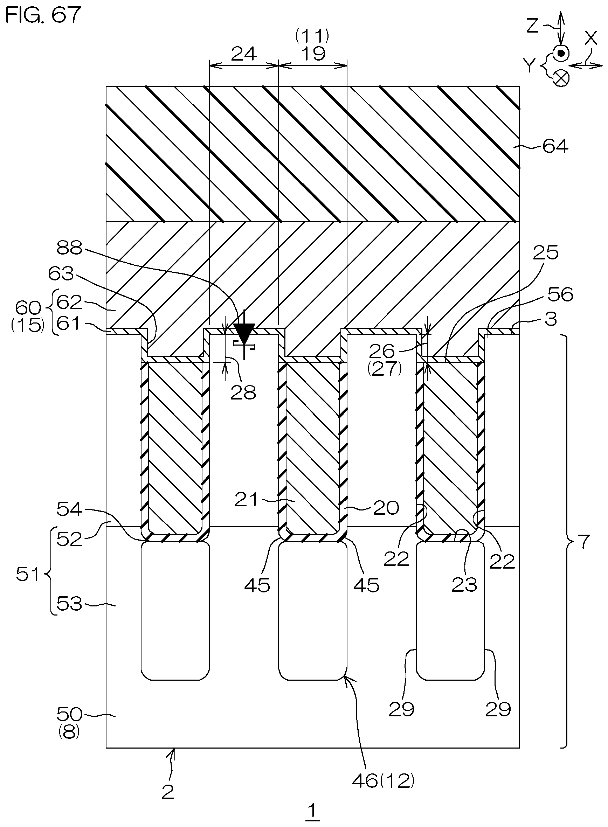

### (20) Embodiment of FIG. 66 and FIG. 67

FIG. 66 shows another preferred embodiment of the semiconductor device 1 and is a perspective view corresponding to FIG. 5. FIG. 67 shows the other preferred embodiment of the semiconductor device 1 and is a sectional view corresponding to FIG. 6. FIG. 66 and FIG. 67 are a modification example of the Schottky barrier diode 88 of FIG. 61 to FIG. 63. In this embodiment, the drift region 8 includes the laminated structure of the base region 50 and the high concentration region 51. Also, each electric field relaxation layer 12 formed at the bottom portion of the trench 19 has a single layer structure instead of the laminated structure of the first layer 30 and the second layer 31. The electric field relaxation layer 12 of a single layer may also be adopted as the electric field relaxation layer 12 at the bottom portion of the trench 19 in the MISFET shown in FIG. 1 to FIG. 60 and the IGBT (FIG. 54).

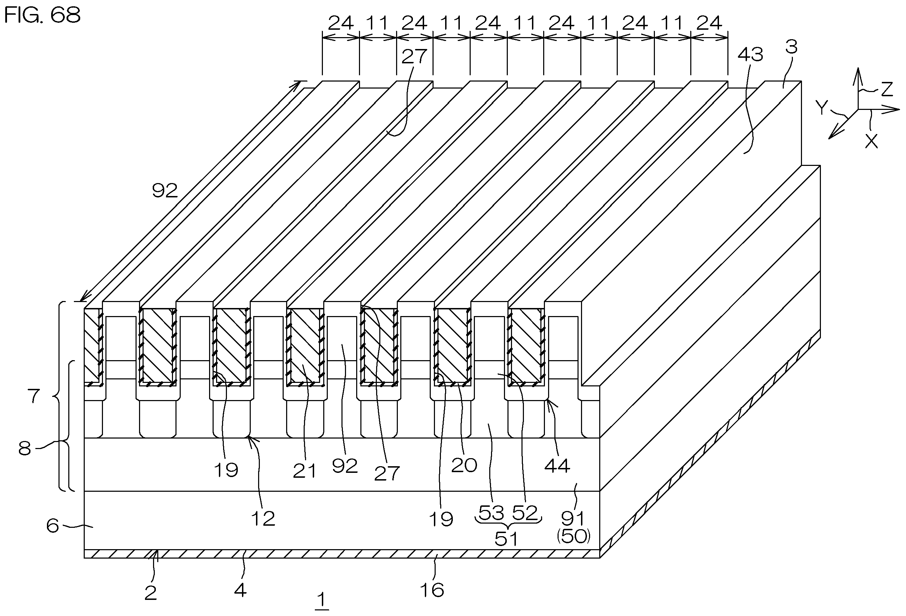

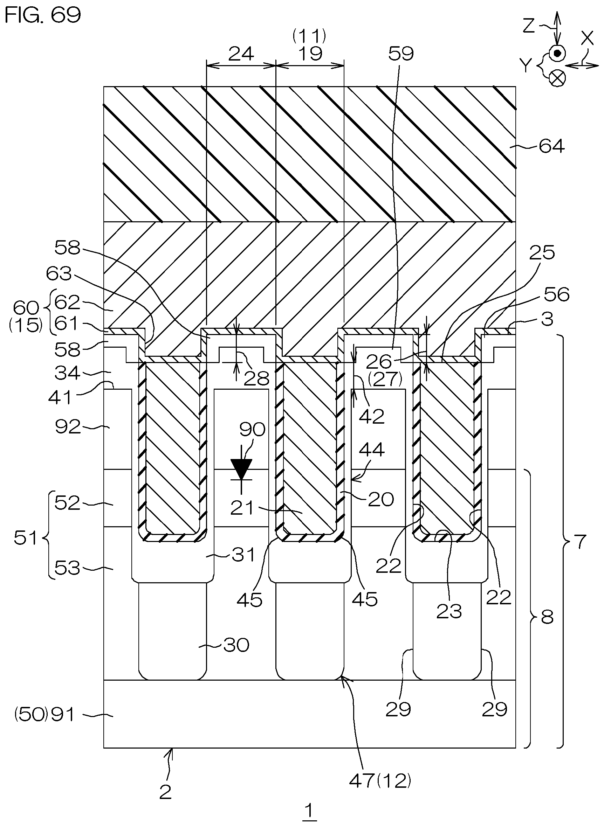

### (21) Embodiment of FIG. 68 and FIG. 69

FIG. 68 shows another preferred embodiment of the semiconductor device 1 and is a perspective view corresponding to FIG. 5. FIG. 69 shows the other preferred embodiment of the semiconductor device 1 and is a sectional view corresponding to FIG. 6. FIG. 68 and FIG. 69 are a modification example of the pn diode 90 of FIG. 64 and FIG. 65. In this embodiment, the cathode region 91 includes the laminated structure of the base region 50 and the high concentration region 51. Also, each electric field relaxation layer 12 formed at the bottom portion of the trench 19 has a single layer structure instead of the laminated structure of the first layer 30 and the second layer 31.

Although preferred embodiments of the present disclosure have been described above, the present disclosure can be implemented in yet other modes.

For example, with each of the preferred embodiments described above, the base layer 6 and the semiconductor layer 7 that each include the SiC monocrystal are adopted. However, at least one or all of the base layer 6 and the semiconductor layer 7 may include a monocrystal of a wide bandgap semiconductor other than the SiC monocrystal.

The wide bandgap semiconductor is a semiconductor having a bandgap greater than a bandgap of silicon. As examples of a monocrystal of a wide bandgap semiconductor, silicon carbide (SiC), gallium nitride (GaN), diamond (C), gallium oxide (Ga₂O₃), etc., can be cited. The base layer 6 and the semiconductor layer 7 may be constituted of monocrystals of the same type or may be constituted of monocrystals of different types. Also, at least one or all of the base layer 6 and the semiconductor layer 7 may be constituted of silicon (Si).

Hereinafter, examples of features extracted from the present description and the attached drawings shall be indicated. Hereinafter, the alphanumeric characters, etc., in parentheses represent the corresponding components, etc., in the preferred embodiments described above, but are not intended to limit the scope of each clause to the preferred embodiments described above. The "semiconductor device" in the following clauses may be replaced with an "SiC semiconductor device," a "wide bandgap semiconductor device," a "semiconductor switching device," a "semiconductor rectifier," a "MISFET device," an "IGBT device," a "diode device," etc., as needed.

### [Appendix A-1]

A semiconductor device (1) including a chip (2) that has a first principal surface (3) and a second principal surface (4) at an opposite side thereto,
a first impurity region (7) of a first conductivity type that is formed in a surface layer portion of the first principal surface (3),
a second impurity region (18) of a second conductivity type that is formed in a surface layer portion of the first impurity region (7),
a third impurity region (32) of the first conductivity type that is formed in a surface layer portion of the second impurity region (18),
a trench (19) passing through the third impurity region (32) and the second impurity region (18) from the first principal surface (3) and reaching the first impurity region (7),
a trench insulating film (20) that is formed on an inner surface of the trench (19),
an embedded body (21) with conductivity that is embedded in the trench (19) with the trench insulating film (20) interposed therebetween, and
an electric field relaxation layer (12) of the second conductivity type that is formed at a bottom portion (23) of the trench (19), and
where the electric field relaxation layer (12) includes a first layer (30) that is formed separated to the second principal surface (4) side from the bottom portion (23) of the trench (19) and has a first impurity concentration and a second layer (31) that is formed between the first layer (30) and the bottom portion (23) of the trench (19) and has a second impurity concentration higher than the first impurity concentration.

With the present arrangement, the impurity concentration of the first layer (30) of the electric field relaxation layer (12) is of low concentration relative to the second layer (31). Since a depletion layer can be extended comparatively widely from a first pn junction between the first layer (30) and the first impurity region (7), a device withstand voltage can be improved. On the other hand, the impurity concentration of the second layer (31) of the electric field relaxation layer (12) is of high concentration relative to the first layer (30). A width of a depletion layer extending from a second pn junction between the second layer (31) and the first impurity region (7) can be made narrower than a width of the depletion layer extending from the first pn junction. Thereby, a depletion layer extending toward the trench (19) bottom portion from the second pn junction portion can be made narrow and an electric field strength applied to the trench insulating film (20) can be relaxed. That is, both relaxation of the electric field strength applied to the trench insulating film (20) and improvement of the device withstand voltage can be achieved at the same time.

### [Appendix A-2]

The semiconductor device (1) according to Appendix A-1, where the electric field relaxation layer (12) is formed in a band shape extending in a front-back direction (Y) of the trench (19) such that a laminated structure of the first layer (30) and the second layer (31) is continuous in the front-back direction (Y) of the trench (19).

With this arrangement, the electric field strength applied to the trench insulating film (20) can be relaxed across a wide range in the front-back direction (Y) of the trench (19) and the device withstand voltage can be improved.

### [Appendix A-3]

The semiconductor device (1) according to Appendix A-2, including a first contact region (34) of the second conductivity type that is formed adjacent to the third impurity region (32) in the surface layer portion of the second impurity region (18) and is connected to the second impurity region (18) and
a second contact region (43) that is formed from the first contact region (34) towards the second principal surface (4) along a side surface (22) of the trench (19) and is connected to the second layer (31) of the electric field relaxation layer (12).

With this arrangement, a potential of the first layer (30) of the electric field relaxation layer (12) can be fixed at the same potential as the third impurity region (32) via the first contact region (34) and the second contact region (43).

### [Appendix A-4]

The semiconductor device (1) according to Appendix A-3, where a plurality of the third impurity regions (32) and a plurality of the first contact regions (34) are aligned alternately along the front-back direction (Y) of the trench (19) such as to be exposed at the side surface (22) of the trench (19).

With this arrangement, since the plurality of third impurity regions (32) and the plurality of first contact regions (34) are aligned alternately, current paths (channels) formed in a depth direction (Z) of the trench (19) can be formed in a well-balanced manner along the front-back direction (Y) of the trench (19).

### [Appendix A-5]

The semiconductor device (1) according to Appendix A-3 or Appendix A-4, where
a plurality of the trenches (19) are formed as stripes,
a mesa portion (24) sandwiched by the plurality of trenches (19) that are adjacent and in which the third impurity region (32), the second impurity region (18), and the first impurity region (7) are formed in that order from the first principal surface (3) side is formed,
the first contact region (34) is adjacent to the third impurity region (32) in the front-back direction (Y) of the trenches (19) and is formed from one side surface (22) to reach another side surface (22) of the mesa portion (24), and
the second contact region (43) is formed along both the one side surface (22) and the other side surface (22) of the mesa portion (24).

With this arrangement, since in each mesa portion (24), the third impurity region (32) and the first contact region (34) are arranged adjacently in the front-back direction (Y) of the trenches (19), miniaturization of the device can be accommodated.

### [Appendix A-6]

The semiconductor device (1) according to Appendix A-5, where a pitch (PT) of the plurality of trenches (19) is not less than 0.1 µm and not more than 5 µm.

With this arrangement, miniaturization of the device can be achieved.

### [Appendix A-7]

The semiconductor device (1) according to any one of Appendix A-1 to Appendix A-6, where a recess (27) demarcated by an upper surface (25) of the embedded body (21) and the side surface (22) of the trench (19) is formed in an upper portion of the trench (19) and
the semiconductor device includes an interlayer insulating layer (55) embedded in the recess (27) such that an upper edge (56) of the trench (19) is exposed and
a first principal surface electrode (60) that is formed on the first principal surface (3) such as to cover the interlayer insulating layer (55) and is connected to the third impurity region (32).

With this arrangement, the interlayer insulating layer (55) is embedded in the recess (27) of the trench (19) and the upper edge (56) of the trench (19) is exposed. Thereby, the third impurity region (32) can be exposed over a wide area in the first principal surface (3). Therefore, even in situations where a miniaturized structure is required, a sufficient contact area between the first principal surface electrode (60) and the third impurity region (32) can be secured. Further, there is no need to form a contact opening in the interlayer insulating layer (55). Since a need to consider a positional deviation margin in the forming of a contact opening is eliminated, the miniaturization of the device can be promoted further.

### [Appendix A-8]

The semiconductor device (1) according to Appendix A-7, where an upper surface (57) of the interlayer insulating layer (55) is positioned further to the bottom portion (23) side of the trench (19) than the first principal surface (3) in a depth direction (Z) of the trench (19) and
the first principal surface electrode (60) is connected to the third impurity region (32) at a side surface (22) of the recess (27) and the first principal surface (3).

With this arrangement, a contact area between the first principal surface electrode (60) and the third impurity region (32) can be widened and a contact resistance between these can be reduced.

### [Appendix A-9]

The semiconductor device (1) according to any one of Appendix A-1 to Appendix A-8, where the first impurity region (7) includes a base region (50) that is formed separated further to the second principal surface (4) side from the second impurity region (18) than the electric field relaxation layer (12) and a high concentration region (51) that is formed at a side of the electric field relaxation layer (12) between the base region (50) and the second impurity region (18) and has a higher impurity concentration than the base region (50).

With this arrangement, a depletion layer having a wide width can be extended by the base region (50) of relatively low concentration and therefore, improvement of the device withstand voltage can be secured. In addition, by arranging the high concentration region (51) of relatively high concentration at the side of the electric field relaxation layer (12), the depletion layer can be suppressed from spreading excessively in a periphery of the electric field relaxation layer (12). Since a current path can be secured by the suppression of expansion of the depletion layer, increase in on resistance can be suppressed.

### [Appendix A-10]

The semiconductor device (1) according to Appendix A-9, where the high concentration region (51) includes a first high concentration region (52) and a second high concentration region (53) that is formed further to the second principal surface (4) side than the first high concentration region (52) such as to cover a boundary portion (54) between the bottom portion (23) of the trench (19) and the electric field relaxation layer (12) and has a lower impurity concentration than the first high concentration region (52).

With this arrangement, the first high concentration region (52) serves the role of a current spreading layer (CSL) that spreads a current flowing via channels across entire intervals between adjacent trenches (19) and can reduce the on resistance. In addition, by arranging the second high concentration region (53) of relatively low concentration at the second principal surface (4) side of the first high concentration region (52), an improvement effect of the device withstand voltage can be obtained.

### [Appendix A-11]

The semiconductor device (1) according to Appendix A-10, where the first high concentration region (52) contacts the second impurity region (18) and is formed to a depth shallower than the bottom portion (23) of the trench (19) from the second impurity region (18) in a thickness direction (Z) of the chip (2).

With this arrangement, a bottom portion of the first high concentration region (52) is shallower than the bottom portion of the trench (19) and does not contact the boundary portion (54) between the bottom portion of the trench (19) and the electric field relaxation layer (12). Thereby, even when the concentration of the first high concentration region (52) is made high, influences on the device withstand voltage and the electric field with respect to the trench insulating film (20) can be lessened.

### [Appendix A-12]

The semiconductor device (1) according to any one of Appendix A-9 to Appendix A-11, where the first layer (30) of the electric field relaxation layer (12) is formed to a depth reaching the base region (50) in the thickness direction (Z) of the chip (2).

With this arrangement, the first pn junction can be formed between the first layer (30) and the base region (50) and therefore, the depletion layer can be extended wider and the device withstand voltage can be improved further.

### [Appendix A-13]

The semiconductor device (1) according to Appendix A-12, where a bottom portion of the first layer (30) of the electric field relaxation layer (12) contacts the base region (50) and forms a boundary portion with the base region (50).

With this arrangement, although the first layer (30) contacts the base region (50), a contact area thereof can be prevented from becoming too wide. Consequently, while enabling the depletion layer to be extended widely, an extension range of the depletion layer can be made suitable in extent and a sufficient current path can be secured.

### [Appendix A-14]

The semiconductor device (1) according to any one of Appendix A-3 to Appendix A-6, where the chip (2) is an Si-based semiconductor chip (2) and
the semiconductor device includes a silicide layer (58) that is formed on respective front surfaces of the third impurity region (32) and the first contact region (34) and
a first principal surface electrode (60) that is connected to the third impurity region (32) and the first contact region (34) via the silicide layer (58).

With this arrangement, contact resistance with respect to the third impurity region (32) and the first contact region (34) can be reduced.

### [Appendix A-15]

The semiconductor device (1) according to any one of Appendix A-1 to Appendix A-14, including a drain region (6) of the first conductivity type that is formed at the second principal surface (4) side with respect to the first impurity region (7),
a body region (18) that is formed by the second impurity region (18),
a source region (32) that is formed by the third impurity region (32), and
a trench gate structure (11) that is formed by the trench (19), the trench insulating film (20), and the embedded body (21).

### [Appendix A-16]

The semiconductor device (1) according to any one of Appendix A-1 to Appendix A-14, including a collector region (84) of the second conductivity type that is formed at the second principal surface (4) side with respect to the first impurity region (7),
a base region (85) that is formed by the second impurity region (18),
an emitter region (86) that is formed by the third impurity region (32), and
a trench gate structure (11) that is formed by the trench (19), the trench insulating film (20), and the embedded body (21).

### [Appendix A-17]

The semiconductor device (1) according to any one of Appendix A-1 to Appendix A-16, where the chip (2) is an SiC chip (2).

### [Appendix A-18]

The semiconductor device (1) according to Appendix A-3 or Appendix A-4, where a plurality of the trenches (19) are formed as stripes,
a mesa portion (24) sandwiched by the plurality of trenches (19) that are adjacent and in which the third impurity region (32), the second impurity region (18), and the first impurity region (7) are formed in that order from the first principal surface (3) side is formed, and
the third impurity region (32) is selectively formed, at an interval from one side surface (22) of the mesa portion (24), at another side surface (22) side of the mesa portion (24).

### [Appendix A-19]

The semiconductor device (1) according to Appendix A-18, where the first contact region (34) is adjacent to the third impurity region (32) in a width direction of the mesa portion (24) and is selectively formed at the one side surface (22) side of the mesa portion (24).

### [Appendix A-20]

The semiconductor device (1) according to Appendix A-19, where, in the mesa portion (24), the third impurity region (32) and the first contact region (34) are formed as stripes extending in the front-back direction (Y) of the trenches (19).

### [Appendix A-21]

The semiconductor device (1) according to Appendix A-1 or Appendix A-2, where
a plurality of the trenches (19) are formed as stripes,
a mesa portion (24) sandwiched by the plurality of trenches (19) that are adjacent and in which the third impurity region (32), the second impurity region (18), and the first impurity region (7) are formed in that order from the first principal surface (3) side is formed, and
the third impurity region (32) is formed at both one side surface (22) side and another side surface (22) side of the mesa portion (24).

### [Appendix A-22]

The semiconductor device (1) according to Appendix A-21, including a first contact region (34) of the second conductivity type that is formed adjacent to the third impurity region (32) at a width direction central portion of the mesa portion (24) separated from the one side surface (22) and the other side surface (22) of the mesa portion (24) and is connected to the second impurity region (18).

### [Appendix A-23]

The semiconductor device (1) according to Appendix A-22, where the first contact region (34) and a pair of the third impurity regions (32) that sandwich the first contact region (34) from both sides of the mesa portion (24) are formed in the mesa portion (24) as stripes extending in the front-back direction (Y) of the trenches (19).

### [Appendix A-24]

The semiconductor device (1) according to any one of Appendix A-3 to Appendix A-6, where the second impurity region (18) includes a first portion (35) that is formed directly below the third impurity region (32) and has a first thickness (BT1) and a second portion (36) that is formed directly below the first contact region (34) and has a second thickness (BT2) greater than the first thickness (BT1).

### [Appendix A-25]

The semiconductor device (1) according to Appendix A-8, where the first principal surface electrode (60) includes a barrier layer (61) that is formed along an inner surface of the recess (27) and further demarcates a second recess (63) inside the recess (27) and a main body layer (62) that is formed on the barrier layer (61) and is partially embedded in the second recess (63).

### [Appendix A-26]

The semiconductor device (1) according to Appendix A-8, where the chip (2) is an Si-based semiconductor chip (2),
a silicide layer (58) that is formed along a front surface of the third impurity region (32) and an inner surface of the recess (27) is included, and
the first principal surface electrode (60) is connected to the third impurity region (32) via the silicide layer (58).

### [Appendix A-27]

The semiconductor device (1) according to Appendix A-26, where the first principal surface electrode (60) includes a barrier layer (61) that is formed along the inner surface of the recess (27), is connected to the silicide layer (58), and further demarcates a second recess (63) inside the recess (27) and a main body layer (62) that is formed on the barrier layer (61) and is partially embedded in the second recess (63).

### [Appendix A-28]

The semiconductor device (1) according to Appendix A-25 or Appendix A-27, where the barrier layer (61) is formed of a Ti-based metal and the main body layer (62) is formed of an Al-based metal.

### [Appendix A-29]

The semiconductor device (1) according to any one of Appendix A-1 to Appendix A-28, where the electric field relaxation layer (12) is formed such as to extend between one side end portion and another side end portion of the trench (19) in a width direction of the trench 19.

### [Appendix A-30]

The semiconductor device (1) according to any one of Appendix A-1 to Appendix A-28, where the electric field relaxation layer (12) is formed separated from one side end portion to another side of the trench (19) in the width direction of the trench (19).

### [Appendix A-31]

The semiconductor device (1) according to any one of Appendix A-1 to Appendix A-30, where the first layer (30) has a first relaxation thickness (RT1A, RT1B) and
the second layer (31) has a second relaxation thickness (RT2A, RT2B) that is smaller than the first relaxation thickness (RT1A, RT1B).

### [Appendix B-1]

A semiconductor device (1) including a chip (2) that has a first principal surface (3) and a second principal surface (4) at an opposite side thereto,
a plurality of gate trenches (19) of stripe shape that are formed in a surface layer portion of the first principal surface (3) and are aligned at intervals in a first direction (X),
a gate insulating film (20) that is formed on an inner surface of each of the gate trenches (19),
a gate electrode (21) that is embedded in the gate trenches (19) with the gate insulating film (20) interposed therebetween,
a plurality of mesa portions (24) of stripe shape sandwiched by the plurality of gate trenches (19) that are adjacent and aligned at intervals in the first direction (X),
a first impurity region (7) of a first conductivity type that is formed such as to extend across the plurality of mesa portions (24),
a second impurity region (18) of a second conductivity type that is formed in a surface layer portion of the first impurity region (7) in each of the mesa portions (24),
a third impurity region (32) of the first conductivity type that is formed in a surface layer portion of the second impurity region (18),
a first contact region (34) of the second conductivity type that is adjacent to the third impurity region (32) in a front-back direction (Y) of the gate trenches (19), is formed such as to cross the mesa portions (24) in a width direction, and is connected to the second impurity region (18), and
an electric field relaxation layer (12) of the second conductivity type that is formed at bottom portions (23) of the gate trenches (19), and
where the electric field relaxation layer (12) has a laminated structure including a first layer (30) that is formed separated to the second principal surface (4) side from the bottom portions (23) of the gate trenches (19) and has a first impurity concentration and a second layer (31) that is formed between the first layer (30) and the bottom portions (23) of the gate trenches (19) such as to be exposed at the bottom portions (23) of the gate trenches (19) and has a second impurity concentration higher than the first impurity concentration.

### [Appendix B-2]

The semiconductor device (1) according to Appendix B-1, where the electric field relaxation layer (12) is formed in a band shape extending in the front-back direction (Y) of the gate trenches (19) such that the laminated structure is continuous in the front-back direction (Y) of the trenches (19).

### [Appendix B-3]

The semiconductor device (1) according to Appendix B-1 or Appendix B-2, including a second contact region (43) that is formed from the first contact region (34) toward the second principal surface (4) along both one side surface (22) and another side surface (22) of each of the mesa portions (24) and is connected to the second layer (31) of the electric field relaxation layer (12) and
where an integral impurity region (44) of the second conductivity type is formed by the first contact region (34), the second contact region (43), and the second layer (31).

### [Appendix B-4]

The semiconductor device (1) according to Appendix B-3, where both end corner portions (45) in a width direction of each of the gate trenches (19) are covered by the integral impurity region (44).

### [Appendix B-5]

The semiconductor device (1) according to Appendix B-3 or Appendix B-4, where a plurality of the integral impurity regions (44) are formed at intervals along the front-back direction (Y) of the gate trenches (19).

### [Appendix B-6]

The semiconductor device (1) according to any one of Appendix B-3 to Appendix B-5, where, in a width direction of the gate trenches (19), the integral impurity region (44) has a wider width than the first layer (30) of the electric field relaxation layer (12).

### [Appendix B-7]

The semiconductor device (1) according to any one of Appendix B-1 to Appendix B-6, where a pitch (PT) of the plurality of gate trenches (19) is not less than 0.1 µm and not more than 5 µm.

### [Appendix B-8]

The semiconductor device (1) according to any one of Appendix B-1 to Appendix B-7, where, in an upper portion of each of the gate trenches (19), a recess (27) demarcated by an upper surface (25) of the gate electrode (21) and a side surface (22) of the gate trench (19) is formed and
the semiconductor device includes an interlayer insulating layer (55) embedded in the recess (27) such that an upper edge (56) of the gate trench (19) is exposed and
a first principal surface electrode (60) that is formed on the first principal surface (3) such as to cover the interlayer insulating layer (55) and is connected to the third impurity region (32).

### [Appendix B-9]

The semiconductor device (1) according to Appendix B-8, where an upper surface (57) of the interlayer insulating layer (55) is positioned further to the bottom portion (23) side of the gate trenches (19) than the first principal surface (3) in a depth direction (Z) of the gate trenches (19) and
the first principal surface electrode (60) is connected to the third impurity region (32) at a side surface (22) of the recess (27) and the first principal surface (3).

### [Appendix B-10]

The semiconductor device (1) according to any one of Appendix B-1 to Appendix B-9, where the first impurity region (7) includes a base region (50) that is formed separated further to the second principal surface (4) side from the second impurity region (18) than the electric field relaxation layer (12) and a high concentration region (51) that is formed at a side of the electric field relaxation layer (12) between the base region (50) and the second impurity region (18) and has a higher impurity concentration than the base region (50).

### [Appendix B-11]

The semiconductor device (1) according to Appendix B-10, where the high concentration region (51) includes a first high concentration region (52) and a second high concentration region (53) that is formed further to the second principal surface (4) side than the first high concentration region (52) such as to cover a boundary portion (54) between the bottom portions (23) of the gate trenches (19) and the electric field relaxation layer (12) and has a lower impurity concentration than the first high concentration region (52).

### [Appendix B-12]

The semiconductor device (1) according to Appendix B-11, where the first high concentration region (52) contacts the second impurity region (18) and is formed to a depth shallower than the bottom portions (23) of the gate trenches (19) from the second impurity region (18) in a thickness direction (Z) of the chip (2).

### [Appendix B-13]

The semiconductor device (1) according to any one of Appendix B-10 to Appendix B-12, where the first layer (30) of the electric field relaxation layer (12) is formed to a depth reaching the base region (50) in the thickness direction (Z) of the chip (2).

### [Appendix B-14]

The semiconductor device (1) according to Appendix B-13, where a bottom portion of the first layer (30) of the electric field relaxation layer (12) contacts the base region (50) and forms a boundary portion with the base region (50).

### [Appendix B-15]

The semiconductor device (1) according to any one of Appendix B-1 to Appendix B-14, where the chip (2) is an Si-based semiconductor chip (2) and
the semiconductor device includes a silicide layer (58) that is formed on respective front surfaces of the third impurity region (32) and the first contact region (34) and
a first principal surface electrode (60) that is connected to the third impurity region (32) and the first contact region (34) via the silicide layer (58).

### [Appendix B-16]

The semiconductor device (1) according to any one of Appendix B-1 to Appendix B-15, where the chip (2) is an SiC chip (2).

### [Appendix C-1]

A semiconductor device (1) including a chip (2) that has a first principal surface (3) and a second principal surface (4) at an opposite side thereto and in which an active region (9) is formed in the first principal surface (3),
a first impurity region (7) of a first conductivity type that is formed in a surface layer portion of the active region (9),
an element structure that is formed in a surface layer portion of the first impurity region (7),
a trench (19) that is formed in the active region (9) and has a bottom portion in the first impurity region (7),
a trench insulating film (20) that is formed on an inner surface of the trench (19),
an embedded body (21) with conductivity that is embedded in the trench (19) with the trench insulating film (20) interposed therebetween, and
an electric field relaxation layer (12) of a second conductivity type that is formed at the bottom portion (23) of the trench (19), and
where the electric field relaxation layer (12) includes a first layer (30) that is formed separated to the second principal surface (4) side from the bottom portion (23) of the trench (19) and has a first impurity concentration and a second layer (31) that is formed between the first layer (30) and the bottom portion (23) of the trench (19) and has a second impurity concentration higher than the first impurity concentration.

### [Appendix C-2]

The semiconductor device (1) according to Appendix C-1, where the electric field relaxation layer (12) is formed in a band shape extending in a front-back direction (Y) of the trench (19) such that a laminated structure of the first layer (30) and second layer (31) is continuous in the front-back direction (Y) of the trench (19).

### [Appendix C-3]

The semiconductor device (1) according to Appendix C-2, including a first contact region (34) of the second conductivity type that is formed adjacent to the trench (19) in a surface layer portion of the first principal surface (3) and
a second contact region (43) that is formed from the first contact region (34) towards the second principal surface (4) along a side surface (22) of the trench (19) and is connected to the second layer (31) of the electric field relaxation layer (12).

### [Appendix C-4]

The semiconductor device (1) according to Appendix C-3, where
a plurality of the trenches (19) are formed as stripes,
a mesa portion (24) sandwiched by the plurality of trenches (19) that are adjacent is formed,
the first contact region (34) is formed from one side surface (22) to reach another side surface (22) of the mesa portion (24), and
the second contact region (43) is formed along both the one side surface (22) and the other side surface (22) of the mesa portion (24).

### [Appendix C-5]

The semiconductor device (1) according to Appendix C-4, where a pitch (PT) of the plurality of trenches (19) is not less than 0.1 µm and not more than 5 µm.

### [Appendix C-6]

The semiconductor device (1) according to any one of Appendix C-1 to Appendix C-5, where a recess (27) demarcated by an upper surface (25) of the embedded body (21) and the side surface (22) of the trench (19) is formed in an upper portion of the trench (19) and
the semiconductor device includes an interlayer insulating layer (55) embedded in the recess (27) such that an upper edge (56) of the trench (19) is exposed and
a first principal surface electrode (60) that is formed on the first principal surface (3) such as to cover the interlayer insulating layer (55) and is connected to the element structure.

### [Appendix C-7]

The semiconductor device (1) according to Appendix C-6, where an upper surface (57) of the interlayer insulating layer (55) is positioned further to the bottom portion (23) side of the trench (19) than the first principal surface (3) in a depth direction (Z) of the trench (19) and
the first principal surface electrode (60) is connected to the element structure at a side surface (22) of the recess (27) and the first principal surface (3).

### [Appendix C-8]

The semiconductor device (1) according to any one of Appendix C-3 to Appendix C-5, where the chip (2) is an Si-based semiconductor chip (2) and
the semiconductor device includes a silicide layer (58) that is formed on respective front surfaces of the first contact region (34) and
a first principal surface electrode (60) that is connected to the first contact region (34) via the silicide layer (58).

### [Appendix D-1]

A semiconductor device (1) including a chip (2) that has a first principal surface (3) and a second principal surface (4) at an opposite side thereto and in which an active region (9) is formed in the first principal surface (3),
a first impurity region (7) of a first conductivity type that is formed in a surface layer portion of the active region (9),
an element structure that is formed in a surface layer portion of the first impurity region (7),
a trench (19) that is formed in the active region (9) and has a bottom portion in the first impurity region (7),
a trench insulating film (20) that is formed on an inner surface of the trench (19),
an embedded body (21) with conductivity that is embedded in the trench (19) with the trench insulating film (20) interposed therebetween, and
an electric field relaxation layer (12) of a second conductivity type that is formed at the bottom portion (23) of the trench (19), and
where the first impurity region (7) includes a base region (50) that is formed separated further to the second principal surface (4) side than the electric field relaxation layer (12) and a high concentration region (51) that is formed at a side of the electric field relaxation layer (12) between the base region (50) and the first principal surface (3) and has a higher impurity concentration than the base region (50).

### [Appendix D-2]

The semiconductor device (1) according to Appendix D-1, where the high concentration region (51) includes a first high concentration region (52) and a second high concentration region (53) that is formed further to the second principal surface (4) side than the first high concentration region (52) such as to cover a boundary portion (54) between the bottom portion (23) of the trench (19) and the electric field relaxation layer (12) and has a lower impurity concentration than the first high concentration region (52).

### [Appendix D-3]

The semiconductor device (1) according to Appendix D-1 or Appendix D-2, where the electric field relaxation layer (12) is formed to a depth reaching the base region (50) in a thickness direction (Z) of the chip (2).

### [Appendix D-4]

The semiconductor device (1) according to Appendix D-3, where a bottom portion of the electric field relaxation layer (12) contacts the base region (50) and forms a boundary portion with the base region (50).

### Reference Signs List

1: Semiconductor device
2: Chip
3: First principal surface
4: Second principal surface
5A: First side surface
5B: Second side surface
5C: Third side surface
5D: Fourth side surface
6: Base layer
7: Semiconductor layer
8: Drift region
9: Active region
10: Outer peripheral region
11: Trench structure
12: Electric field relaxation layer
13: Gate pad
14: Gate wiring
14A: First gate wiring
14B: Second gate wiring
15: Source pad
16: Drain pad
17: Field region
18: Body region
19: Trench
20: Trench insulating film
21: Embedded body
22: Side surface
23: Bottom surface
24: Mesa portion
25: Upper surface
26: Level difference
27: Recess
28: Projection portion
29: Side surface
30: First layer
31: Second layer
32: Source region
33: Channel section
34: First contact region
35: First body portion
36: Second body portion
37: Base boundary surface
38: Body projection portion
39: First boundary surface
40: First level difference
41: Second boundary surface
42: Second level difference
43: Second contact region
44: Integral impurity region
45: Corner portion
46: First relaxation portion
47: Second relaxation portion
48: First boundary surface
49: Second boundary surface
50: Base region
51: High concentration region
52: First high concentration region
53: Second high concentration region
54: Boundary portion
55: Interlayer insulating layer
56: Upper edge
57: Upper surface
58: Silicide layer
59: Non-silicide portion
60: First principal surface electrode
61: Barrier layer
62: Main body layer
63: Second recess
64: Resin layer
65: Wafer
66: First wafer principal surface
67: Second wafer principal surface
68: Wafer side surface
69: Mark
70: Device region
71: Intended cutting line
72: First mask
73: First opening
74: Second mask
75: Second opening
76: Insulating film
77: Base electrode film
78: Base insulating film
79: First trench
80: Second trench
81: Contact opening
82: Contact opening
83: Boundary surface
84: Collector region
85: Base region
86: Emitter region
87: Contact opening
88: Schottky barrier diode
89: Schottky region
90: pn diode
91: Cathode region
92: Anode region

## Claims

1. A semiconductor device comprising: a chip that has a first principal surface and a second principal surface at an opposite side thereto;
a first impurity region of a first conductivity type that is formed in a surface layer portion of the first principal surface;
a second impurity region of a second conductivity type that is formed in a surface layer portion of the first impurity region;
a third impurity region of the first conductivity type that is formed in a surface layer portion of the second impurity region;
a trench passing through the third impurity region and the second impurity region from the first principal surface and reaching the first impurity region;
a trench insulating film that is formed on an inner surface of the trench;
an embedded body with conductivity that is embedded in the trench with the trench insulating film interposed therebetween; and
an electric field relaxation layer of the second conductivity type that is formed at a bottom portion of the trench; and
wherein the electric field relaxation layer includes a first layer that is formed separated to the second principal surface side from the bottom portion of the trench and has a first impurity concentration and a second layer that is formed between the first layer and the bottom portion of the trench and has a second impurity concentration higher than the first impurity concentration.

2. The semiconductor device according to Claim 1, wherein the electric field relaxation layer is formed in a band shape extending in a front-back direction of the trench such that a laminated structure of the first layer and the second layer is continuous in the front-back direction of the trench.

3. The semiconductor device according to Claim 2, comprising: a first contact region of the second conductivity type that is formed adjacent to the third impurity region in the surface layer portion of the second impurity region and is connected to the second impurity region; and
a second contact region that is formed from the first contact region towards the second principal surface along a side surface of the trench and is connected to the second layer of the electric field relaxation layer.

4. The semiconductor device according to Claim 3, wherein a plurality of the third impurity regions and a plurality of the first contact regions are aligned alternately along the front-back direction of the trench such as to be exposed at the side surface of the trench.

5. The semiconductor device according to Claim 3 or Claim 4, wherein
a plurality of the trenches are formed as stripes,
a mesa portion sandwiched by the plurality of trenches that are adjacent and in which the third impurity region, the second impurity region, and the first impurity region are formed in that order from the first principal surface side is formed,
the first contact region is adjacent to the third impurity region in the front-back direction of the trenches and is formed from one side surface to reach another side surface of the mesa portion, and
the second contact region is formed along both the one side surface and the other side surface of the mesa portion.

6. The semiconductor device according to Claim 5, wherein a pitch of the plurality of trenches is not less than 0.1 µm and not more than 5 µm.

7. The semiconductor device according to any one of Claim 1 to Claim 6, wherein a recess demarcated by an upper surface of the embedded body and the side surface of the trench is formed in an upper portion of the trench and
the semiconductor device comprises: an interlayer insulating layer embedded in the recess such that an upper edge of the trench is exposed; and
a first principal surface electrode that is formed on the first principal surface such as to cover the interlayer insulating layer and is connected to the third impurity region.

8. The semiconductor device according to Claim 7, wherein an upper surface of the interlayer insulating layer is positioned further to the bottom portion side of the trench than the first principal surface in a depth direction of the trench and
the first principal surface electrode is connected to the third impurity region at a side surface of the recess and the first principal surface.

9. The semiconductor device according to any one of Claim 1 to Claim 8, wherein the first impurity region includes a base region that is formed separated further to the second principal surface side from the second impurity region than the electric field relaxation layer and a high concentration region that is formed at a side of the electric field relaxation layer between the base region and the second impurity region and has a higher impurity concentration than the base region.

10. The semiconductor device according to Claim 9, wherein the high concentration region includes a first high concentration region and a second high concentration region that is formed further to the second principal surface side than the first high concentration region such as to cover a boundary portion between the bottom portion of the trench and the electric field relaxation layer and has a lower impurity concentration than the first high concentration region.

11. The semiconductor device according to Claim 10, wherein the first high concentration region contacts the second impurity region and is formed to a depth shallower than the bottom portion of the trench from the second impurity region in a thickness direction of the chip.

12. The semiconductor device according to any one of Claim 9 to Claim 11, wherein the first layer of the electric field relaxation layer is formed to a depth reaching the base region in the thickness direction of the chip.

13. The semiconductor device according to Claim 12, wherein a bottom portion of the first layer of the electric field relaxation layer contacts the base region and forms a boundary portion with the base region.

14. The semiconductor device according to any one of Claim 3 to Claim 6, wherein the chip is an Si-based semiconductor chip and
the semiconductor device comprises: a silicide layer that is formed on respective front surfaces of the third impurity region and the first contact region; and
a first principal surface electrode that is connected to the third impurity region and the first contact region via the silicide layer.

15. The semiconductor device according to any one of Claim 1 to Claim 14, comprising: a drain region of the first conductivity type that is formed at the second principal surface side with respect to the first impurity region;
a body region that is formed by the second impurity region;
a source region that is formed by the third impurity region; and
a trench gate structure that is formed by the trench, the trench insulating film, and the embedded body.

16. The semiconductor device according to any one of Claim 1 to Claim 14, comprising: a collector region of the second conductivity type that is formed at the second principal surface side with respect to the first impurity region;
a base region that is formed by the second impurity region;
an emitter region that is formed by the third impurity region; and
a trench gate structure that is formed by the trench, the trench insulating film, and the embedded body.

17. The semiconductor device according to any one of Claim 1 to Claim 16, where the chip is an SiC chip.
